(19) Europäisches Patentamt
European Patent Office
Office européen des brevets

(11) EP 2 028 654 A1

(12) EUROPEAN PATENT APPLICATION

(43) Date of publication:
25.02.2009 Bulletin 2009/09

(21) Application number: 08013191.5

(22) Date of filing: 22.07.2008

(51) Int Cl.:
G11B 7/0065 (2006.01) G11B 7/242 (2006.01)
G03F 7/00 (2006.01)

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(30) Priority: 22.08.2007 JP 2007215772

(71) Applicant: FUJIFILM Corporation
Minato-ku
Tokyo 106-8620 (JP)

(72) Inventors:
- Sasaki, Toshio
Ashigarakami-gun
Kanagawa (JP)
- Yamada, Satoru
Ashigarakami-gun
Kanagawa (JP)
- Suzuki, Hiroyuki
Ashigarakami-gun
Kanagawa (JP)
- Usami, Yoshihisa
Ashigarakami-gun
Kanagawa (JP)
- Kamo, Makoto
Ashigarakami-gun
Kanagawa (JP)

(74) Representative: Grünecker, Kinkeldey, Stockmair & Schwanhäusser
Anwaltssozietät
Leopoldstrasse 4
80802 München (DE)

(54) **Holographic recording medium and holographic recording apparatus**

(57) A holographic recording medium includes at least two substrates, and a recording layer provided between the substrates. The recording layer has a property such that an average refractive index lowers as irradiation with a beam proceeds. In the recording layer, an optical compensation rate C that is defined by $C = (1-(n2/n1))/\alpha$ satisfies $0.8 \leq C \leq 1.0$, where $\alpha$ is a rate of thickness change of the recording layer before and after recording, n1 is an average refractive index before recording, and n2 is an average refractive index after recording.

FIG. 1

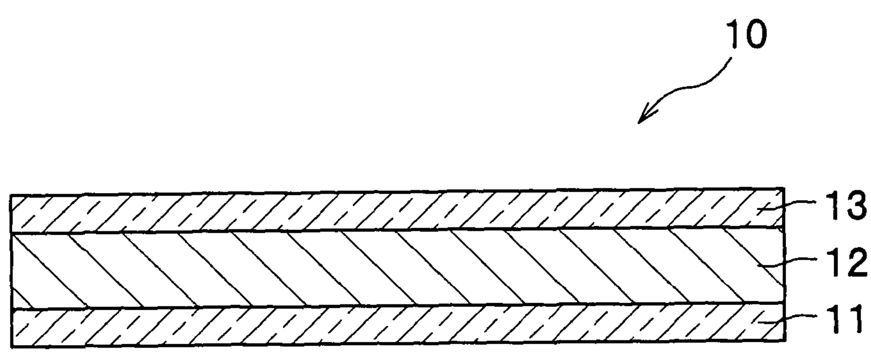


EP 2 028 654 A1

## Description

BACKGROUND OF THE INVENTION

The present invention relates to a holographic recording medium and a holographic recording apparatus.

In recent years, an optical information recording apparatus using holographic technology (i.e., holographic recording apparatus) has been developed for recording information with high recording density. Holographic recording is carried out by intersecting a signal beam into which information is imprinted and a reference beam having the same wavelength with that of the signal beam in a recording layer of a recording medium, and storing a generated interference pattern in the recording medium. To read out the information recorded in the recording medium, the subject interference pattern is illuminated with a readout beam having the same wavelength and the same angle with those of the reference beam that is illuminated at the time of recording, so that a reconstructed signal beam that is identical with the signal beam is obtained from the interference pattern.

Unlike an optical recording method using a conventional bit recording such as on a compact disc (CD) and digital versatile disc (DVD), a holographic recording apparatus permits a large amount of information per recording spot, and therefore it is expected to increase reading/writing speeds. Further, due to delicate and sensitive positioning/angle selectivity of a hologram, a large amount of different information can be recorded in the same recording region by changing angles or positions of the beams irradiated by the recording apparatus so as to perform multiple recording. The storage capacity can be increased to a large extent by utilizing such characteristics of the hologram.

However, upon holographic recording, the recording material reacts as the multiple recording proceeds, resulting in a gradual shrinkage of the recording material. Therefore, as more information is recorded in the recording layer, the direction of the recorded interference pattern is changed, and hence, even if the readout beam is emitted with the same conditions as those of the reference beam at the time of recording, the quality of the reconstructed signal beam may deteriorate.

In order to eliminate this drawback, it is conventionally necessary to restrict as low as possible a shrinkage of the recording material that is caused by illumination with a beam during the time of recording and fixing. However, it is difficult to eliminate the shrinkage of the recording material if the polymerization reaction of a monomer is used for recording information in a photopolymer material. For this reason, a proposal has been made to restrict the shrinkage ratio (shrinkage percentage) within 0.1 % by using a monomer with low polymerization shrinkage and optimizing the additive amount of the monomer in the photopolymer. This is shown, for example, by "Holographic Data storage" IBM Journal of Research and Development 44 (3), pp. 341-368 (Non-patent Reference 1), and "Holographic recording properties in thick films of ULSH-500 photopolymer" Proceedings of SPIE - The International Society for Optical Engineering 3291, pp.89-103 (Non-patent Reference 2).

Further, it is known that increasing the additive amount of the monomer in the photopolymer will result in increased storage capacity (M/#). This is shown, for example, by "Recording media that exhibit high dynamic range for digital holographic data storage" Optics letters Vol.24, No.7, pp.487-489 (Non-patent Reference 3). However, although the storage capacity can be increased, the amont of shrinkage increases accordingly. It is very much a situation in which there is a limit to the amount of monomer to be added in the recording material.

In order to prevent a decrease in signal quality due to shrinkage of the recording layer, various techniques have been proposed for adjusting and thus compensating the angle or the wavelength of the readout beam that is emitted for reading out information, as well as for controlling a temperature of the recording spot, etc. This is shown, for example, by Japanese Laid-open Patent Publication No. 2005-321597 corresponding to US 2007/0206448 A1 (Patent reference 1), and other non-patent references such as "Evaluation of polycarbonate substrate hologram recording medium regarding implication of birefringence and thermal expansion" Optics Communications 270 (2007) pp.17-24 (Non-patent Reference 4), and "Tenperature Compensation strategy for holographic storage" Proceedings of Optical data storage topical meeting 2006, WC4 (Non-patent Reference 5). However, each recording medium undergoes a different amount of light exposure at the time of recording in accordance with conditions such as information to be recorded, a type of the recording apparatus to be used, etc., and therefore each recording medium has different mode of shrinkage after recording. For this reason, it is difficult to perform optimization for each recording medium at a time of reading the information. Consequently, even with these tequniques, it is necessary to provide some additional contrivance to keep the change in the shrinkage amount within a predetermined range, preferably not more than 0.1 % at most, for performing acutual reading/writing of the recording medium.

In view of the above disadvantages of the prior art, the present invention seeks to provide a holographic recording medium and a holographic recording apparatus, which can read out data with reliability even if the recording medium undergoes a shrinkage due to light-exposure at the time of recording.

SUMMARY OF THE INVENTION

According to one aspect of the present invention, there is provided a holographic recording medium comprising at least two substrates, and a recording layer provided between the substrates. The recording layer has a property such that an average refractive index lowers as irradiation with a beam proceeds, and in the recording layer an optical compensation rate C that is defined by $C=(1-(n2/n1))/\alpha$ satisfies $0.8 \leq C \leq 1.0$, where $\alpha$ is a rate of thickness change of the recording layer before and after recording, n1 is an average refractive index before recording, and n2 is an average refractive index after recording.

In this holographic recording medium, the recording layer shrinks through irradiation with a beam. Because the recording layer is provided between the substrates and it is considered that the substrates are substantially non-shrinkable compared with the recording layer, the recording layer shrinks only in the direction of the thickness so that the direction (inclination) of the interference pattern changes. However, the recording layer according to the present invention has a property such that the average refractive index lowers as irradiation with a beam proceeds, so that when the interference pattern is irradiated with a beam for reading out a hologram (normally a beam to be emitted with the same conditions as those of the reference beam, and hereinafter referred as a "readout beam"), the readout beam can be considered optically as having the same conditions as those of the reference beam emitted at the time of recording. In other words, if the readout beam is emitted under the same conditions as those of the reference beam, the signal beam can be reconstructed. Therefore, unlike the conventional techniques, it is unnecessary to adjust the conditions at the time of reading the recording medium or alternatively, such an adjustment can be limited to the minimum extent if necessary.

The term "average refractive index" indicates the average of the refractive index over the whole system. Even if the refractive index is locally increased due to migration of a substance after irradiation with a beam, it may be said that the average refractive index lowers as long as the refractive index lowers as the average of the whole system.

The average refractive index of the recording layer may be measured by using a prism coupler or ellipsometry. The average refractive index can also be measured by arranging a recording material on one of optical paths of Michelson interferometer or Mach-Zehnder interferometer and irradiating the recording material with a beam of which the wavelength allows the recording material to be reacted, so that a physical shrinkage and a change in the average refractive index can be measured from a change in the length of the optical path.

If the optical compensation rate C satisfies $0.8 \leq C \leq 1.0$, the recording layer is considered to provide the substantially same effects as in the case of the shrinkage of the recording material within 0.1 % that is generally regarded as a preferable criterion, and therefore, the adjustment of the conditions is substantially unnecessary at the time of reading the recording medium.

The shrinkage ratio $\alpha$ is a value that is obtained by the formula: $\alpha=(t1-t2)/t1$, where t1 is the thickness of the recording layer before recording, and t2 is the thickness of the recording layer after recording. It is noted that throughout the specification and the drawings, the value of $\alpha$ may also be expressed by percentage. For instance, if the value of $\alpha$ is 0.01, the shrinkage ratio is also expressed as 1%.

In the aforementioned holographic recording medium, the recording layer may contain at least one kind of dye having a polymerizable group.

Further, in the aforementioned holographic recording medium, the dye having a polymerizable group may be such that an absorption peak wavelength $\lambda_{max}$ thereof is shorter by 10-200 nm than a wavelength of a hologram-reconstructing beam, that a molar absorptivity $\varepsilon$ at the absorption peak wavelength $\lambda_{max}$ is not smaller than 10,000, and that a molar absorptivity $\varepsilon$ at the wavelength of the hologram-reconstructing beam is not more than 100.

In order to lower the average refractive index through irradiation with a beam, the recording layer may comprise a compound of which an absorption spectrum changes through irradiation with a beam.

With the construction of this holographic recording medium, the average refractive index changes because the recording layer contains a compound of which an absorption spectrum changes through irradiation with a beam. Examples of such compound may be a color forming compound or a discolorable compound which develops or loses color through irradiation with a beam. Mostly, the higher the absorption of light, the higher the refractive index of the compound becomes, so that if the recording layer contains a discolorable compound which loses color through irradiation with a beam, irradiating the recording layer with a beam makes it possible to lower the average refractive index.

The beam for lowering the average refractive index may be a hologram-recording beam or another beam that is different from the hologram-recording beam. In the case where the average refractive index lowers as the irradiation with the hologram-recording beam proceeds, the recording material shrinks as more information is recorded in the recording layer and hence the average refractive index lowers accordingly. Therefore, irrespective of the number of recording times for the multiple recording, it is possible to provide a preferable average refractive index that is appropriate for reading the recording medium.

According to a second aspect of the present invention, there is provided a holographic recording apparatus which records information in the aforementioned holographic recording medium. The holographic recording apparatus

includes: a recording beam source configured to generate a laser beam; a device configured to create a signal beam and a reference beam from the laser beam, the signal beam being created from part of the laser beam by imprinting information into a section of the part of the laser beam, and the reference beam being created from the rest of the laser beam; an optical system configured to focus the signal beam and the reference beam in the recording layer of the holographic recording medium; and a refractive index control beam source configured to emit a light for lowering the average refractive index of the recording layer, a wave length of the light being different from that of the laser beam generated at the recording beam source.

As an alternative, the holographic recording apparatus includes: a recording beam source configured to generate a laser beam; an optical system configured to divide the laser beam into a signal beam and a reference beam and to focus the signal beam and the reference beam in the recording layer of the holographic recording medium; a device configured to imprint information into the signal beam; and a refractive index control beam source configured to emit a light for lowering the average refractive index of the recording layer, a wave length of the light being different from that of the laser beam generated at the recording beam source.

According to these holographic recording apparatuses, information is recorded by means of holography and the average refractive index of the recording layer is decreased using the refractive index control beam source. Lowering the average refractive index makes it possible to read out information recorded in the recording medium with the substantially same conditions as those of the reference beam emitted at the time of recording, even if the recording layer shrinks, that is, the direction of the interference pattern is changed due to a decrease in the thickness of the recording layer. Therefore, it becomes unnecessary to adjust the conditions at the time of reading the recording medium, or alternatively, such an adjustment can be limited to the minimum extent.

According to the holographic recording medium and the holographic recording apparatuses as described above, even if the recording layer shrinks after recording information in the recording layer, a change in the average refractive index of the recording layer advantageously cancels out or compensates a change in the angle of the interference pattern that causes in the process of shrinkage. Therefore, it becomes unnecessary to adjust the conditions at the time of reading the recording medium, or alternatively, such an adjustment can be limited to the minimum extent.

## BRIEF DESCRIPTION OF THE DRAWINGS

Other objects and aspects of the present invention will become more apparent by describing in detail illustrative, non-limiting embodiments thereof with reference to the accompanying drawings, in which:

FIG. 1 is a sectional view of a holographic recording medium according to one embodiment of the present invention;
FIG. 2 is an explanatory view showing angles of an interference pattern before and after recording information;
FIG. 3 is a block diagram showing a two-beam interference exposure apparatus;
FIG. 4 is a graph showing a change in angle of an interference pattern resulting from a volumetric shrinkage of 0.1 % in the recording layer that is generally regarded as a preferable criterion;
FIG. 5 is a graph showing a relation between shift amount of the sample angle and diffraction efficiency for each crossing angle;
FIG. 6 is a graph showing relations between shrinkage ratio and optical compensation rate for particular crossing angles $\theta_{AIR}$ when an optimal compensation (for keeping a shift angle within a range equal to or less than $\alpha$=0.1%) is carried out for the recording layer recorded with the recording condition of the sample angle being $\pm$40 degrees;
FIG. 7 is a block diagram showing a holographic recording apparatus according to a first example;
FIG. 8 is a block diagram showing a holographic recording apparatus according to a second example;
FIG. 9 is a graph showing relations between sample angle and Bragg detuning for Examples 1 and 2; and
FIG. 10 is a graph showing relations between sample angle and Bragg detuning for Examples 1 and 2 in the process of recording information.

## DETAILED DESCRIPTION OF THE INVENTION

With reference to the attached drawings, a holographic recording medium and a holographic recording apparatus according to the present invention will be described.

## HOLOGRAPHIC RECORDING MEDIUM

A holographic recording medium 10 according to this preferred embodiment comprises a substrate 11, a recording layer 12, and a substrate 13 in this order.

The substrate 11 is a plate-like member for supporting the recording layer 12.

The recording layer 12 is a layer containing a dye material of which an optical property such as refractive index

is changed through irradiation with a beam. Details of the recording layer 12 will be described later.

The substrate 13 holds the recording layer 12 such that the recording layer 12 is positioned between the substrates 11, 13, so as to protect the recording layer 12.

At least one of the substrates 11, 13 has permeability for a hologram-recording beam (signal beam and reference beam; hereinafter simply referred to as a "recording beam") that is used in a holographic recording apparatus as well as for a readout beam. Therefore, information can be recorded with the recording beam, and read out with the readout beam.

The substrate 11 and the substrate 13 may be made of any known preferable material. As an example, the substrate 11 may be made of glass, ceramics, resin, etc. However, in terms of moldability and cost, resin is most preferable. The substrate 13 may be made of the same material as that of the substrate 11.

The substrate 11 and the substrate 13 hold the recording layer 12 to such an extent that the recording layer 12 is substantially non-shrinkable along its plane direction while it shrinks in its thickness direction. Further, as long as the substrates 11, 13 do not impair the function as a holographic recording medium, the thickness and material thereof may be arbitrarily selected. For this reason, the substrate 11 and the substrate 13 may have a different name, for instance, a protect layer, a protect film, and the like.

The configuration of the holographic recording layer 10 is not limited to this triple-layered structure, and a reflective layer and an adhesive layer may be added where necessary. A pit or groove may be formed in the substrate 11 for servo control purposes. Further, the holographic recording medium 10 may be manufactured by any known preferable method, such as by injecting a recording layer material between the substrate 11 and the substrate 13 to form the recording layer 12, by applying the recording layer 12 on the substrate 11 and further the substrate 13 on the recording layer 12, and by separately preparing and bonding the substrate 11, the recording layer 12, and the substrate 13 together.

The recording layer 12 consists of an optical recording composition which contains at least one kind of dye having a polymerizable group. Namely, the recording layer 12 contains a so-called polymerizable monomer which changes from a monomer to a polymer through irradiation with light. The recording layer 12 may contain plural kinds of dyes.

The recording layer 12 has a thickness from several tens of micro meters to several millimeters, and information is recorded in the recording layer 12 by the known holographic recording method. Briefly speaking, information is imprinted into the section of a beam with a spatial light modulator (SLM) or the like to form a signal beam, and the recording layer 12 is irradiated with the signal beam and a reference beam that is a beam having the same wavelength as that of the signal beam. When the same region in the recording layer 12 is irradiated simultaneously with the signal beam and the reference beam, an interference pattern of light is formed. The dye having a polymerizable group then polymerizes according to the light intensity distribution of this interference pattern. Because of changes in refractive index and diffusion of unreacted monomers as a result of polymerization, a distribution in refractive-index in accordance with the interference pattern can be obtained.

The recording layer 12 has a property such that the average refractive index lowers as irradiation with light proceeds. Herein, the light may be the recording beam used in the holographic recording apparatus. Alternatively, the beam may be a different beam of which a wavelength is different from that of the recording beam.

It is preferable that the average refractive index lowers at a rate correlated with the shrinkage amount of the recording layer 12. In the recording layer 12, an optical compensation rate C that is defined by $C=(1-(n2/n1))/\alpha$ preferably satisfies the following formula:

$$0.8 \leq C \leq 1.0 \qquad (1)$$

where $\alpha$ is a rate of thickness change of the recording layer before and after recording, n1 is an average refractive index before recording, and n2 is an average refractive index after recording. The term "after recording" indicates the time at which all the recording processes have been completed in the case where the recording layer 12 is exposed to light multiple times. One exemplary measuring method for the optical compensation rate C assumes that the "after recording" is defined as the case in which the dyes contained in the recording layer 12 have been sufficiently reacted (polymerized), and the "before recording" is defined as the case in which the recording layer is not yet irradiated with the recording beam to obtain the optical compensation rate C.

In order to make the recording layer 12 have a property such that the average refractive index lowers as irradiation with light proceeds, it is preferable that the recording layer 12 contains a compound of which absorption spectrum changes through irradiation with light. To be more specific, other than the dye having a polymerizable group, the recording layer 12 preferably contains a compound of which an absorption spectrum changes through irradiation with light, that is, a compound which loses or develops color through irradiation with the hologram-reconstructing beam,

so that an adjustment of the average refractive index can be achieved before and after irradiation with the beam.

Alternatively, in order to make the recording layer 12 have a property such that the average refractive index lowers as irradiation with light proceeds, the dye having a polymerizable group may have a property such that the average refractive index lowers when a polymerization reaction occurs through irradiation with light.

OPTICAL RECORDING COMPOSITION FOR RECORDING LAYER 12

The optical recording composition used for the recording layer 12 will be described below. The recording layer 12 is appropriately prepared from the following compositions such that the optical compensation rate C satisfies $0.8 \leq C \leq 1.0$. Some examples for preparing the optical recording composition will be described later in EXAMPLES.

<Polymerizable Monomer>

The optical recording composition used for the recording layer 12 preferably contains at least one kind of dye having a polymerizable group. Herein, the dye in this preferred embodiment indicates a compound which absorbs any of ultraviolet light, visible light, and infrared light in the range of wavelengths from 300 to 2,000 nm, more preferably, ultraviolet light or visible light in the range of wavelengths from 330 to 700 nm, and most preferably, ultraviolet light or visible light in the range of wavelengths from 350 to 600 nm. In these instances, the molar absorptivity in any of the above wavelength areas is preferably not less than 5,000, more preferably not less than 10,000, and most preferably not less than 20,000.

In general, a dye shows a high refractive index at wavelengths around the absorption peak wavelength ($\lambda$max) or longer, particularly a very high refractive index at wavelengths in the range from $\lambda$max to the wavelength 200 nm longer than $\lambda$max. Some dyes even show a refractive index higher than 2 and higher than 2.5. Preferably in the absorption spectrum, the dye having a polymerizable group has $\lambda$max that is 10 to 200 nm shorter than the wavelength of the hologram-reconstructing beam, and more preferably, 30 to 130 nm shorter than the wavelength of the hologram-reconstructing beam, and molar absorptivity $\varepsilon$ thereof is not less than 10,000, and more preferably not less than 20,000.

Molar absorptivity $\varepsilon$ of the dye at the wavelength of the hologram-reconstructing beam is not more than 100, more preferably 10, and most preferably 0.

The dye having a polymerizable group is not limited to those having a specific polymerizable monomer, and any polymerizable group may be properly selected depending on application. Preferred examples of the polymerizable group include radical polymerizable monomers, cationic polymerizable monomers, and anionic polymerizable monomers. Preferably, the polymerizable group may be radical polymerizable monomers or cationic polymerizable monomers, and most preferably, the polymerizable group may be radical polymerizable monomers. The polymerizable group may be radical polymerizable monomers having an ethylene unsaturated bond such as an acrylic group, a methacrylic group, a styryl group, and a vinyl group. Of these, an acrylic group and a methacrylic group are more preferable. Further, the polymerizable group may be cationic polymerizable monomers or anionic polymerizable monomers having any of an oxirane ring, an oxetane ring, a vinyl ether group, and an N-vinylcarbazole. Of these, an oxirane ring or an oxetane ring are more preferable. These monomers may be monofunctional or polyfunctional. Optical crosslinking reaction may also be utilized for the polymerization.

As preferred examples of the dye having a polymerizable group, the dye preferably includes cyanine dyes, squarilium cyanine dyes, styryl dyes, pyrilium dyes, melocyanine dyes, arylidene dyes, oxonol dyes, azlenium dyes, coumarine dyes, ketocoumarine dyes, styrylcoumarine dyes, pyrane dyes, xanthene dyes, thioxanthene dyes, phenothiazine dyes, phenoxazine dyes, phenazine dyes, phthalocyanine dyes, azaporphyrin dyes, porphyrin dyes, condensed aromatic dyes, perylene dyes, azomethine dyes, anthraquinone dyes, metal complex dyes, and azo dyes. More preferably, the dye includes cyanine dyes, squarilium cyanine dyes, styryl dyes, melocyanine dyes, arylidene dyes, oxonol dyes, coumarine dyes, xanthene dyes, phenothiazine dyes, condensed aromatic dyes, and azo dyes. Most preferably, the dye includes cyanine dyes, melocyanine dyes, arylidene dyes, oxonol dyes, coumarine dyes, xanthene dyes, and azo dyes.

In addition to these dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as the dye according to the invention.

Preferred examples of the dye having a polymerizable group are shown in the following general formulae from C-1 to C-6.

C-1 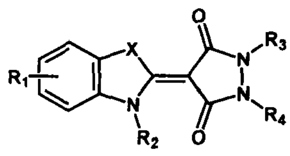 C-2 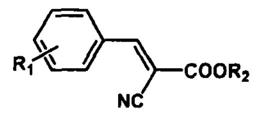

C-3 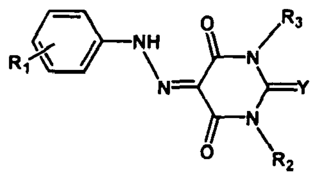 C-4 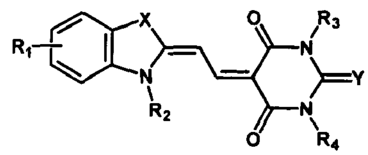

C-5 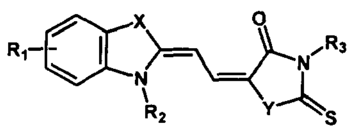 C-6 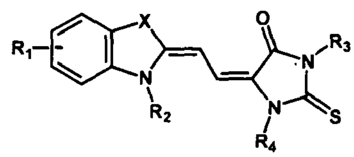

Wherein in the general formulae C-1 through C-6, $R_1$ represents any one of a hydrogen atom, a halogen atom, an alkyl group, an aryl group, a heterocyclic group, an alkoxy group, an aryloxy group, an alkoxycarbonyl group, an aryloxycarbonyl group, a carbamoyl group, a sulfamoyl group, an amino group, an acyloxy group, an acylamino group, a hydroxyl group, a carboxylic group, a sulfonic acid group. Of these groups, a hydrogen atom, a halogen atom, an alkyl group, an aryl group, a heterocyclic group, an alkoxy group, an aryloxy group, and an amino group are preferable. Further, a hydrogen atom, a halogen atom, an alkoxy group, an aryloxy group, and an amino group are more preferable, and a hydrogen atom, and a halogen atom are most preferable.

Wherein in the general formulae C-1 through C-6, $R_2$ to $R_4$ each represents any one of a hydrogen atom, an alkyl group, an aryl group, and a heterocyclic group. Of these, a hydrogen atom, an alkyl group, and an aryl group are preferable, and a hydrogen atom and an alkyl group are more preferable. An alkyl group, an aryl group, and a heterocyclic group represented by $R_1$ to $R_4$ may further have a substituent.

However, in the general formulae C-1, C-4, and C-6, at least one of $R_1$ to $R_4$ has a substituent having a polymerizable group. In the general formula C-2, at least one of $R_1$ and $R_2$ has a substituent having a polymerizable group. In the general formulae C-3 and C-5, at least one of $R_1$ to $R_3$ has a substituent having a polymerizable group.

X is a structure selected from O, S, Se, and $C(R_5)_2$, where $R_5$ is a hydrogen atom or an alkyl group, and specifically a methyl group is preferable. Y is selected from O, S, and Se.

An alkyl group represented by $R_1$ to $R_4$ preferably has 1-20 carbon atoms, more preferably 1-15 carbon atoms, and most preferably 1-10 carbon atoms. Examples of such an alkyl group include a methyl group, an ethyl group, an n-propyl group, an isopropyl group, an n-butyl group, an isobutyl group, a tert-butyl group, a pentyl group, a cyclopentyl group, a hexyl group, a cyclohexyl group, a heptyl group, an octyl group, a tert-octyl group, a 2-ethylhexyl group, a decyl group, a dodecyl group, and an octadecyl group. These groups may further have a substituent.

An aryl group represented by $R_1$ to $R_4$ preferably has 6-14 carbon atoms, more preferably 6-10 carbon atoms, and most preferably 6 carbon atoms. Examples of such an aryl group include a phenyl group, a naphtyl group, and an anthranil group. These groups may further have a substituent.

A heterocyclic group represented by $R_1$ to $R_4$ preferably has 4-13 carbon atoms, more preferably 4-10 carbon atoms, and most preferably 4-5 carbon atoms. Examples of such a heterocyclic group include a pyridine group, a thiophene group, a pyrrole group, a pyrrolidine group, an imidazole group, an oxazole group, and a thiazole group. These groups may further have a substituent.

A halogen atom represented by $R_1$ includes, for example, an iodine atom, a bromine atom, a chlorine atom, and a fluorine atom. Of these atoms, an iodine atom and a bromine atom are preferable.

An alkoxy group represented by $R_1$ preferably has 1-20 carbon atoms, more preferably 1-10 carbon atoms, and most preferably 1-5 carbon atoms. Examples of such an alkoxy group include a methoxy group, an ethoxy group,

a butoxy group, a propoxy group, a hexyloxy group, a cyclohexyloxy group, a heptyloxy group, an octyloxy group, a tert-octyloxy group, a 2-ethylhexyloxy group, a decyloxy group, a dodecyloxy group, and an octadecyloxy group. Such an alkoxy group may be substituted by a substituent.

An aryloxy group represented by $R_1$ preferably has 6-12 carbon atoms, and more preferably 6 carbon atoms. Examples of such an aryloxy group include a phenyloxy group, a naphthyloxy group, and an anthraniloxy group. Such an aryloxy group may be substituted by a substituent.

An alkoxycarbonyl group represented by $R_1$ preferably has 2-10 carbon atoms, more preferably 2-7 carbon atoms, and most preferably 2-5 carbon atoms. Examples of such an alkoxycarbonyl group include a methoxycarbonyl group, an ethoxycarbonyl group, a butoxycarbonyl group, a propoxycarbonyl group, a hexyloxycarbonyl group, a cyclohexyloxycarbonyl group, a heptyloxycarbonyl group, an octyloxycarbonyl group, a tert-octyloxycarbonyl group, and a 2-ethylhexyloxycarbonyl group. Such an alkoxycarbonyl group may be substituted by a substituent.

An aryloxycarbonyl group represented by $R_1$ preferably has 7-12 carbon atoms, and more preferably 7 carbon atoms. Examples of such an aryloxycarbonyl group include a phenyloxycarbonyl group, a naphthyloxycarbonyl group, and an anthraniloxycarbonyl group. Such an aryloxycarbonyl group may be substituted by a substituent.

A carbamoyl group represented by $R_1$ preferably has 1-12 carbon atoms, and more preferably 1-6 carbon atoms. Examples of such a carbamoyl group include a methylcarbamoyl group, an ethylcarbamoyl group, an n-propylcarbamoyl group, an isopropylcarbamoyl group, an n-butylcarbamoyl group, an isobutylcarbamoyl group, a tert-butylcarbamoyl group, and a phenylcarbamoyl group. Such a carbamoyl group may be substituted by a substituent.

A sulfamoyl group represented by $R_1$ preferably has 0-12 carbon atoms, and more preferably 1-6 carbon atoms. Examples of such a sulfamoyl group include a methylsulfamoyl group, an ethylsulfamoyl group, an n-propylsulfamoyl group, an isopropylsulfamoyl group, an n-butylsulfamoyl group, an isobutylsulfamoyl group, a tert-butylsulfamoyl group, and a phenylsulfamoyl group. Such a sulfamoyl group may be substituted by a substituent.

An amino group represented by $R_1$ preferably has 0-12 carbon atoms, and more preferably 1-6 carbon atoms. The amino group may be monosubstituted or disubstituted. Examples of such an amino group include a methylamino group, a dimethylamino group, an ethylamino group, a diethylamino group, an n-propylamino group, an isopropylamino group, an n-butylamino group, an isobutylamino group, a tert-butylamino group, a phenylamino group, and a diphenylamino group. Such an amino group may be substituted by a substituent.

An acyloxy group represented by $R_1$ preferably has 2-12 carbon atoms, and more preferably 2-6 carbon atoms. Examples of such an acyloxy group include a methylcarbonyloxy group, an ethylcarbonyloxy group, an n-propylcarbonyloxy group, an isopropylcarbonyloxy group, an n-butylcarbonyloxy group, an isobutylcarbonyloxy group, a tert-butylcarbonyloxy group, a phenylcarbonyloxy group, and an acryloyloxy group. Such an acyloxy group may be substituted by a substituent.

An acylamino group represented by $R_1$ preferably has 2-12 carbon atoms, and more preferably 2-6 carbon atoms. Examples of such an acylamino group include a methylcarbonylamino group, an ethylcarbonylamino group, an n-propylcarbonylamino group, an isopropylcarbonylamino group, an n-butylcarbonylamino group, an isobutylcarbonylamino group, a tert-butylcarbonylamino group, a phenylcarbonylamino group, and an acryloylamino group. Such an acylamino group may be substituted by a substituent.

Preferred examples of the substituent as described above include an alkyl group, a phenyl group, a halogen atom, an alkoxy group, an aryloxy group, an alkoxycarbonyl group, an aryloxycarbonyl group, an acyloxy group, an acylamino group, a carbamoyl group, a sulfamoyl group, a cyano group, a carboxylic acid group, a hydroxyl group, a sulfonic acid group, and heterocyclic group. Of these groups, a phenyl group, a halogen atom, an alkoxy group, an aryloxy group, an alkoxycarbonyl group, an aryloxycarbonyl group, an acyloxy group, an acylamino group, a carbamoyl group, a cyano group, and heterocyclic group are preferable, and a halogen atom, an alkoxy group, an aryloxy group, an alkoxycarbonyl group, an acyloxy group, and an acylamino group are more preferable, and further, a phenyl group, a halogen atom, an alkoxy group, an aryloxy group, and an alkoxycarbonyl group are most preferable.

Preferred examples of the polymerizable group to be substituted at $R_1$ to $R_4$ are shown in the following general formulae from P-1 to P-3:

P-1

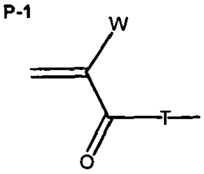

P-2

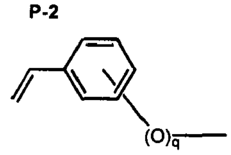

P-3

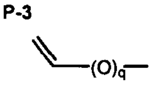

Wherein in the general formulae from P-1 to P-3, W represents a hydrogen atom or a methyl group, T represents -O- or $-NR_8-$, $R_8$ represents a hydrogen atom or an alkyl group, and q represents an integer of 0 or 1.

An alkyl group represented by $R_8$ preferably has 1-5 carbon atoms, more preferably 1-2 carbon atoms, and most preferably 1 carbon atom. Examples of such an alkyl group include a methyl group, and an ethyl group. These groups may further have a substituent.

Preferred examples of this substituent include an alkyl group, a phenyl group, a halogen atom, an alkoxy group, an aryloxy group, an alkoxycarbonyl group, an acyloxy group, an acylamino group, a carbamoyl group, a cyano group, a carboxylic acid group, a sulfonic acid group, a sulfamoyl group, a sulfurylamide group, an oxycarbonyl group, and a heterocyclic group. Of these groups, an alkoxy group, an acyloxy group, and an acylamino group are more preferable, and an acyloxy group and an acylamino group are most preferable.

In the above general formulae from P-1 to P-3, polymerizable groups represented by P-1 and P-2 are more preferable, and a polymerizable group represented by P-1 is most preferable. Specifically, an acryloyloxy group, a methacryloyloxy group, an N-acryloylamino group, and an N-acryloyl-N-alkylamino group are preferable. If the above polymerizable group is a substituent represented by the general formula P-1, polymerization may be formed swiftly.

As a preferred example of the substituents represented by $R_1$ to $R_4$ in the general formula C-1, each of $R_1$, $R_3$, and $R_4$ is a hydrogen atom or an alkyl group, $R_2$ is an alkyl group having a polymerizable group as a substituent, and X is O or S. More preferably, $R_1$, $R_3$, and $R_4$ are hydrogen atoms, $R_2$ is an alkyl group having a polymerizable group as a substituent, and X is S.

As a preferred example of the substituents represented by $R_1$ to $R_2$ in the general formula C-2, $R_1$ is an alkyl group having a polymerizable group as a substituent, and $R_2$ is an alkyl group or an aryl group. More preferably, $R_1$ is an alkyl group having a polymerizable group as a substituent, and $R_2$ is an alkyl group.

As a preferred example of the substituents represented by $R_1$ to $R_4$ in the general formula C-3, each of $R_1$, $R_2$, and $R_3$ is an unsubstituted alkyl group or an alkyl group having a polymerizable group as a substituent, and Y is O or S. More preferably, each of $R_1$ and $R_2$ is an unsubstituted alkyl group, $R_3$ is an alkyl group having a polymerizable group as a substituent, and Y is O.

As a preferred example of the substituents represented by $R_1$ to $R_4$ in the general formula C-4, $R_1$ is a hydrogen atom or an alkyl group, one of $R_2$ and $R_3$ is an alkyl group having a polymerizable group as a substituent, $R_4$ is an alkyl group, X is S, O or $C(Me)_2$, and Y is S or O. More preferably, $R_1$ is a hydrogen atom, one of $R_2$ and $R_3$ is an alkyl group having a polymerizable group as a substituent, $R_4$ is an alkyl group, X is O or $C(Me)_2$, and Y is S or O. Most preferably, $R_1$ is a hydrogen atom, $R_2$ is an alkyl group having a polymerizable group as a substituent, each of $R_3$ and $R_4$ is an alkyl group, X is $C(Me)_2$, and Y is O.

As a preferred example of the substituents represented by $R_1$ to $R_3$ in the general formula C-5, $R_1$ is a hydrogen atom or an alkyl group, $R_2$ is an alkyl group having a polymerizable group as a substituent, X is S, O or $C(Me)_2$, and Y is O or S. More preferably, R1 is a hydrogen atom, $R_2$ is an alkyl group having a polymerizable group as a substituent, X is O or $C(Me)_2$, and Y is S.

As a preferred example of the substituents represented by $R_1$ to $R_4$ in the general formula C-6, each of $R_1$, $R_3$, and $R_4$ is a hydrogen atom or an alkyl group, $R_4$ is an alkyl group having a polymerizable group as a substituent, and X is O or S. More preferably, each of $R_1$, $R_3$, and $R_4$ is a hydrogen atom, $R_4$ is an alkyl group having a polymerizable group as a substituent, and X is S.

In the general formulae from C-1 to C-6, C-2, C-4, C-5, and C-6 are preferable. Further, C-4 and C-5 are more preferable, and C-4 is the most preferable.

Specific examples of the dye having a polymerizable group will be shown below. However, the present invention is not limited to these specific examples. It should be noted that one or more kinds of these monomers may be used in combination.

DM-1

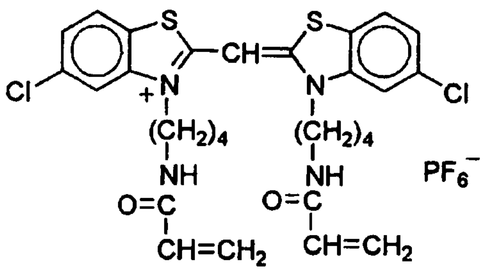

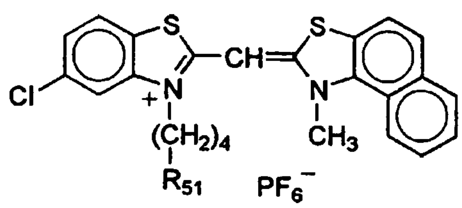

| | $R_{51}$ |
|---|---|
| DM-2 | $-NHCOCH=CH_2$ |

DM-5

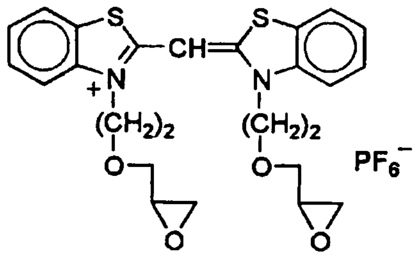

| | |
|---|---|
| DM-3 | 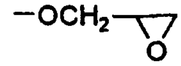 |
| DM-4 | $-OCH=CH_2$ |

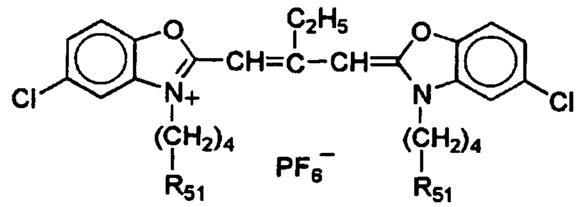

| | $R_{51}$ |
|---|---|
| DM-6 | 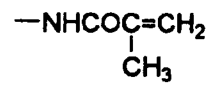 |
| DM-7 | 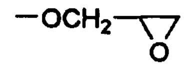 |

DM-8

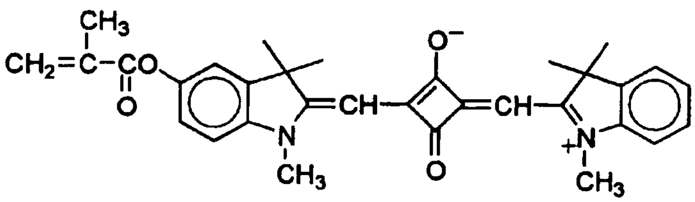

DM-9

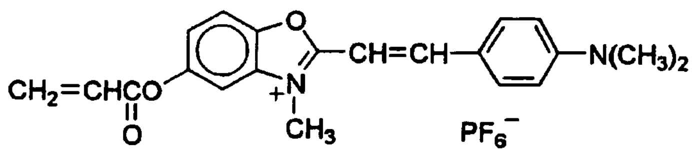

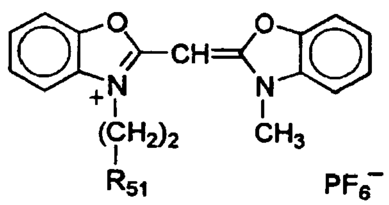

| | $R_{51}$ |
|---|---|
| DM-10 | 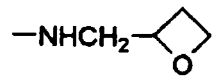 |
| DM-11 | 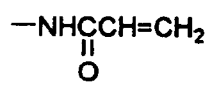 |

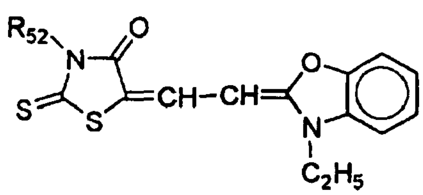

| | $R_{52}$ |
|---|---|
| DM-12 | $-CH=CH_2$ |
| DM-13 | 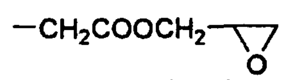 |
| DM-14 | 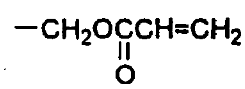 |

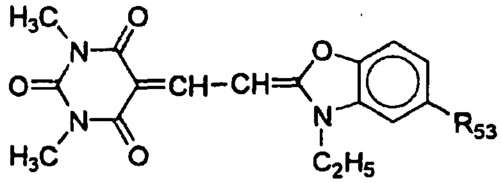

| | $R_{53}$ |
|---|---|
| DM-15 | 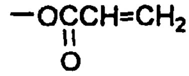 |
| DM-16 | 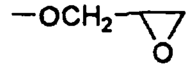 |
| DM-17 | 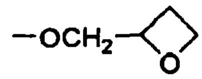 |

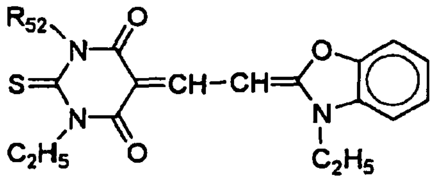

| | $R_{52}$ |
|---|---|
| DM-18 | $-CH=CH_2$ |
| DM-19 | 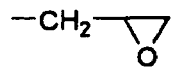 |

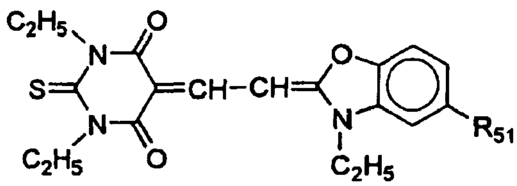

| | $R_{51}$ |
|---|---|
| DM-20 | 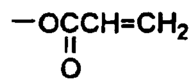 |
| DM-21 | 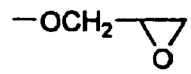 |

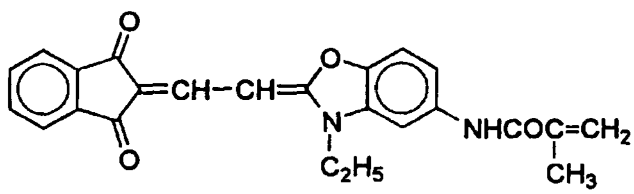

DM-22

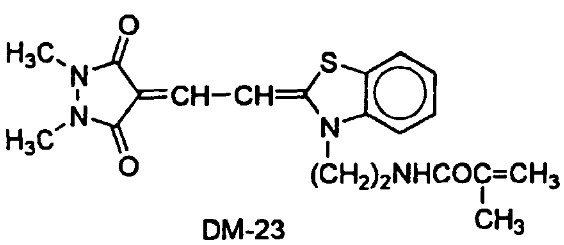

DM-23

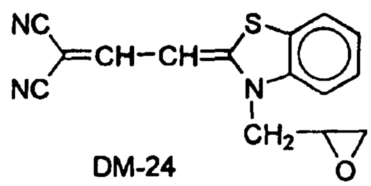

DM-24

DM-25

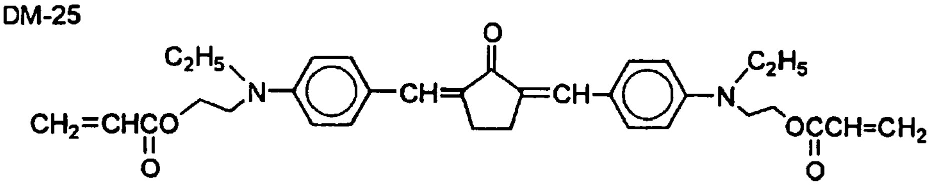

DM-26

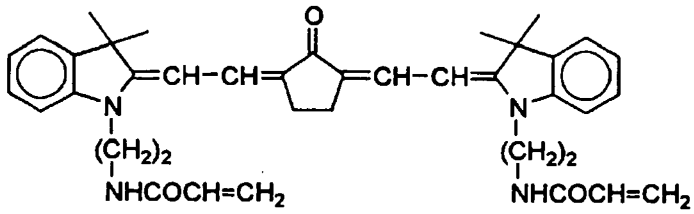

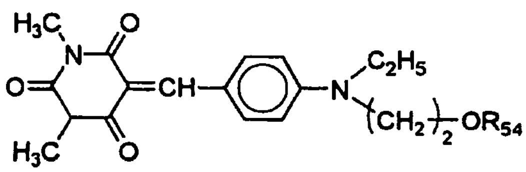

| | $R_{54}$ |
|---|---|
| DM-27 | 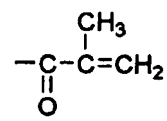 |
| DM-28 | 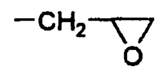 |
| DM-29 | 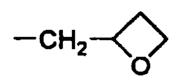 |

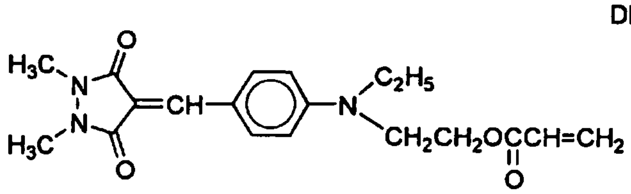

DM-30

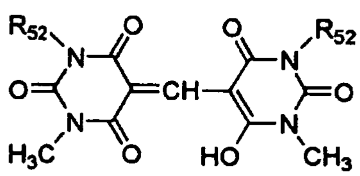

| | $R_{52}$ |
|---|---|
| DM-31 | $-CH=CH_2$ |
| DM-32 | 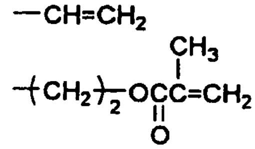 |
| DM-33 | 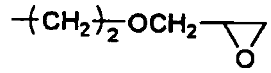 |
| DM-34 | 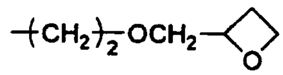 |

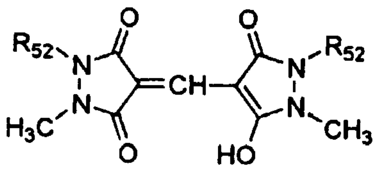

| | $R_{52}$ |
|---|---|
| DM-35 | $-CH=CH_2$ |
| DM-36 | 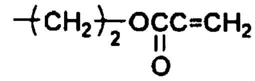 |
| DM-37 | 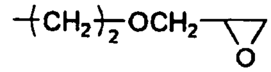 |

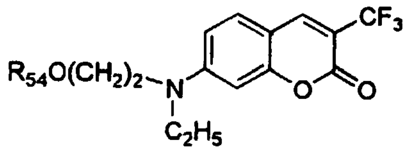

| | $R_{54}$ |
|---|---|
| DM-38 | 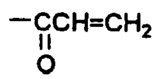 |
| DM-39 | 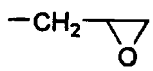 |
| DM-40 | $-CH=CH_2$ |

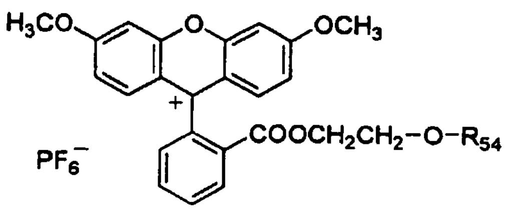

| | $R_{54}$ |
|---|---|
| DM-41 | 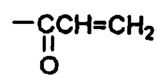 |
| DM-42 | 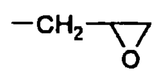 |

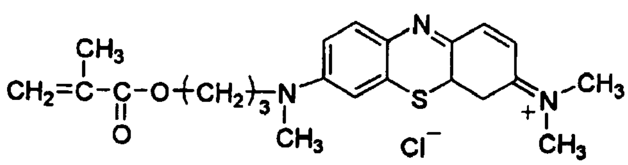

DM-43

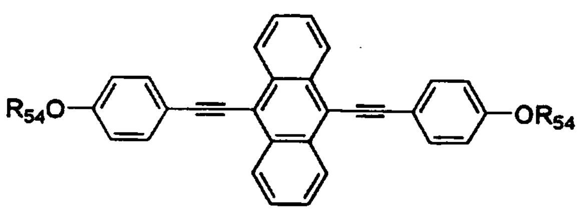

| | $R_{54}$ |
|---|---|
| DM-44 | 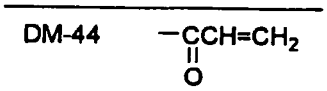 |
| DM-45 | 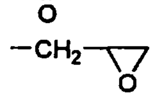 |

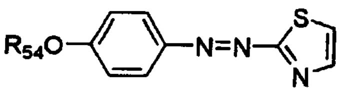

| | $R_{54}$ |
|---|---|
| DM-46 | 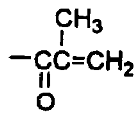 |
| DM-47 | 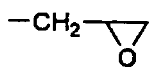 |
| DM-48 | $-CH=CH_2$ |

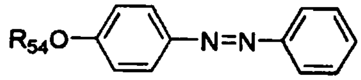

| | $R_{54}$ |
|---|---|
| DM-49 | 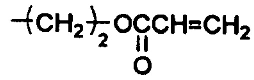 |
| DM-50 | 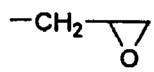 |

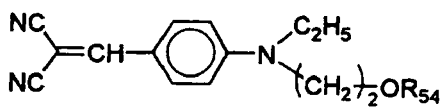

| | $R_{54}$ |
|---|---|
| DM-51 | 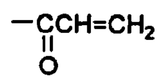 |
| DM-52 | 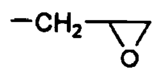 |

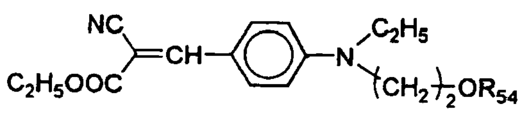

| | $R_{54}$ |
|---|---|
| DM-53 | 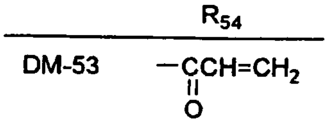 |
| DM-54 | 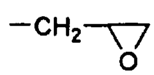 |

DM-55

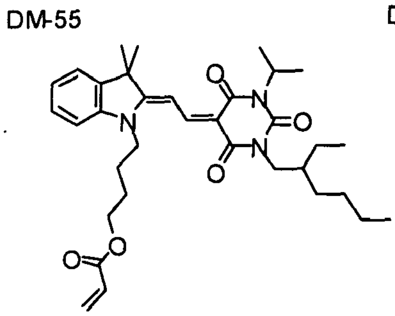

DM-56

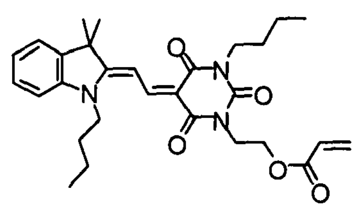

DM-57

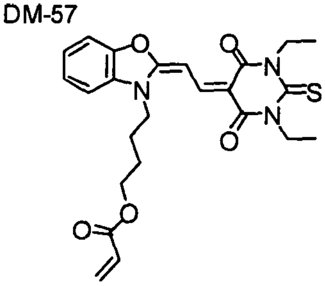

DM-58

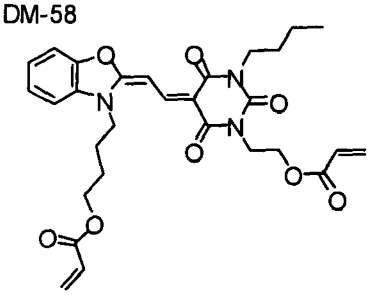

DM-59

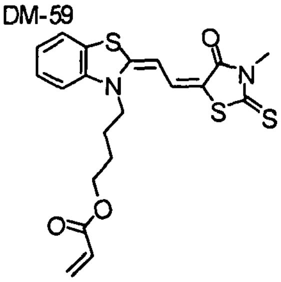

DM-60

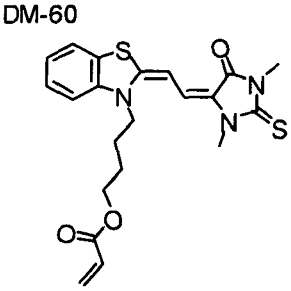

DM-61

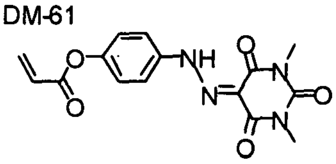

DM-62

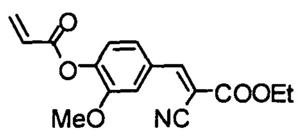

DM-63

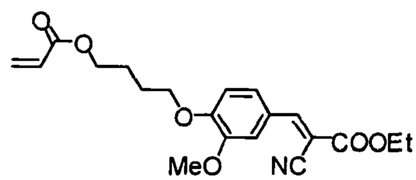

DM-64

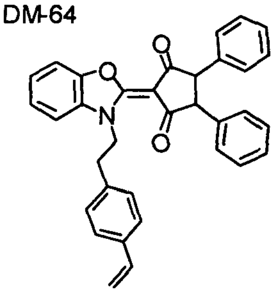

DM-65

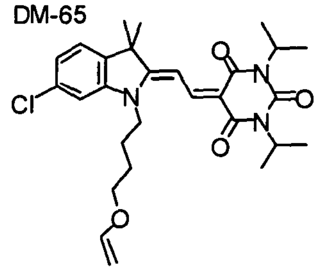

The content of the dye having a polymerizable group within the optical recording composition is preferably 1-40 mass %, and more preferably 3-30 mass %. If the content is less than 1 mass %, the sensitivity of the recording layer 12 may be lowered. On the contrary, if the content is more than 40 mass %, the multiple recording property will deteriorate.

<Other Polymerizable Monomers>

Other than the dye having a polymerizable group, the optical recording composition in the recording layer 12 may contain other polymerizable monomers where necessary. The polymerizable monomer may be properly selected depending on the application; for example, the polymerizable monomer may be radical polymerizable monomers having an unsaturated bond such as an acrylic group and a methacrylic group or cationic polymerizable monomers having an ether structure such as an epoxy ring and an oxetane ring. These monomers may be monofunctional or polyfunctional. Optical crosslinking reaction may also be utilized for the polymerization.

Examples of the radical polymerizable monomer include acryloyl morpholine, phenoxyethylacrylate, isobornylacrylate, 2-hydroxypropylacrylate, 2-ethylhexylacrylate, 1,6-hexanediol diacrylate, tripropyleneglycol diacrylate, neopentylglycol PO modified diacrylate, 1,9-nonandiol diacrylate, hydroxylpivalic acid neopentylglycoldiacrylate, EO modified bisphenol A diacrylate, polyethyleneglycol diacrylate, di(urethane-acrylate) oligomer, pentaerythritol triacrylate, pentaerythritol tetraacrylate, pentaerythritol hexaacrylate, EO modified glycerol triacrylate, trimethylolpropane triacrylate, EO modified trimethylolpropane triacrylate, 2-naphtho-1-oxyethylacrylate, 2-carbazoyl-9-ylethylacrylate, (trimethylsilyloxy)dimethylsilyl propylacrylate, vinyl-1-naphthoate, N-vinylcarbazol, 2,4,6-tribromophenylacrylate, pentabromophenylacrylate, phenylthioethylacrylate and tetrahydrofurfurylacrylate.

Examples of the cationic polymerizable monomer include bisphenol A epoxy resins, phenolnovolac epoxy resins, glycerol triglycidylether, 1,6-hexaneglycidylether, vinyltrimethoxysilane, 4-vinylphenyl trimethoxysilane, $\gamma$-methacryloxy propyltriethoxysilane and compounds expressed by formulae (M1) to (M6) in Japanese Laid-open Patent Publication No. 2007-119731. It should be noted that one or more kinds of these monomers may be used in combination.

If other polymerizable monomers are used, the content of these polymerizable monomers within the optical recording composition is preferably 1-40 mass %, and more preferably 1-20 mass %, based on the solid content in the total polymerizable monomers. In this preferred embodiment, the radical polymerizable monomer is particularly preferable.

<Color Forming Compound or Discolorable Compound>

Preferably, the optical recording composition contains at least one kind of color forming compound or discolorable compound, which develops or loses color through the optical recording exposure or in the process of fixation. The color forming compound may be a compound which shows a reaction such that in the region of ultraviolet light, visible light, and infrared light having wavelengths of 200-2000 nm, either the absorption peak wavelength $\lambda_{max}$ becomes

longer in the absorption spectrum or the molar absorptivity ε becomes larger in the absorption spectrum, and more preferably, both reactions occur in the compound. It is preferable that the color forming reaction occurs in the range of wavelengths from 200 to 900 nm, and more preferably in the range of wavelengths from 300 to 600 nm.

If a color forming reaction proceeds in the optical recording composition, it is preferable that the optical recording composition contains at least one kind of color forming compound, of which an absorption peak wavelength $\lambda_{max}$ increases or the molar absorptivity ε increases from the original state and which can turn out to be a colored material having no absorption in the wavelength of the hologram-reconstructing beam. The color forming reaction by the color forming compound proceeds in accordance with a thermal reaction or a photoreaction. In the case of the photoreaction, a color may be developed by a direct excitation which is induced by light irradiation of the color forming compound and/or the color may be developed using electron transfer or energy transfer from the excited state of the sensitizing dye that is created when the sensitizing dye is irradiated with light.

It is preferable that the optical recording composition has little or no absorption in the wavelength of the hologram-reconstructing beam during the readout from the recording medium.

Therefore, when the color forming compound turns out to be a colored material, it is preferable to be a colored material having no absorption in the wavelength of the hologram-reconstructing beam but having absorption in the wavelength range shorter than the wavelength of the hologram-reconstructing beam. To be more specific, it is preferable that it is a colored material having the absorption maximum in the range between the wavelength of the hologram-reconstructing beam and the wavelength 200 nm shorter than that of the hologram-reconstructing beam, and more preferably in the range between the wavelength of the hologram-reconstructing beam and the wavelength 150 nm shorter than that of the hologram-reconstructing beam. The sensitizing dye preferably decomposes during the optical recording or the subsequent fixing to lose its absorption and sensitizing capacity.

The sensitizing dye preferably absorbs any one of ultraviolet light, visible light and infrared light in the range of wavelengths from 200 to 2,000 nm, and more preferably ultraviolet light or visible light in the range of wavelengths from 300 to 700 nm, to produce the excited state.

Preferred examples of the sensitizing dye include cyanine dyes, squarilium cyanine dyes, styryl dyes, pyrilium dyes, melocyanine dyes, benzylidene dyes, oxonol dyes, azlenium dyes, coumarine dyes, ketocoumarine dyes, styrylcoumarine dyes, pyrane dyes, xanthene dyes, thioxanthene dyes, phenothiazine dyes, phenoxazine dyes, phenazine dyes, phthalocyanine dyes, azaporphyrine dyes, porphyrine dyes, condensed aromatic dyes, perylene dyes, azomethine dyes, anthraquinone dyes, metal complex dyes, and metalocene dyes. Of these sensitizing dyes, cyanine dyes, squarilium cyanine dyes, pyrilium dyes, melocyanine dyes, oxonol dyes, coumarine dyes, ketocoumarine dyes, styrylcoumarine dyes, pyrane dyes, xanthene dyes, thioxanthene dyes, condensed aromatic dyes, metal complex dyes, and metalocene dyes are more preferable, and cyanine dyes, melocyanine dyes, oxonol dyes, metal complex dyes, and metalocene dyes are most preferable. $R_u$ complex dyes are particularly preferable as the metal complex dyes, and ferrocene dyes are particularly preferable as the metalocene dyes.

In addition to these sensitizing dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as sensitizing dye of the invention. The sensitizing dye to be used in the invention is not limited to these examples. Any dye or dyestuff may be used so far as it absorbs light in the visible range. These sensitizing dyes may be selected such that they are adapted for the wavelength of the laser beam from the light source depending on the purpose. Two or more sensitizing dyes may be used in combination depending on the purpose.

In the case where the optical recording composition is used as the hologram recording material, since the hologram recording material needs to be used in the form of a sufficiently thick film and the film has to transmit most of the recording beam, the molar absorptivity of the sensitizing dye at the wavelength of the holographic exposure is preferably reduced to maximize the added amount of the sensitizing dye for the purpose of enhancing sensitivity. The molar absorptivity of the sensitizing dye at the wavelength of the holographic exposure is preferably in the range not smaller than 1 and not greater than 10,000, more preferably not smaller than 1 and not greater than 5,000, even more preferably not smaller than 5 and not greater than 2,500, and most preferably not smaller than 10 and not greater than 1,000.

The transmissivity of the hologram-recording beam with respect to the hologram recording material is preferably from 10 to 99%, more preferably from 20 to 95%, even more preferably from 30 to 90%, and most preferably from 40 to 85%, in view of diffraction efficiency, sensitivity and recording density (multiplicity of recording). To this end, the molar absorptivity of the sensitizing dye at the recording wavelength and the molarity of the sensitizing dye to be added are preferably adjusted in accordance with the film thickness of the hologram recording material. The absorption peak wavelength $\lambda_{max}$ of the sensitizing dye is preferably shorter than the wavelength of the recording beam or the fixing beam, and more preferably in the range between the wavelength of the recording beam and the wavelength 100 nm shorter than that of the recording beam (or in the range between the wavelength of the fixing beam and the wavelength 100 nm shorter than that of the fixing beam).

Specific examples of the sensitizing dye will be described below. However, the present invention is not limited to these dyes.

< Cyanine dyes >

S-1

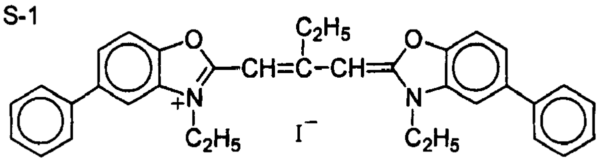

S-2

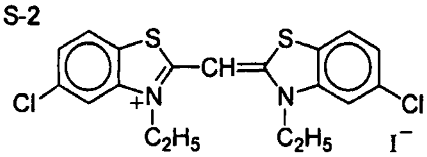

S-3

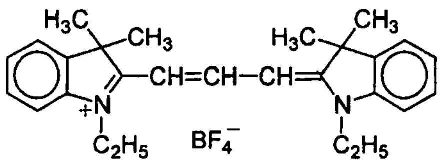

S-4

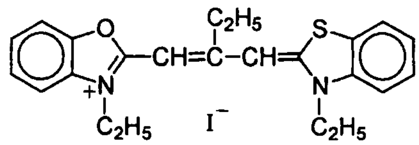

S-5

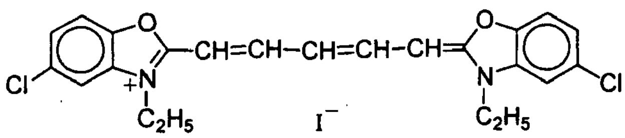

S-6

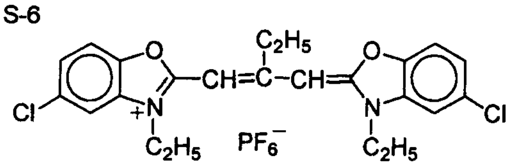

S-7

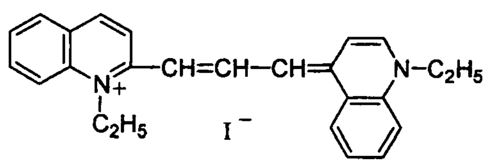

S-8

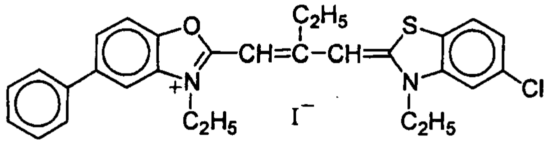

S-9

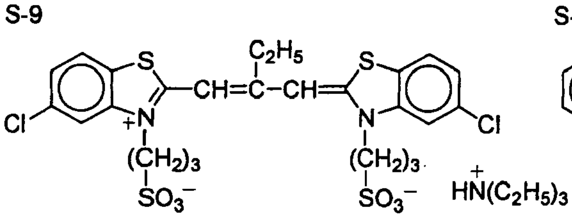

S-10

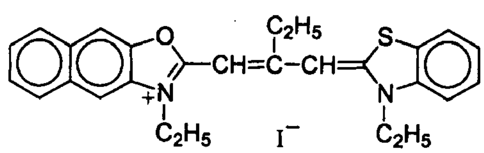

S-11 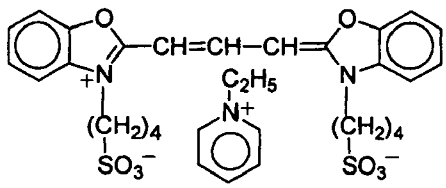

< Squarilium cyanine dyes >

S-12 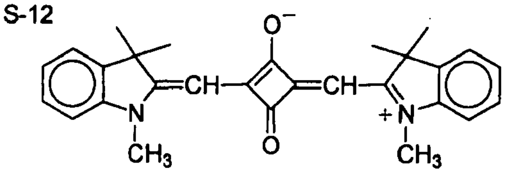

S-13 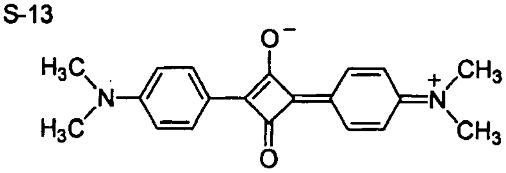

< Styryl dyes >

S-14 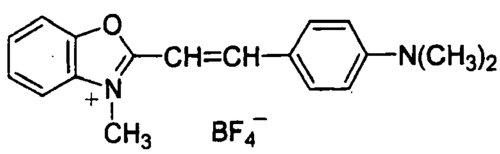

S-15 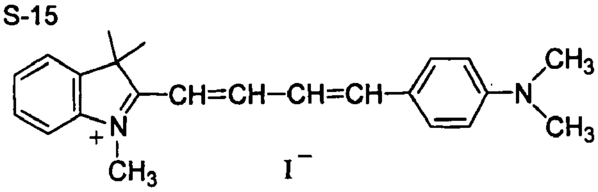

< Pyrilium dyes >

S-16 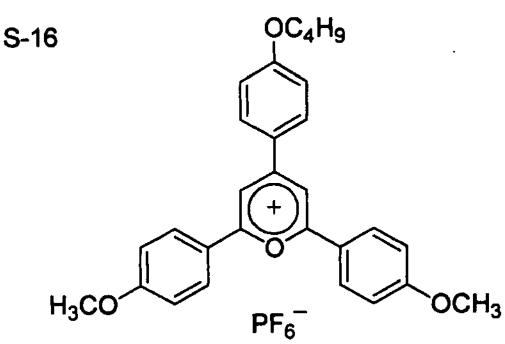

S-17 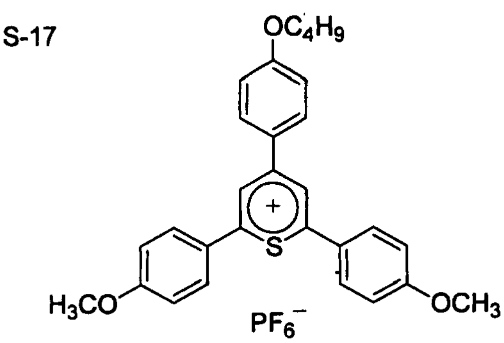

< Melocyanine dyes >

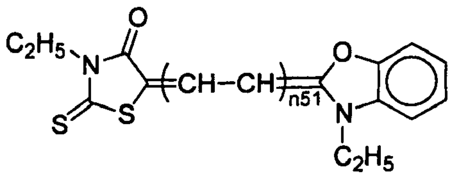

| | n51 |
|---|---|
| S-18 | 0 |
| S-19 | 1 |
| S-20 | 2 |

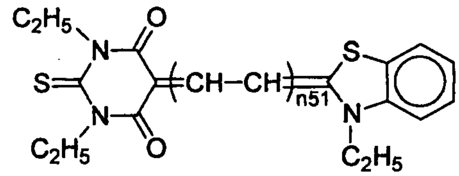

| | n51 |
|---|---|
| S-23 | 1 |
| S-24 | 2 |

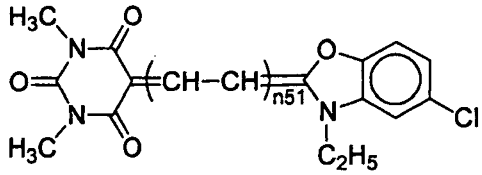

| | n51 |
|---|---|
| S-21 | 1 |
| S-22 | 2 |

$Q_{51}$=CH-CH=$Q_{52}$

| | $Q_{51}$ | $Q_{52}$ | | $Q_{51}$ | $Q_{52}$ |
|---|---|---|---|---|---|
| S-25 | 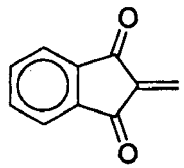 | 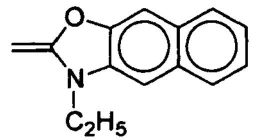 | S-26 | 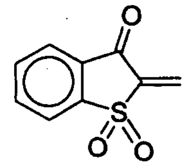 | 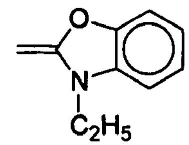 |
| S-27 | 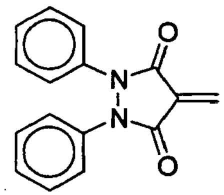 | 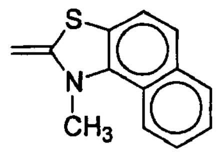 | S-28 | 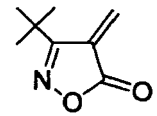 | 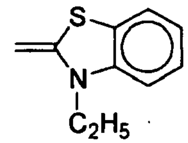 |
| S-29 | 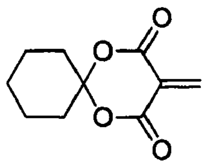 | 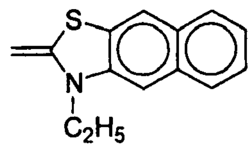 | | | |

< Cont. from Melocyanine dyes >

S-30

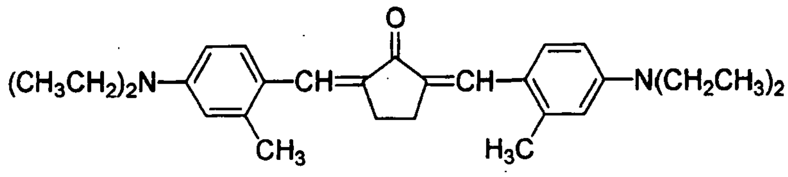

S-31

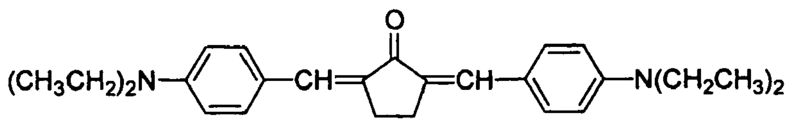

S-32

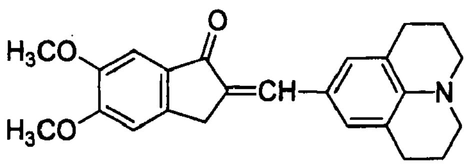

S-33

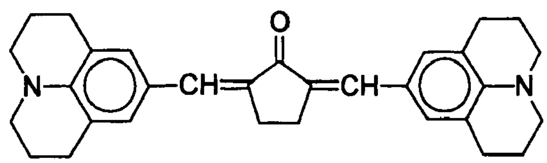

S-34

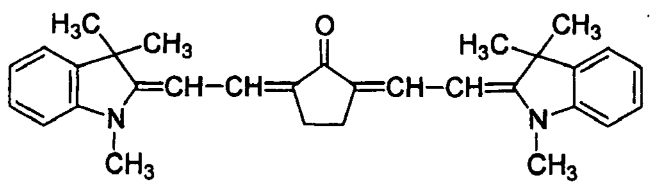

S-35

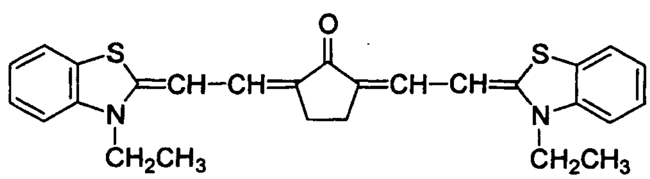

S-36

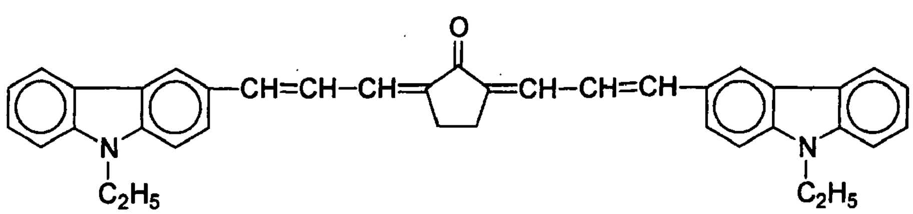

< Arylidene dyes >

S-37 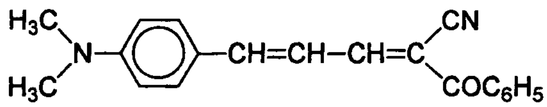

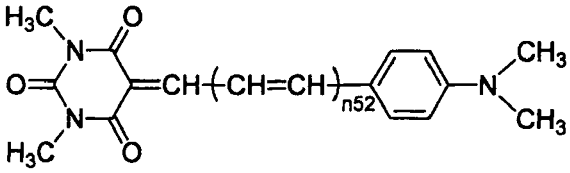

| | n52 |
|---|---|
| S-38 | 0 |
| S-39 | 1 |

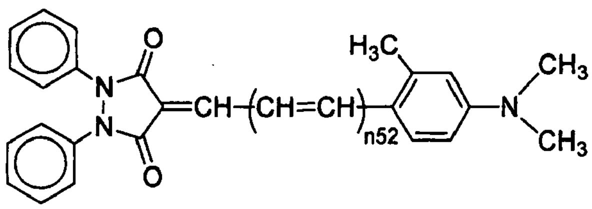

| | n52 |
|---|---|
| S-40 | 0 |
| S-41 | 1 |

< Oxonol dyes >

$Q_{52}=CH\!\left(CH=CH\right)_{n53}Q_{53}$ CI

| | $Q_{52}$ | $Q_{53}$ | $n_{53}$ | CI |
|---|---|---|---|---|
| S-42 | 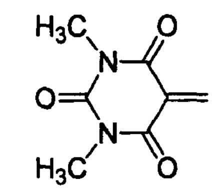 | 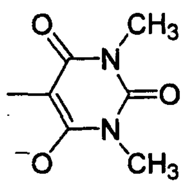 | 2 | $H^+$ |
| S-43 | 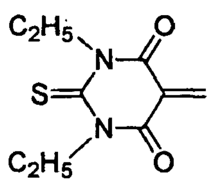 | 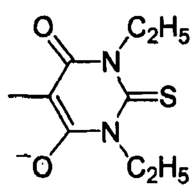 | 1 | 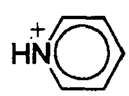 |
| S-44 | 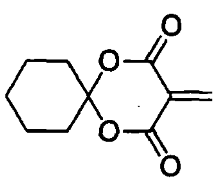 | 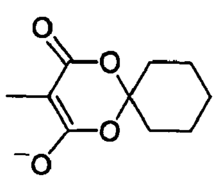 | 2 | $H^+$ |

(continued)

| | $Q_{52}$ | $Q_{53}$ | $n_{53}$ | CI |
|---|---|---|---|---|
| S-45 | 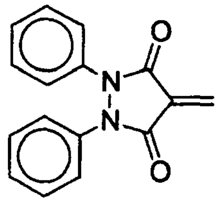 | 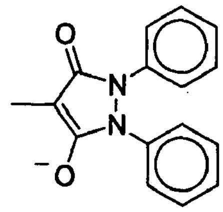 | 1 | $H^+$ |
| S-46 | 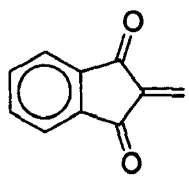 | 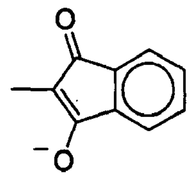 | 1 | $+ HN(C_2H_5)_3$ |

< Azlenium dyes >

S-47

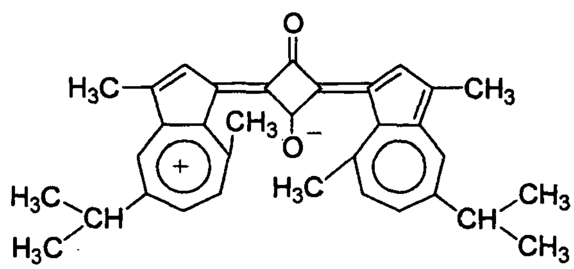

< Coumarine dyes >

S-48

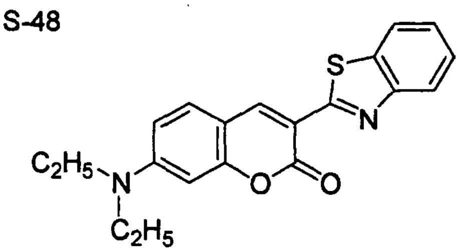

S-49

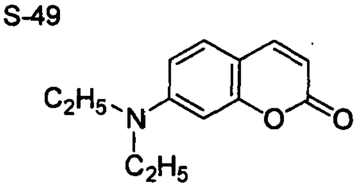

< Ketocoumarine dyes >

S-50

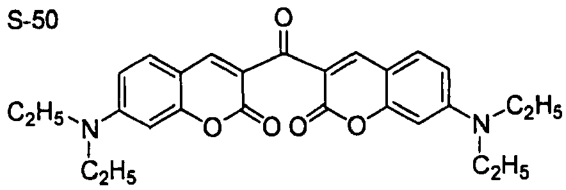

S-51

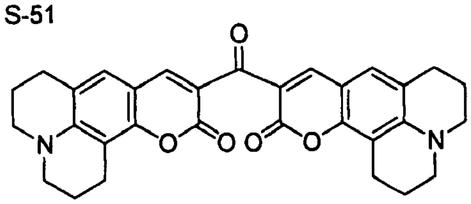

< Styrylcoumarine dyes >

S-52

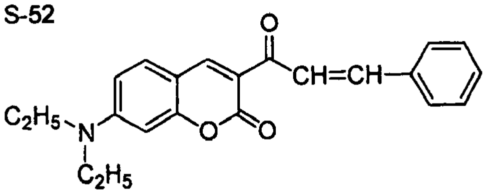

S-53

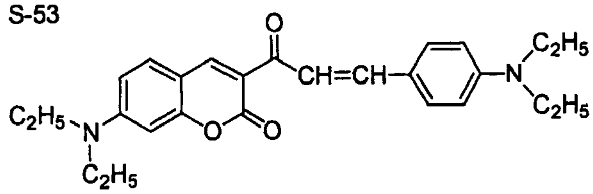

< Pyrane dyes >

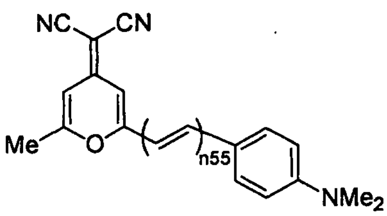

| | n55 |
|---|---|
| S-54 | 1 |
| S-55 | 2 |
| S-56 | 3 |

< Xanthene dyes >

S-57

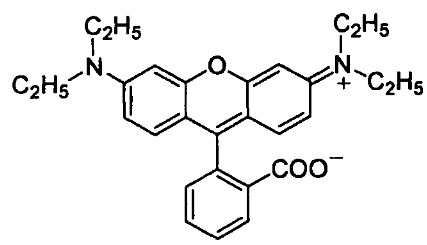

S-58

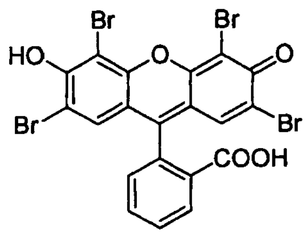

< Thioxanthene dyes >

S-59

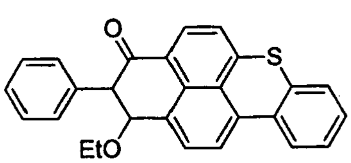

< Phenothiazine dyes >

S-60

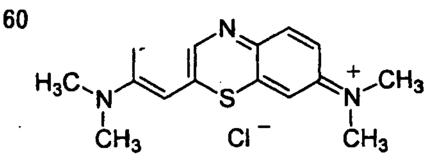

< Phenoxazine dyes >

S-61

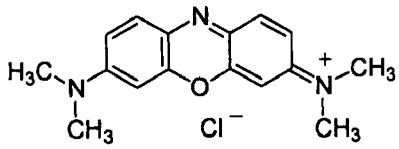

< Phenazine dyes >

S-62

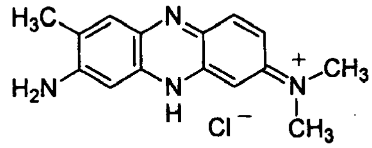

< Phthalocyanine dyes >

S-63

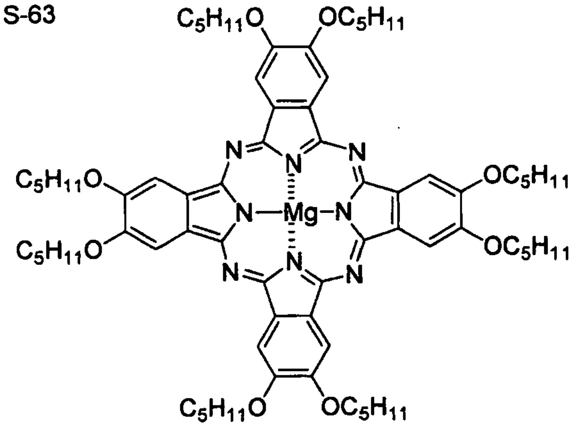

< Azaporphyrine dyes >

S-64

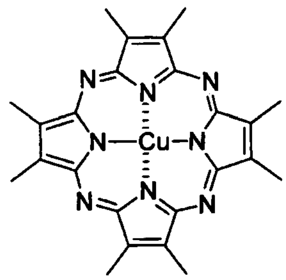

< Porphyrine dyes >

S-65

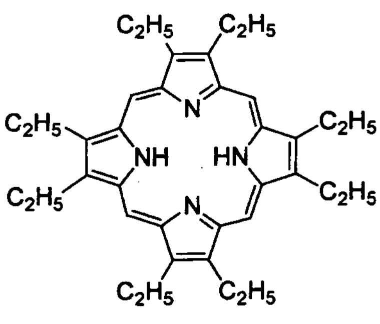

< Condensed aromatic dyes >

S-66

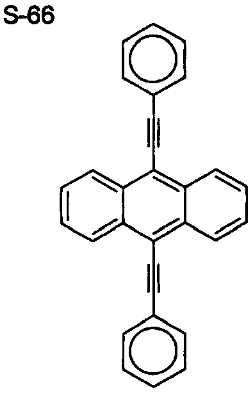

S-67

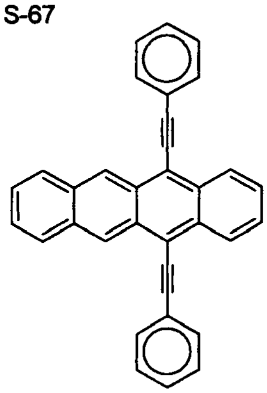

< Perylene dyes >

S-68

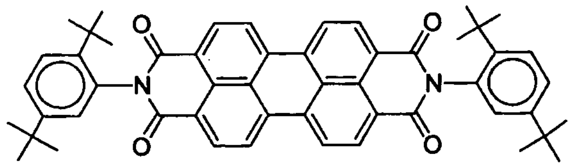

< Azomethine dyes >

S-69

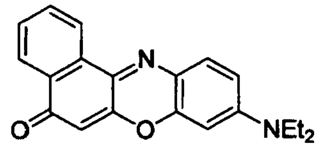

< Anthraquinone dyes >

S-70

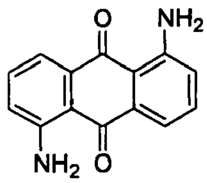

< Metal complex dyes >

S-71

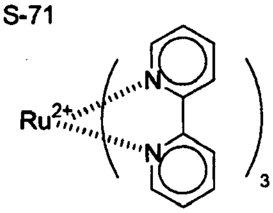

$(PF_6^-)_2$

S-72

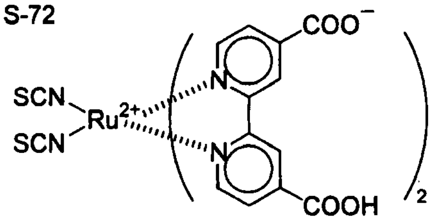

S-73

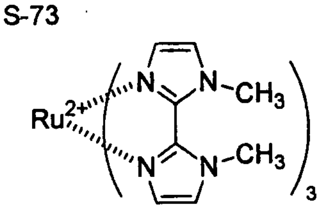

$(PF_6^-)_2$

S-74

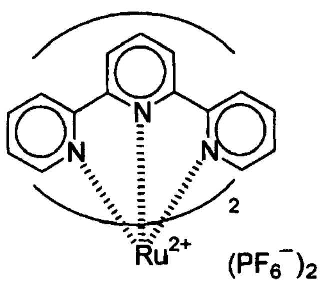

$(PF_6^-)_2$

S-75

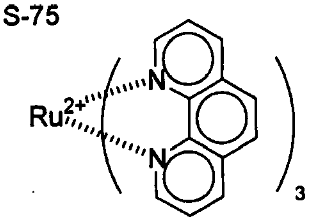

$(PF_6^-)_2$

S-76

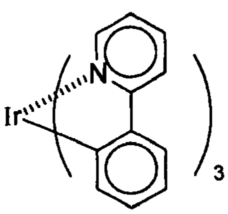

S-77

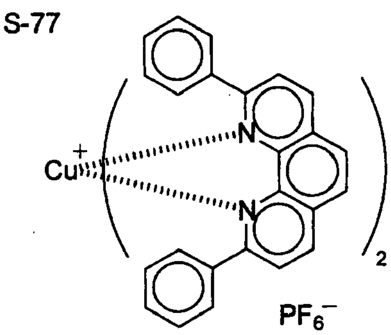

$PF_6^-$

S-78

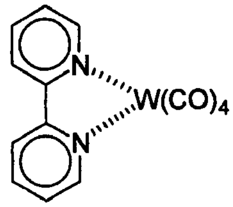

S-79

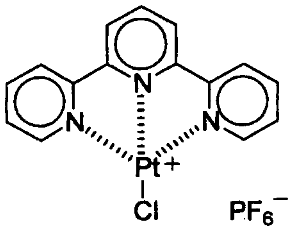

S-80

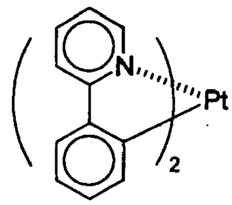

< Metalocene dyes >

S-81

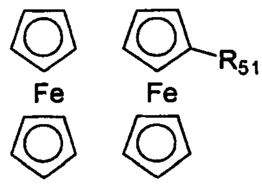

| | $R_{51}$ |
|---|---|
| S-82 | $-CHO$ |
| S-83 | $-CH_2CH_2COOH$ |
| S-84 | $-CH_2CH_2COOCH_3$ |
| S-85 | 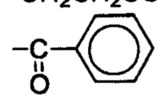 |
| S-86 | $-CH_2OH$ |
| S-87 | $-COOCH_3$ |

S-88

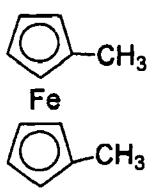

S-89

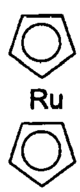

S-90

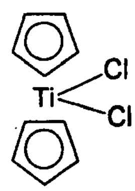

< Cont. from Cyanine dyes >

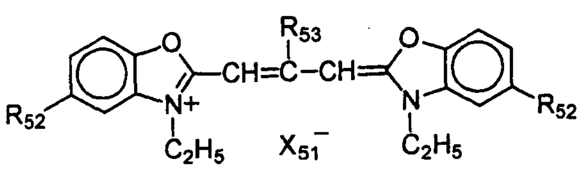

| | $R_{52}$ | $R_{53}$ | $X_{51}^-$ |
|---|---|---|---|
| S-91 | $-Cl$ | $-H$ | $I^-$ |
| S-92 | $-H$ | $-C_2H_5$ | 〃 |
| S-93 | 〃 | $-H$ | 〃 |
| S-94 | 〃 | 〃 | $PF_6^-$ |
| S-95 | $-Br$ | 〃 | $BF_4^-$ |
| S-96 | $-CH_3$ | 〃 | $I^-$ |
| S-97 | $-OCH_3$ | $-C_2H_5$ | $PF_6^-$ |

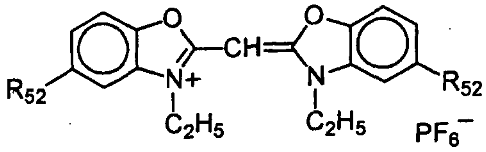

| | $R_{52}$ |
|---|---|
| S-98 | —H |
| S-99 | —Cl |
| S-100 | —Ph |
| S-101 | —$CH_3$ |
| S-102 | —$OCH_3$ |

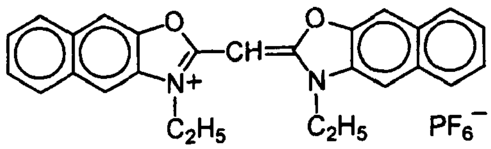

S-103

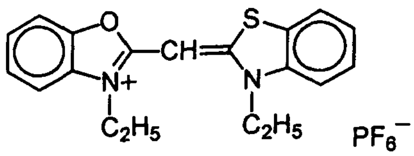

S-104

In the case where the hologram recording is effected using a frequency-doubled YAG laser beam of which an optical recording wavelength is 532 nm, particularly preferable examples of the sensitizing dye include trimethinecyanine dyes having a benzoxazole ring, melocyanine dyes having a barbiturate-like nucleus, benzylidene dyes having a pyrazolidinedioate-like nucleus, Ru complex dyes, and ferrocenes. In the case where the hologram recording is effected using a laser beam, such as GaN and InGaN, of which an optical recording wavelength is in the range from 400 to 415 nm, particularly preferable examples of the sensitizing dye include monomethinecyanine dyes having a benzoxazole ring, melocyanine dyes, Ru complex dyes, and ferrocenes.

Other preferable examples of the sensitizing dye are disclosed in Japanese Laid-open Patent Publication No. 2005-99751. The sensitizing dye may be commercially available or synthetically prepared by known methods.

Preferably, the following combinations are given as a color forming component. Specific examples of the color forming component are disclosed in Japanese Laid-open Patent Publication No. 2005-99751.

(I) Combination of at least an acid-induced color-forming compound and an acid generating agent, and optionally an acid proliferator;

Preferable examples of the acid generating agent include diaryl iodonium salts, sulfonium salts, diazonium salts, metal arene complex, trihalomethyl-substituted triazine, sulfonic acid ester, and imidosulfonate. Of these, diaryl iodonium salts and sulfonium salts are more preferable. Preferable examples of the acid generating agent are disclosed in Japanese Laid-open Patent Publication No. 2005-99753.

Specific examples of the acid generating agent will be shown below. However, the present invention is not limited to these specific examples.

I-3

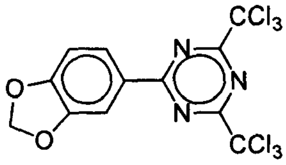

I-4

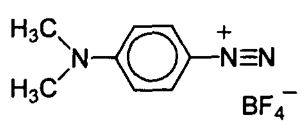

I-5

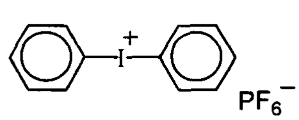

I-6

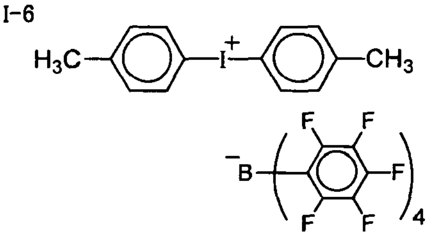

I-7

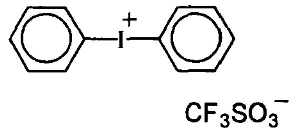

I-8

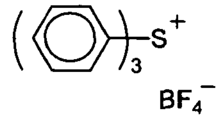

I-9

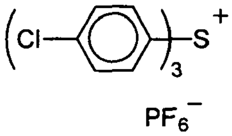

I-10

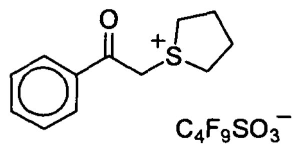

I-21

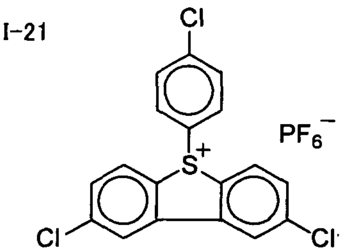

I-22

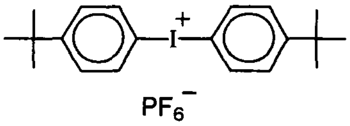

I-23

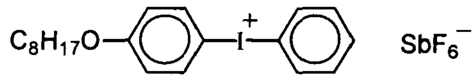

I-24

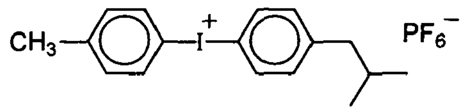

I-25

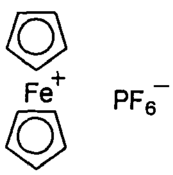

I-26

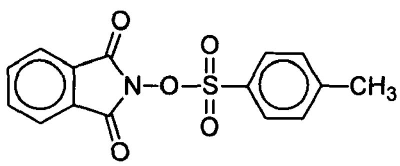

I-27

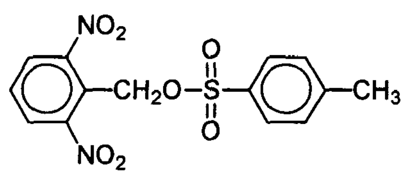

I-28

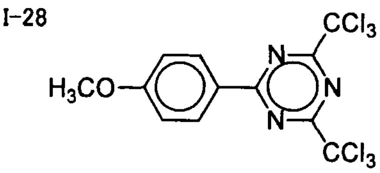

I-29

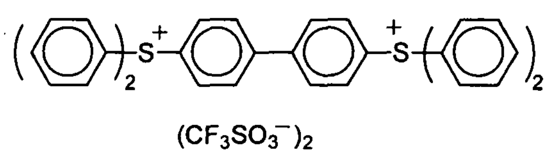

I-30

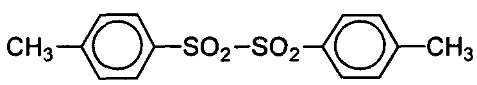

As a colored material generated from the acid-induced color-forming compound, xanthenes dyes, fluorane dyes, and triphenylmethane dyes are preferable. Specific examples of the acid-induced color-forming compound will be shown below. However, the present invention is not limited to these specific examples.

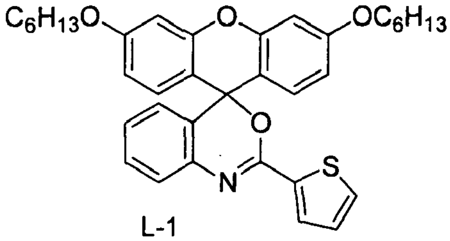

L-1

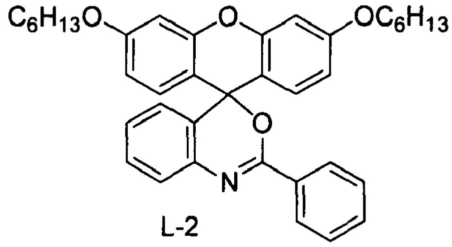

L-2

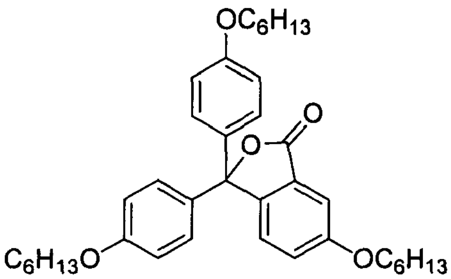

L-3

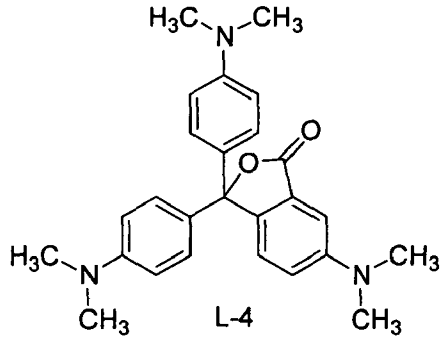

L-4

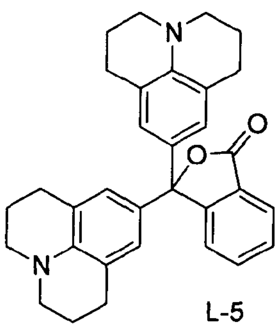

L-5

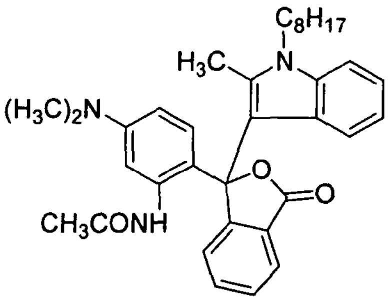

L-6

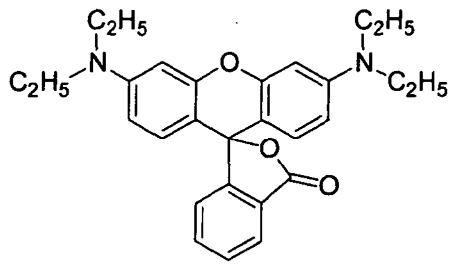

L-7

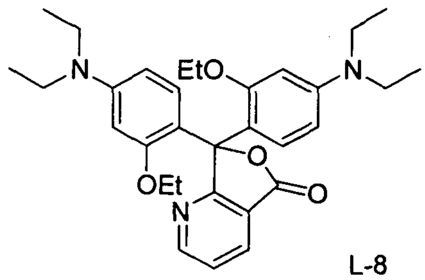

L-8

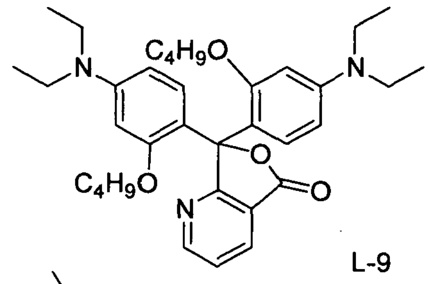

L-9

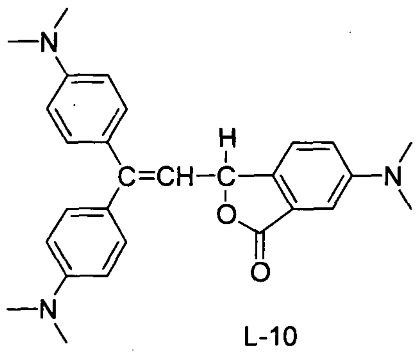

L-10

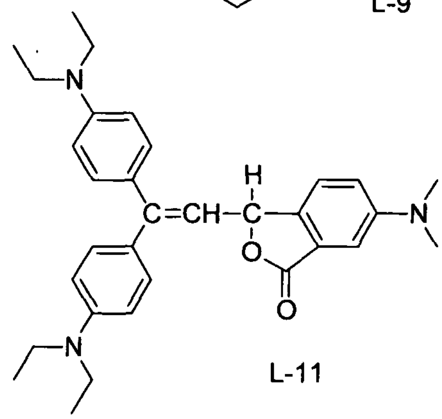

L-11

As a preferable example of the acid-induced color-forming compound, a cyanine base (leuco cyanine dyes) which forms a color by the addition of an acid (proton) may also be used. Specific examples of the cyanine base will be shown below. However, the present invention is not limited to these specific examples.

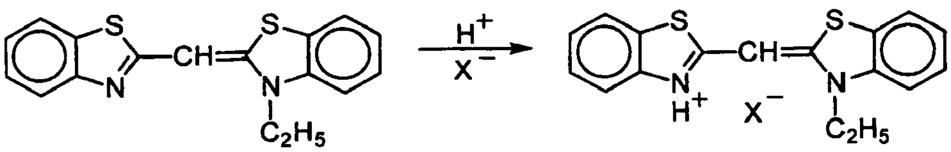

Cyanine base (Leuco cyanine dyes), Colorless

Cyanine dyes, Colorless

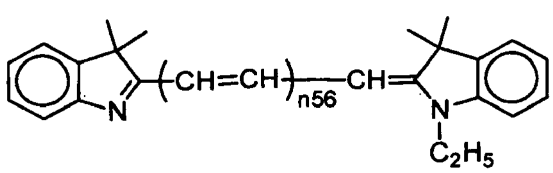

| | $n_{56}$ |
|---|---|
| LC-1 | 0 |
| LC-2 | 1 |
| LC-3 | 2 |

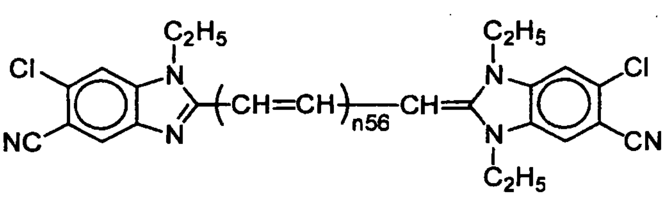

| | $n_{56}$ |
|---|---|
| LC-4 | 0 |
| LC-5 | 1 |
| LC-6 | 2 |

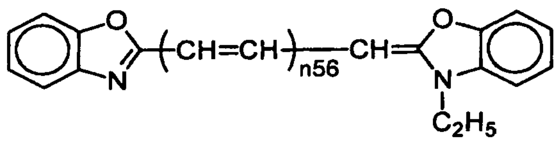

| | $n_{56}$ |
|---|---|
| LC-7 | 0 |
| LC-8 | 1 |

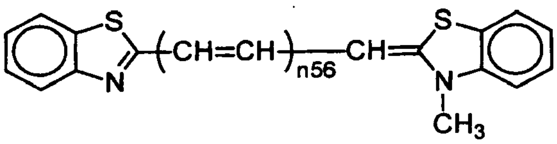

| | $n_{56}$ |
|---|---|
| LC-9 | 0 |
| LC-10 | 1 |

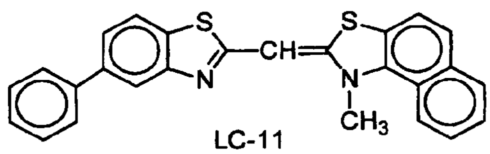

LC-11

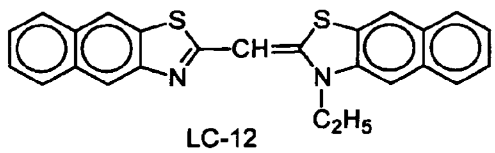

LC-12

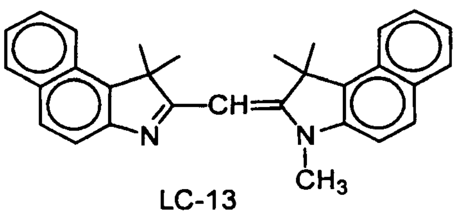

LC-13

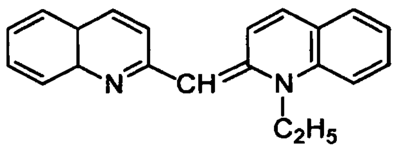

LC-14

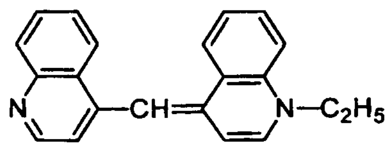

LC-15

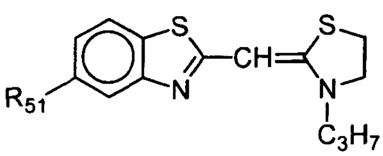

| | $R_{51}$ |
|---|---|
| LC-16 | $-H$ |
| LC-17 | $-Cl$ |

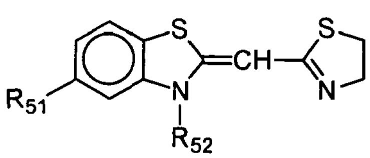

| | $R_{51}$ | $R_{52}$ |
|---|---|---|
| LC-18 | $-H$ | $-C_3H_7$ |
| LC-19 | $-Cl$ | $-C_3H_7$ |
| LC-20 | $-Cl$ | $-C_8H_{17}$ |
| LC-21 | $-CN$ | $-C_3H_7$ |
| LC-22 | 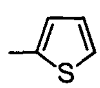 | $-C_8H_{17}$ |

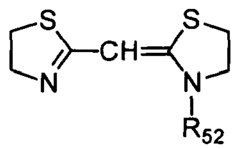

| | $R_{52}$ |
|---|---|
| LC-23 | $-C_8H_{17}$ |
| LC-24 | $-(CH_2)_2-O-(CH_2)_2-O-(CH_2)_2-OCH_3$ |

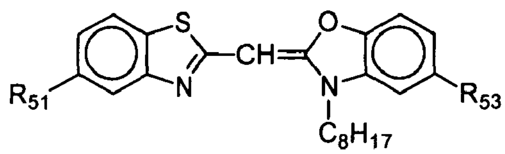

| | $R_{51}$ | $R_{53}$ |
|---|---|---|
| LC-25 | $-H$ | $-H$ |
| LC-26 | $-Cl$ | $-H$ |
| LC-27 | $-Cl$ | $-Cl$ |

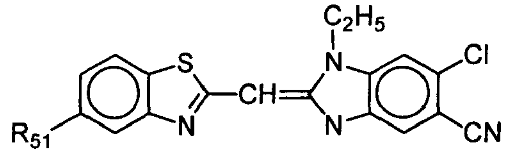

| | $R_{51}$ |
|---|---|
| LC-28 | $-H$ |
| LC-29 | $-Cl$ |

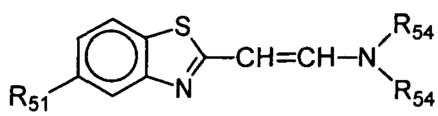

| | $R_{51}$ | $R_{54}$ |
|---|---|---|
| LC-30 | $-H$ | $-C_{12}H_{25}$ |
| LC-31 | $-H$ | $-CH_2COOC_2H_5$ |
| LC-32 | $-H$ | $-CH_2COOC_8H_{17}$ |
| LC-33 | $-CN$ | $-CH_2COOC_2H_5$ |

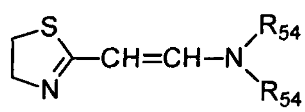

| | $R_{54}$ |
|---|---|
| LC-34 | $-C_6H_{13}$ |
| LC-35 | $-CH_2COOC_2H_5$ |
| LC-36 | $-CH_2COOC_6H_{13}$ |

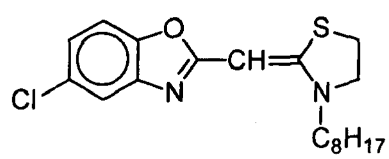

LC-37

Preferable examples of the acid proliferator are disclosed in Japanese Laid-open Patent Publication No. 2005-17730.

(II) Combination of at least a base-induced color-forming compound and a base generating agent, and optionally a base proliferator;

Preferable examples of the base generating agent and the base proliferator are disclosed in Japanese Laid-open Patent Publication No. 2005-17354, the disclosure of which is also herein incorporate by reference in its entirety.

The base-induced color-forming compound may be a non-dissociation product of dissociative azo dyes, dissociative azomethine dyes, dissociative oxonol dyes, dissociative xanthene dyes, dissociative fluorane dyes, and dissociative triphenylmethane dyes.

Specific examples of the base-induced color-forming compound will be shown below. However, the present invention is not limited to these specific examples.

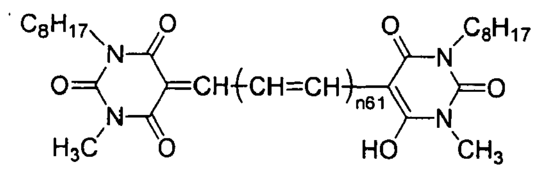

| | n61 |
|---|---|
| DD-1 | 1 |
| DD-2 | 2 |
| DD-3 | 3 |

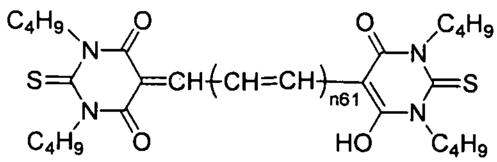

| | n61 |
|---|---|
| DD-4 | 0 |
| DD-5 | 1 |
| DD-6 | 2 |

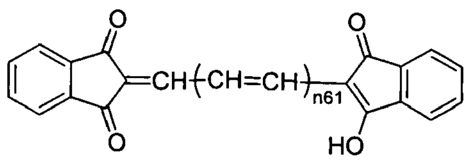

| | n61 |
|---|---|
| DD-7 | 0 |
| DD-8 | 1 |
| DD-9 | 2 |

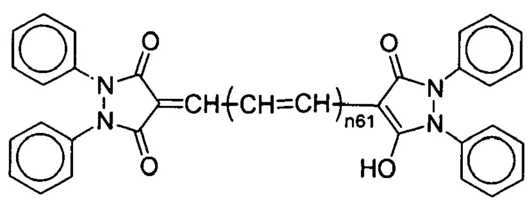

| | n61 |
|---|---|
| DD-10 | 0 |
| DD-11 | 2 |
| DD-12 | 3 |

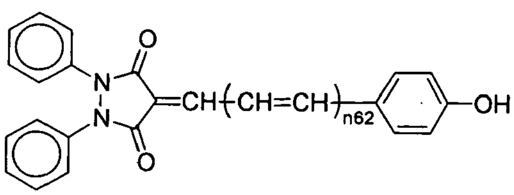

| | n62 |
|---|---|
| DD-13 | 0 |
| DD-14 | 1 |

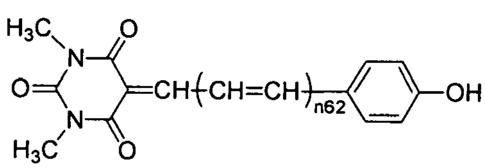

| | n62 |
|---|---|
| DD-15 | 0 |
| DD-16 | 1 |

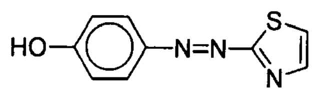

DD-17

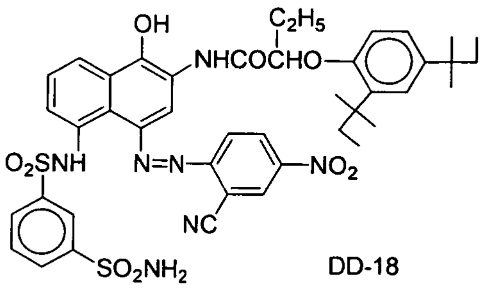

DD-18

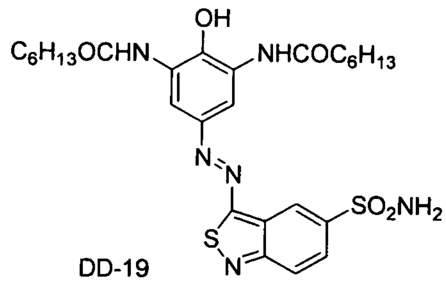

DD-19

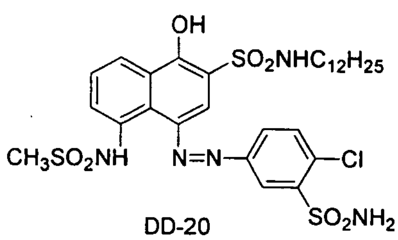

DD-20

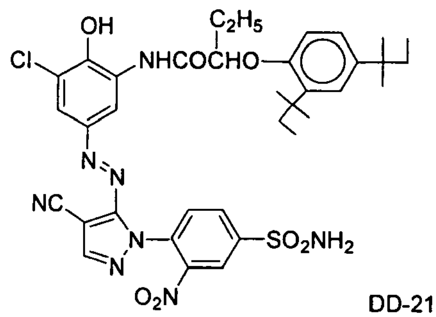

DD-21

DD-22

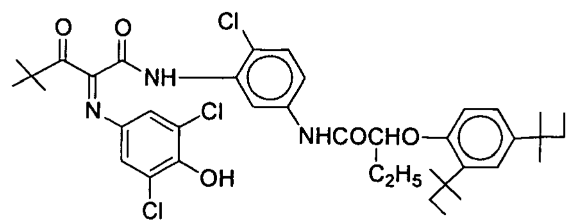

DD-23

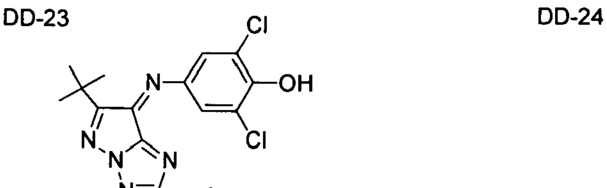

DD-24

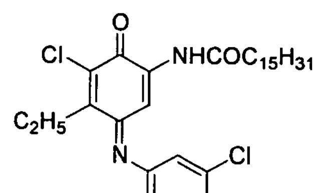

DD-25

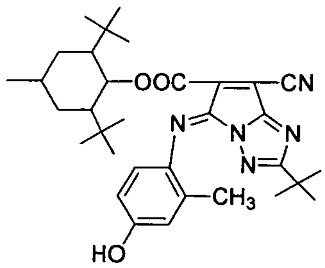

DD-26

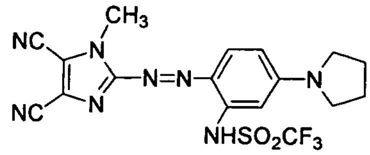

DD-27

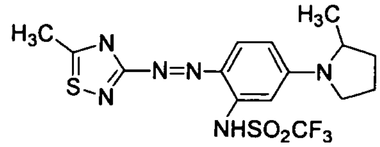

DD-28

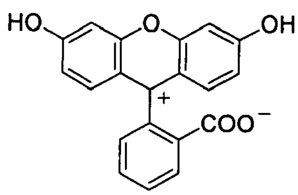

DD-29

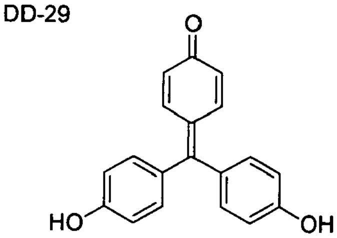

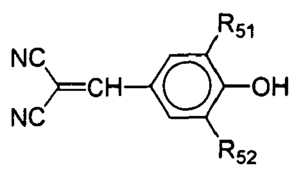

| | $R_{51}$ | $R_{52}$ |
|---|---|---|
| DD-30 | —H | —H |
| DD-31 | —Cl | —H |
| DD-32 | —Cl | —Cl |

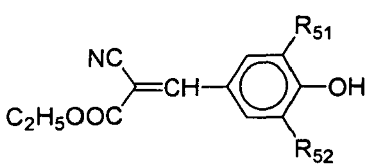

| | $R_{51}$ | $R_{52}$ |
|---|---|---|
| DD-33 | —H | —H |
| DD-34 | —Cl | —H |
| DD-35 | —Cl | —Cl |
| DD-36 | —H | —$OCH_3$ |
| DD-37 | —$CH_3$ | —$CH_3$ |
| DD-38 | —$C_3H_7$-i | —$C_3H_7$-i |

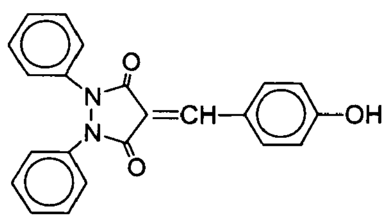

DD-39

(III) Presence of a compound, in which a covalent bond is formed between an organic compound moiety capable of severing the covalent bonding when an electron or energy moves from or moves to the excited state of the sensitizing dye and an organic compound moiety capable of being a colored material when the covalent bonding is severed, and optionally a base;

Particularly preferable examples will be shown below. However, the present invention is not limited to these specific examples. Arrows in the general formulae indicate positions at which a covalent bond is formed.

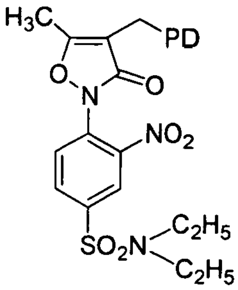

| | PD |
|---|---|
| E-1 | PD-1 |
| E-2 | PD-2 |
| E-3 | PD-22 |
| E-4 | PD-27 |
| E-5 | PD-8 |

| | PD |
|---|---|
| E-6 | PD-10 |
| E-7 | PD-12 |
| E-8 | PD-13 |
| E-9 | PD-16 |
| E-10 | PD-18 |

| | PD |
|---|---|
| E-11 | PD-31 |
| E-12 | PD-33 |
| E-13 | PD-34 |
| E-14 | PD-35 |
| E-15 | PD-36 |

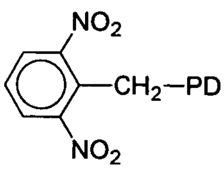

| | PD |
|---|---|
| E-16 | PD-22 |
| E-17 | PD-2 |
| E-18 | PD-27 |
| E-19 | PD-7 |
| E-20 | PD-8 |

| | PD |
|---|---|
| E-21 | PD-11 |
| E-22 | PD-14 |
| E-23 | PD-15 |
| E-24 | PD-17 |
| E-25 | PD-18 |

| | PD |
|---|---|
| E-26 | PD-31 |
| E-27 | PD-34 |
| E-28 | PD-35 |
| E-29 | PD-38 |
| E-30 | PD-41 |

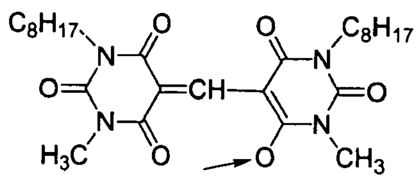

PD-1

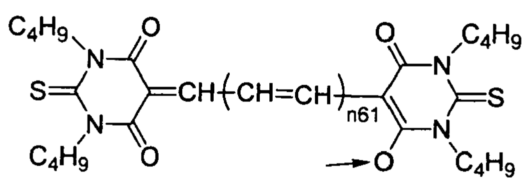

| | n61 |
|---|---|
| PD-2 | 0 |
| PD-3 | 1 |
| PD-4 | 2 |

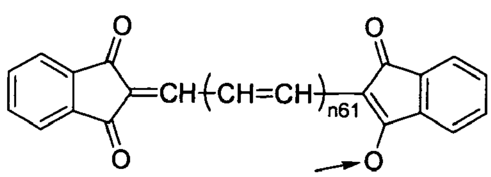

| | n61 |
|---|---|
| PD-5 | 0 |
| PD-6 | 2 |

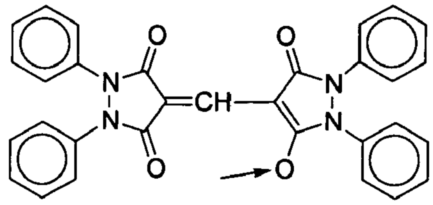

PD-7

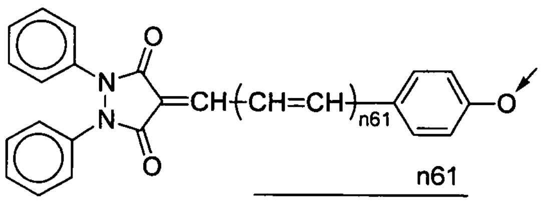

| | n61 |
|---|---|
| PD-8 | 0 |
| PD-9 | 1 |

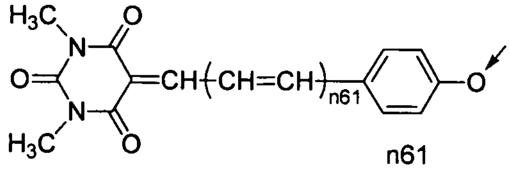

| | n61 |
|---|---|
| PD-10 | 0 |
| PD-11 | 1 |

PD-12

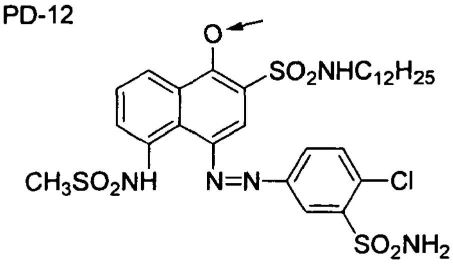

PD-13

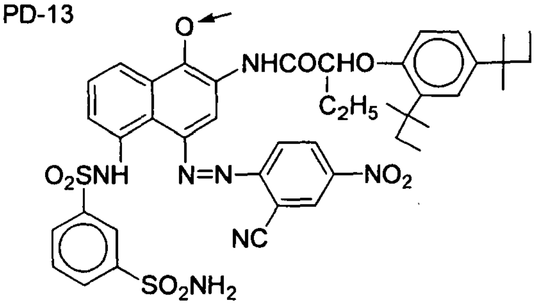

PD-14

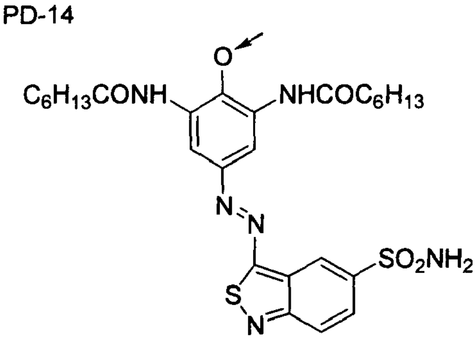

PD-15

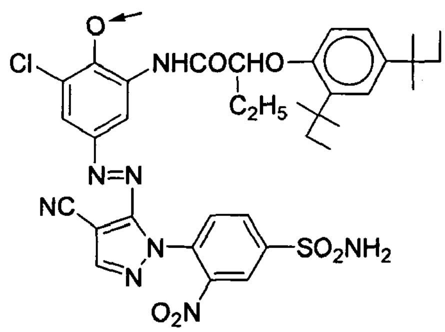

PD-16

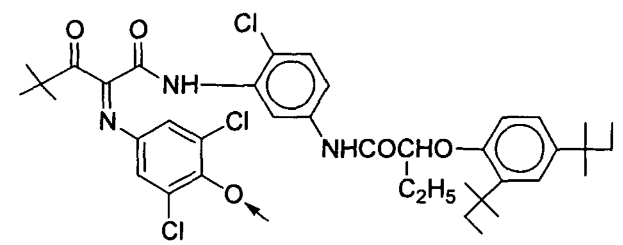

PD-17

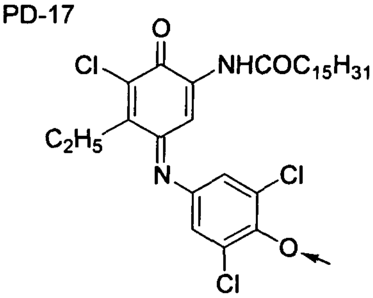

PD-18

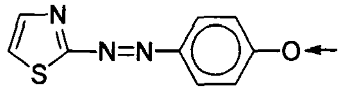

PD-19

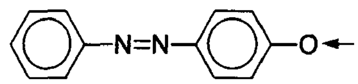

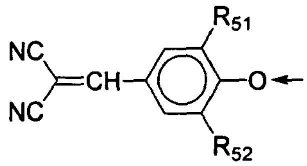

| | $R_{51}$ | $R_{52}$ |
|---|---|---|
| PD-20 | —H | —H |
| PD-21 | —Cl | —H |
| PD-22 | —Cl | —Cl |
| PD-23 | —Cl | $—COOC_2H_5$ |
| PD-24 | —Cl | —CN |

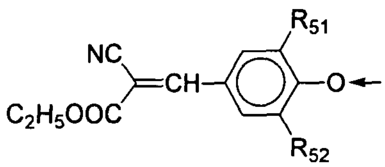

| | $R_{51}$ | $R_{52}$ |
|---|---|---|
| PD-25 | —H | —H |
| PD-26 | —Cl | —H |
| PD-27 | —Cl | —Cl |
| PD-28 | $—OCH_3$ | —H |
| PD-29 | $—CH_3$ | $—CH_3$ |
| PD-30 | $—C_3H_7$-i | $—C_3H_7$-i |

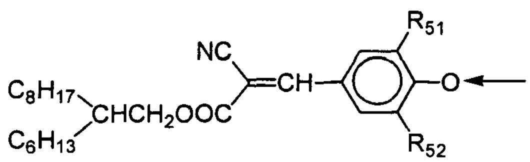

| | $R_{51}$ | $R_{52}$ |
|---|---|---|
| PD-31 | —Cl | —Cl |
| PD-32 | —Br | —Br |
| PD-33 | —I | —I |
| PD-34 | —Cl | —CN |

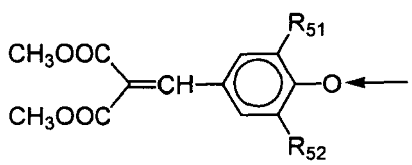

| | $R_{51}$ | $R_{52}$ |
|---|---|---|
| PD-35 | —Cl | —Cl |
| PD-36 | —I | —I |
| PD-37 | —Cl | —CN |

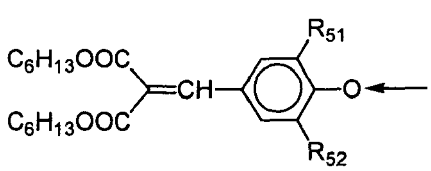

| | $R_{51}$ | $R_{52}$ |
|---|---|---|
| PD-38 | —Cl | —Cl |
| PD-39 | —Br | —Br |
| PD-40 | —I | —I |
| PD-41 | —Cl | —CN |

Preferred examples of the base may include tributylamine, trihexylamine, trioctylamine, N,N-dimethyldodecylamine, tribenzylamine, tetrabenzylethylenediamine, and 4-(dimethylamino)pyridine.

(IV) Presence of a compound capable of reacting and changing its absorption form when an electron moves from or moves to the excited state of the sensitizing dye;

Preferably, a so-called electrochromic compound is used. Preferred examples of the electrochromic compound that may be used in the present invention include polypyrrols (e.g., preferably polypyrrol, poly(N-methylpyrrol), poly(N-methylindole), and polypyrrolopyrrol), polythiophenes (e.g., preferably polythiophene, poly(3-hexylthiophene), polyisothianaphthene, polydithienothiophene, poly(3-hexylthiophene), polyisothioanaphthene, polydithienothiophene, and poly (3,4-ethylenedioxy)thiophene), polyaniline (e.g., preferably polyaniline, poly(N-naphthylaniline), poly(o-phenylenediamine), poly(aniline-m-sulfonic acid), poly(2-methoxyaniline), poly(o-aminophenol), and poly(diallylamine)), poly(N-vinylcarbazole), Co-pyridinoporphyrazine complex, Ni-phenanthroline complex, Fe-basophenanthroline complex, viologens, polyviologens, lanthanoid diphthalocyanines, styryl dyes, TNFs, TCNQ/TTF complexes, and Ru-trisbipyridyl complexes.

Description will be given of a discolorable compound. The discolorable compound used in the present invention may be a compound which shows a reaction such that in the region of ultraviolet light, visible light, and infrared light in the range of wavelengths from 200 to 2,000 nm, either the absorption peak wavelength $\lambda_{max}$ becomes shorter in the absorption spectrum or the molar absorptivity $\varepsilon$ becomes smaller in the absorption spectrum, and more preferably, both reactions occur in the compound. It is preferable that the discoloration reaction occurs in the range of wavelengths from 300 to 600 nm.

If a discoloration reaction proceeds in the optical recording composition, it is preferable that the optical recording composition contains at least one kind of discolorable compound, of which an absorption peak wavelength $\lambda_{max}$ decreases and/or the molar absorptivity $\varepsilon$ decreases from the original state and which can turn out to be a discolored material having no absorption in the wavelength of the hologram-reconstructing beam. The discoloration reaction by the discolorable compound proceeds in accordance with a thermal reaction or photoreaction. In the case of the photoreaction, discoloration may occur by a direct excitation which is induced by light irradiation of the discolorable compound or the discoloration may occur from a discolorable component using electron transfer or energy transfer from the excited state of the sensitizing dye that is created when the sensitizing dye is irradiated with a beam.

Preferred combinations of the discoloration reaction are as follows.

(A) The discolorable compound is a dye having absorption either in the optical recording wavelength or in the wavelength of the fixing beam. The discolorable compound absorbs light when it undergoes the optical recording exposure or the irradiation with the fixing beam, and loses its color.

(B) The optical recording composition contains at least a sensitizing dye having absorption in the optical recording wavelength or in the wavelength of the fixing beam and the discolorable compound of which a molar absorptivity $\varepsilon$ at the wavelength of the hologram-reconstructing beam is not more than 1,000, and preferably not more than 100. The sensitizing dye absorbs light when it undergoes the optical recording exposure or the irradiation with the fixing beam, so that the discolorable compound loses its color due to electron transfer or energy transfer using the excitation energy.

(C) Photoreaction or thermal reaction causes a discolorable agent precursor to generate a discolorable agent, which can discolor or lose the color of the discolorable compound. The discolorable agent occurs from the discolorable agent precursor, for example, due to thermal decomposition of the discolorable agent precursor, photolysis by the light-irradiation of the discolorable agent precursor, or electron transfer or energy transfer from the excited state of the sensitizing dye to the discolorable agent precursor. Preferably, the discolorable agent is any one of a radical, an acid, a base, a nucleophilic agent, an electrophilic agent, and singlet oxygen. Therefore, it is preferable that the discolorable agent precursor is any one of a radical generator, an acid generator, a base generator, a nucleophilic agent generator, an electrophilic agent generator, and triplet oxygen, and more preferably the discolorable agent precursor is a radical generator, an acid generator or a base generator.

If the discoloration reaction proceeds due to the optical recording exposure in the above combination type (A), preferred examples of the discolorable compound include those described above with respect to the sensitizing dye. In this instance, the absorption peak wavelength $\lambda_{max}$ of the discolorable compound is preferably in the range between the wavelength of the recording beam and the wavelength 100 nm shorter than that of the recording beam.

Meanwhile, a discolorable compound having a smaller absorption in the wavelength of the recording beam is used in the case where the discoloration reaction proceeds due to irradiation with the fixing beam in the above combination type (A), and also in the cases of the above combination types (B) and (C). In this instance, the molar absorptivity $\varepsilon$ of the discolorable compound at the wavelength of the recording beam is not more than 1,000, preferably not more than 100, and most preferably 0. The absorption peak wavelength $\lambda_{max}$ of the discolorable compound is preferably in the range between the wavelength of the recording beam and the wavelength 200 nm shorter than that of the recording beam.

In the case of the type (A) where the fixing beam causes discoloration, and in the cases of the types (B) and

(C), preferred examples of the discolorable compound include cyanine dyes, squarilium cyanine dyes, styryl dyes, pyrilium dyes, melocyanine dyes, benzylidene dyes, oxonol dyes, coumarine dyes, pyrane dyes, xanthene dyes, thioxanthene dyes, phenothiazine dyes, phenoxazine dyes, phenazine dyes, phthalocyanine dyes, azaporphyrine dyes, porphyrine dyes, condensed aromatic dyes, perylene dyes, azomethine dyes, azo dyes, anthraquinone dyes, and metal complex dyes. Of these dyes, cyanine dyes, styryl dyes, melocyanine dyes, benzylidene dyes, oxonol dyes, coumarine dyes, xanthene dyes, azomethine dyes, azo dyes, and metal complex dyes are more preferable.

In particular, if the discolorable agent is an acid in the above type (C), it is preferable that the discolorable compound is a dissociation product of dissociative benzylidene dyes, dissociative oxonol dyes, dissociative xanthene dyes or dissociative azo dyes. More preferably, the discolorable compound is a dissociation product of dissociative benzylidene dyes, dissociative oxonol dyes or dissociative azo dyes. The term "dissociative dye(s)" as used herein generically indicates a dye having an active hydrogen with pKa from about 2 to 14, such as -OH group, -SH group, -COOH group, $NHSO_2R$ group, and $-CONHSO_2R$ group, so that deprotonation causes the absorption peak wavelength $\lambda_{max}$ to be longer in the absorption spectrum or the molar absorptivity $\varepsilon$ to be larger in the absorption spectrum. Accordingly, the dissociative dye can be previously treated with a base to provide a dissociated dye. This makes it possible to previously prepare a dye having absorption at longer wavelengths or a dye having a higher molar absorptivity $\varepsilon$, so that a discoloration (to have a shorter wavelength or a lower molar absorptivity $\varepsilon$) can occur when the photoacid generation causes a change to a non-dissociation product.

In the case where the discolorable agent is a base, use of an acid-colorable dye as the discolorable compound makes it possible to lose the color (to have a shorter wavelength or a lower molar absorptivity $\varepsilon$) when the photobase generation causes a change to an unprotonated adduct. For example, the acid-colorable dye may be triphenylmethane dyes, xanthene dyes or fluorane dyes, which have been previously treated with an acid to prepare a colored material.

Specific examples of the discolorable compound used in the present invention will be shown below. However, the present invention is not limited to these specific examples.

G-1

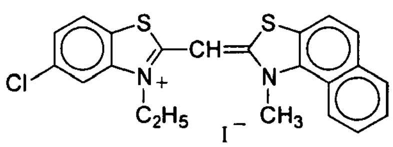

G-2

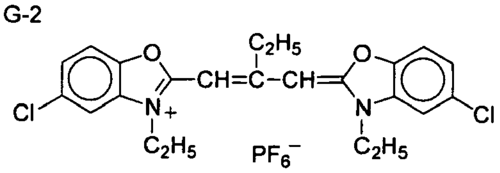

G-3

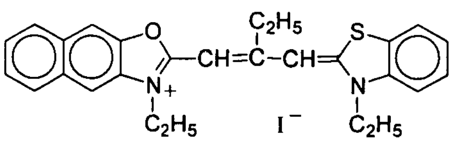

G-4

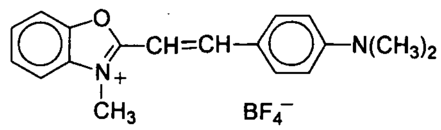

G-5

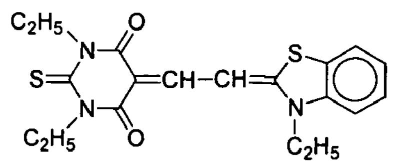

G-6

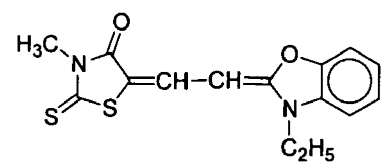

G-7

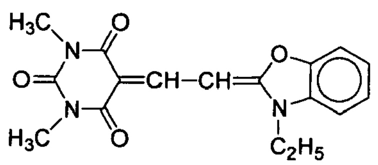

G-8

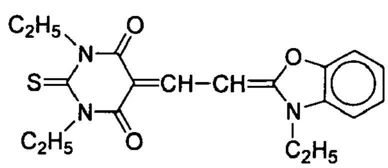

G-9

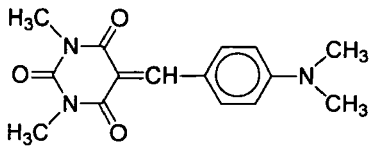

G-10

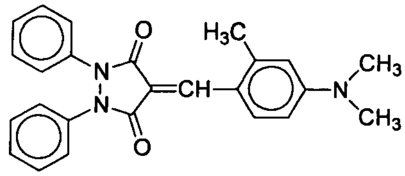

G-11

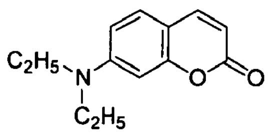

G-12

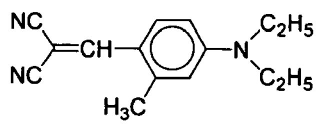

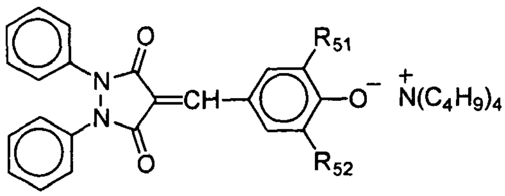

| | $R_{51}$ | $R_{52}$ |
|---|---|---|
| G-13 | —H | —H |
| G-14 | —Cl | —H |
| G-15 | —Cl | —Cl |

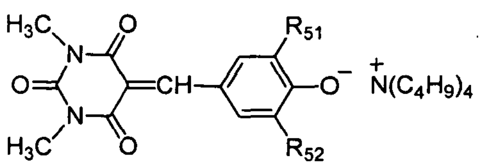

| | $R_{51}$ | $R_{52}$ |
|---|---|---|
| G-16 | —H | —H |
| G-17 | —Cl | —H |
| G-18 | —Cl | —Cl |

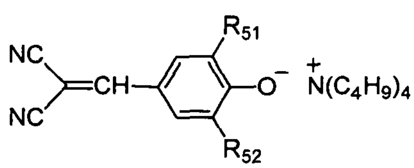

| | $R_{51}$ | $R_{52}$ |
|---|---|---|
| G-19 | —H | —H |
| G-20 | —Cl | —H |
| G-21 | —Cl | —Cl |

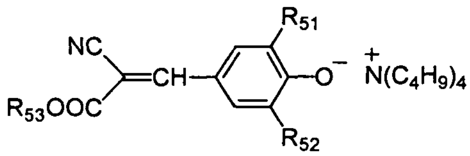

| | $R_{51}$ | $R_{52}$ | $R_{53}$ |
|---|---|---|---|
| G-22 | $-H$ | $-H$ | $-C_2H_5$ |
| G-23 | $-Cl$ | $-Cl$ | " |
| G-24 | $-H$ | $-H$ | $-CH_2CH(CH_3)_2$ |
| G-25 | $-H$ | $-Cl$ | " |
| G-26 | $-Cl$ | $-Cl$ | " |
| G-27 | $-Br$ | $-Br$ | " |
| G-28 | $-I$ | $-I$ | " |
| G-29 | $-Cl$ | $-CN$ | " |
| G-30 | $-H$ | $-H$ | $-CH_2CH(C_6H_{13})(C_8H_{17})$ |
| G-31 | $-H$ | $-Cl$ | " |
| G-32 | $-Cl$ | $-Cl$ | " |
| G-33 | $-CH_3$ | $-CH_3$ | $-CH_2CH(CH_3)_2$ |
| G-34 | $-C_3H_7$-i | $-C_3H_7$-i | " |

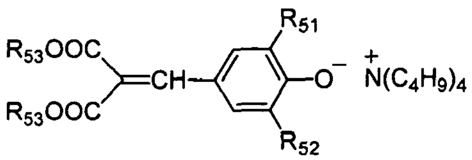

| | $R_{51}$ | $R_{52}$ | $R_{53}$ |
|---|---|---|---|
| G-35 | $-Cl$ | $-Cl$ | $-CH_3$ |
| G-36 | $-H$ | $-Cl$ | $-C_6H_{13}$ |
| G-37 | $-Cl$ | $-Cl$ | " |
| G-38 | $-Br$ | $-Br$ | " |
| G-39 | $-I$ | $-I$ | " |
| G-40 | $-Cl$ | $-Cl$ | $-CH_2CH(C_6H_{13})(C_8H_{17})$ |

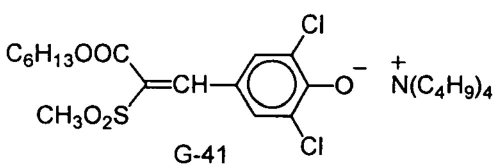

G-41

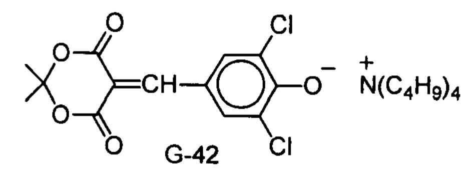

G-42

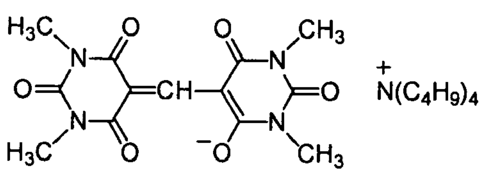

G-43

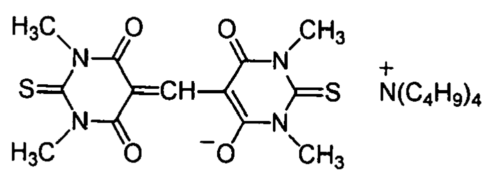

G-44

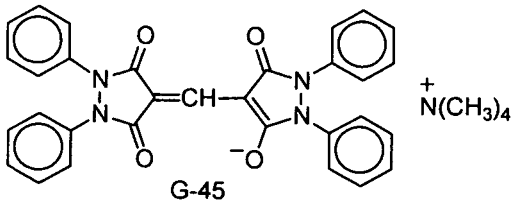

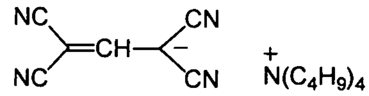

G-45

G-46

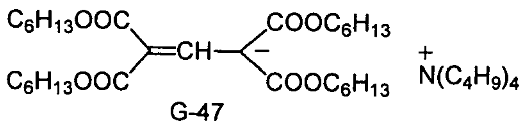

G-47

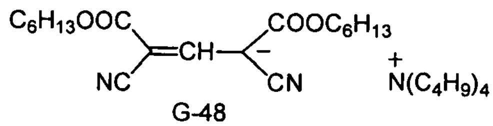

G-48

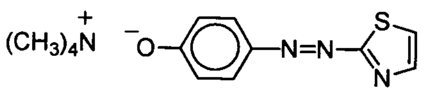

G-49

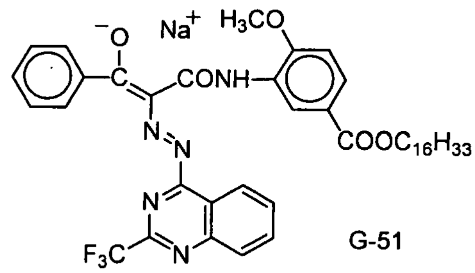

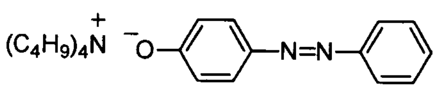

G-50

G-51

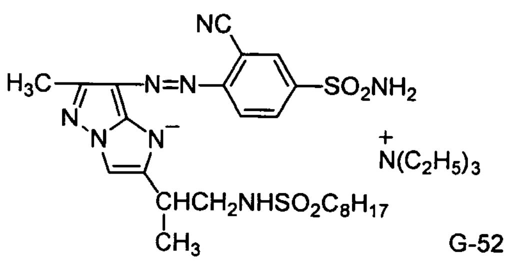

G-52

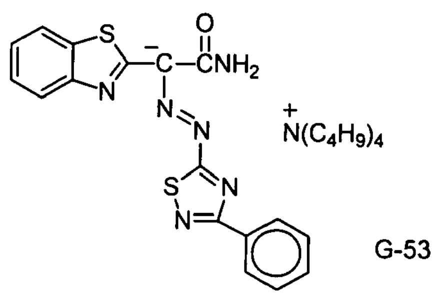

G-53

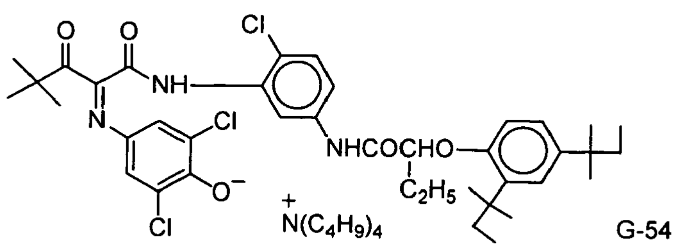

G-54

< Acid-colorable dye; Mainly Base discoloration >

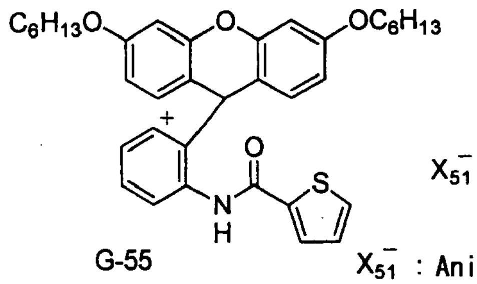

G-55

$X_{51}^-$ : Anion

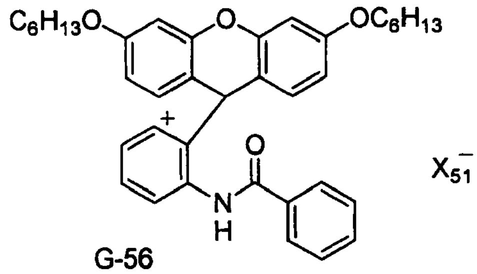

G-56

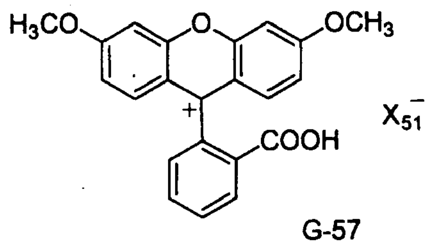

G-57

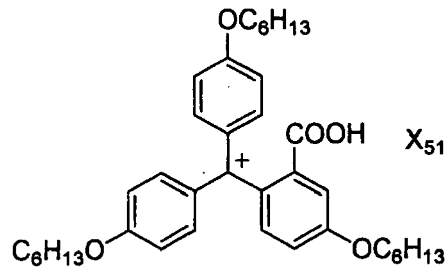

G-58

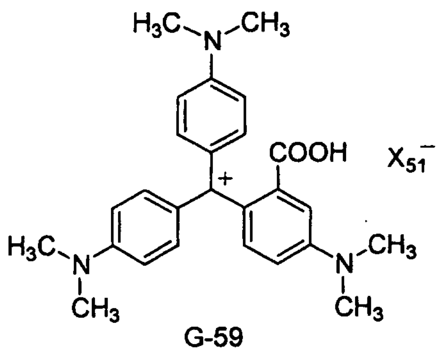

G-59

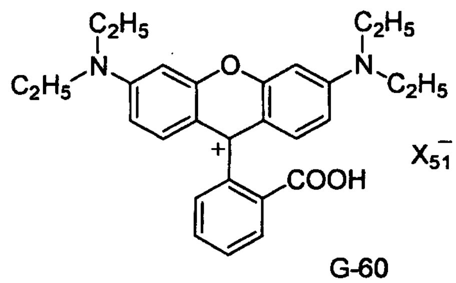

G-60

< Cyanine based acid-colorable dye; Mainly base discoloration >

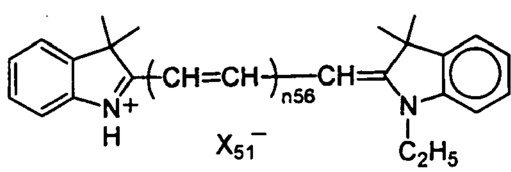

| | $n_{56}$ |
|---|---|
| G-61 | 0 |
| G-62 | 1 |
| G-63 | 2 |

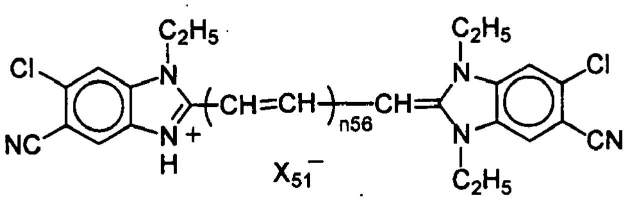

| | $n_{56}$ |
|---|---|
| G-64 | 0 |
| G-65 | 1 |

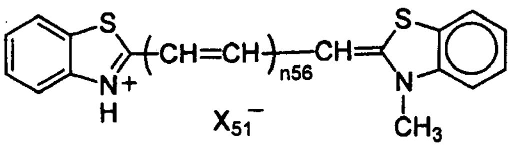

| | $n_{56}$ |
|---|---|
| G-66 | 0 |
| G-67 | 1 |

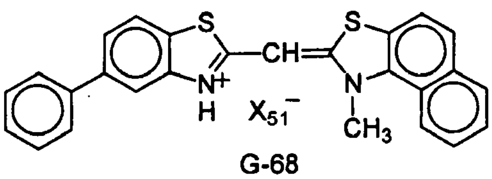

G-68

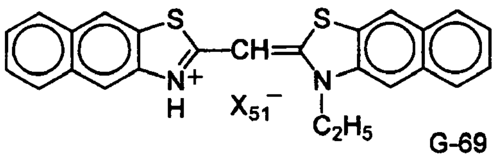

G-69

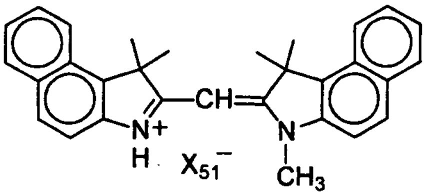

G-70

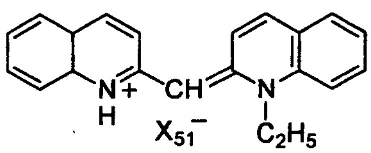

G-71

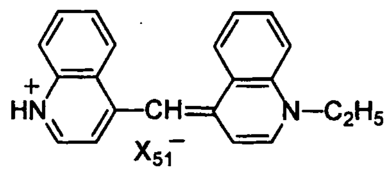

G-72

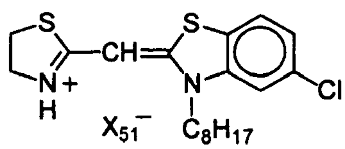

G-73

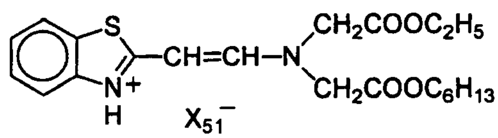

G-74

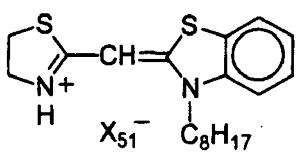

G-75

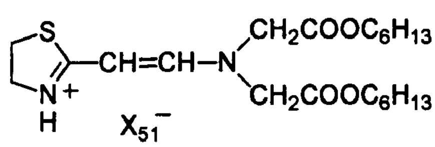

G-76

Preferred examples of the discolorable compound may be the following compounds, which are subject to optical recording exposure or irradiation with a fixing beam to generate the excited state of the sensitizing dye from which an electron moves to sever the bond, resulting in the discoloration of the discolorable compound.

These discolorable compounds are originally cyanine dyes. However, when the bond is severed by the electron transfer, the discolorable compound is changed to a cyanine base (leucocyanine dye), thereby causing the absorption to be eliminated or shifted to a lower wavelength.

< Discoloration due to severance of bond by electron transfer >

$X_{51}^-$ : Anion

| $R_{51}$ | 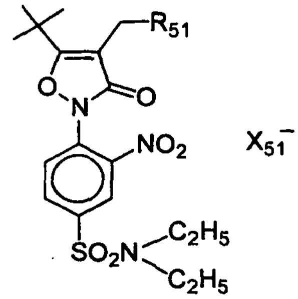 | 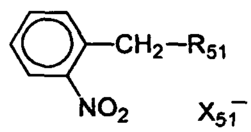 |
|---|---|---|
| GD-1 | G-77 | G-84 |
| GD-2 | G-78 | G-85 |
| GD-3 | G-79 | G-86 |
| GD-4 | G-80 | G-87 |
| GD-5 | G-81 | G-88 |
| GD-6 | G-82 | G-89 |
| GD-7 | G-83 | G-90 |

*: Substituted at this position

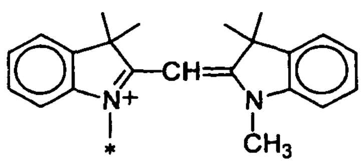

GD-1

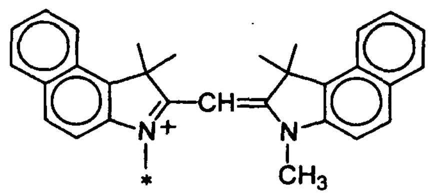

GD-2

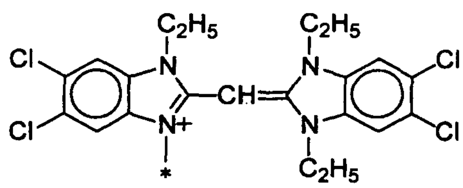

GD-3

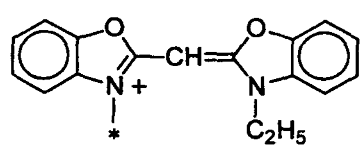

GD-4

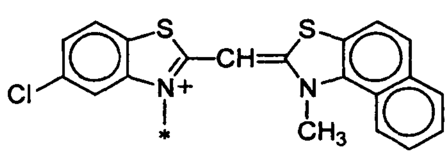

GD-5

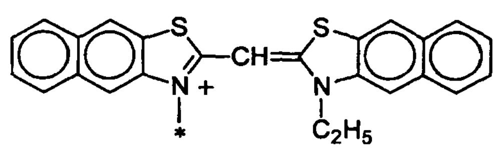

GD-6

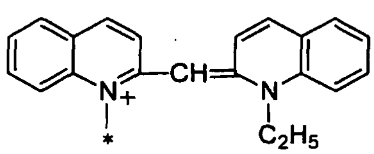

GD-7

In the case where the discolorable agent precursor is an acid-colorable dye, preferred examples are those described above with respect to the acid generating agent. If the discolorable agent precursor is a radical generator, preferred specific examples are those disclosed in Japanese Laid-open Patent Publication No. 2005-115361. If the discolorable agent precursor is a base generator, an anion polymerization initiator is preferable, specific examples of

which are disclosed in Japanese Laid-open Patent Publication No. 2005-17354.

Preferred specific examples of the discoloration reaction are those disclosed in Japanese Laid-open Patent Publication No. 2005-309359.

<Photopolymerization initiator>

The optical recording composition preferably contains a photopolymerization initiator. The photopolymerization initiator may be selected from those sensitive to the recording beam without limitation. For example, a photoradical polymerization initiator and a cation polymerization initiator may be used as the photopolymerization initiator. The photoradical polymerization initiator is preferable in terms of efficiency in polymerization reaction.

Preferred examples of the photoradical polymerization initiator may include, for example, 2,2'-bis(o-chlorophenyl)-4,4',5,5'-tetraphenyl-1,1'-biimidazole, 2,4,6-tris(trichloromethyl)-1,3,5-triazine, 2,4-bis(trichloromethyl)-6-(p-methoxyphenylvinyl)-1,3,5-triazine, diphenyliodoniumtetrafluoroborate, diphenyliodoniumhexafluorophosphate, 4,4'-di-t-butyldiphenyliodoniumtetrafluoroborate, 4-diethylaminophenylbenzenediazoniumhexafluorophosphate, benzoin, 2-hydroxy-2-methyl-1-phenylpropane-2-one, benzophenone, thioxanthone, 2,4,6-trimethylbenzoyldiphenylacyl phosphineoxide, triphenylbutylborate tetraethylammonium, and bis(η5-2,4-cyclopentadiene-1-yl)-bis[2,6-difluoro-3-(1H-pyrrole-1-yl)phenyl titanium]. These may be used alone or in combination of two or more. Further, a sensitizing dye to be described later may be used together taking into consideration the wavelength of the irradiation beam.

Further, preferred examples of the cation polymerization initiator may include, for example, 2,4,6-tris(trichloromethyl)-1,3,5-triazine, 2,4-bis(trichloromethyl)-6-(p-methoxyphenylvinyl)-1,3,5-triazine, diphenyliodoniumtetrafluoroborate, diphenyliodoniumhexafluorophosphate, 4,4'-di-t-butyldiphenyliodoniumtetrafluoroborate, 4-diethylaminophenylbenzenediazoniumhexafluorophosphate, triphenylbutylborate tetraethylammonium, and diphenyl-4-phenylthiophenylsulfoniumhexafluorophosphate.

The content of the photopolymerization initiator within the optical recording composition is preferably in the range of 0.01-5 percent by mass, and more preferably in the range of 1-3 percent by mass.

<Matrix formation component>

The recording layer of the optical recording medium contains a monomer responsible for recording or storage of data, and a polymer for retaining the photopolymerization initiator, which are generally referred to as a matrix. The matrix is employed for the purposes of enhancing coating property, film strength, and hologram recording property. The optical recording composition according to the present invention may contain a curable compound which is a matrix formation component. Examples of the curable compound include a thermosetting compound, and a photo-curable compound which employs a catalyst and is cured by light-irradiation. Of these compounds, the thermosetting compound is more preferable.

The thermosetting matrix contained in the recording layer is not limited to specific compounds, and depending on the purpose an appropriate compound may be selected, for example, from urethane resin formed from an isocyanate compound and an alcohol compound, an epoxy compound formed from an oxirane compound, a melamine compound, a formalin compound, and a polymer obtained by polymerizing an unsaturated acid ester compound such as (meth) acrylic acid and itaconic acid, and an amido compound. Of these compounds, a polyurethane matrix formed from an isocyanate compound and an alcohol compound is preferable, and a three-dimensional polyurethane matrix formed from a polyfunctional isocyanate and a polyfunctional alcohol is most preferable in terms of the recording storage stability.

Specific examples of the polyfunctional isocyanate and the polyfunctional alcohol, which can form the polyurethane matrix, will be shown below.

Specific examples of the polyfunctional isocyanate may include biscyclohexyl methanediisocyanate, hexamethylene diisocyanate, phenylene-1,3-diisocyanate, phenylene-1,4-diisocyanate, 1-methoxyphenylene-2,4-diisocyanate, 1-methylphenylene-2,4-diisocyanate, 2,4-thrylenediisocyanate, 2,6-thrylenediisocyanate, 1,3-xylylenediisocyanate, 1,4-xylylenediisocyanate, biphenylene-4,4'-diisocyanate, 3,3'-dimethoxybiphenylene-4,4'-diisocyanate, 3,3'-dimethylbiphenylene-4,4'-diisocyanate, diphenylmethane-2,4'-diisocyanate, diphenylmethane-4,4'-diisocyanate, 3,3'-dimethoxydiphenylmethane-4,4'-diisocyanate, 3,3'-dimethyldiphenylmethane-4,4'-diisocyanate, naphthylene-1,5-diisocyanate, cyclobutylene-1,3-diisocyanate, cyclopentylene-1,3-diisocyanate, cyclohexylene-1,3-diisocyanate, cyclohexylene-1,4-diisocyanate, 1-methylcyclohexylene-2,4-diisocyanate, 1-methylcyclohexylene-2,6-diisocyanate, 1-isocyanate-3,3,5-trimethyl-5-isocyanatemethylcyclohexane, cyclohexane-1,3-bis(methylisocyanate), cyclohexane-1,4-bis (methylisocyanate), isophoronediisocyanate, dicyclohexylmethane-2,4'-diisocyanate, dicyclohexylmethane-4,4'-diisocyanate, ethylenediisocyanate, tetramethylene-1,4-diisocyanate, hexamethylene-1,6-diisocyanate, dodecamethylene-1,12-diisocyanate, phenyl-1,3,5-triisocyanate, diphenylmethane-2,4,4'-triisocyanate, diphenylmethane-2,5,4'-triisocyanate, triphenylmethane-2,4',4"-triisocyanate, triphenylmethane-4,4',4"-triisocyanate, diphenylmethane-2,4,2',4'-tetraisocyanate, diphenylmethane-2,5,2',5'-tetraisocyanate, cyclohexane-1,3,5-triisocyanate, cyclohexane-1,3,5-tris(methylisocyanate), 3,5-dimethylcyclohexane-1,3,5-tris(methylisocyanate), 1,3,5-trimethylcyclohexane-1,3,5-tris(methylisocyanate), dicyclohexylmethane-2,4,2'-triisocyanate, and dicyclohexylmethane-2,4,4'-triisocyanatelysine diisocyanatemethylester, and also a prepolymer having isocyanates at both ends that can be prepared by a reaction between these organic isocyanate compounds of over stoichiometric quantities and polyfunctional compounds containing an active hydrogen. Of these, biscyclohexyl methanediisocyanate and hexamethylene diisocyanate are most preferable. These may be used alone or in combination of two or more.

The polyfunctional alcohol may be used alone or in combination with other polyfunctional alcohols. Examples of the polyfunctional alcohol may include glycols such as ethylene glycol, triethylene glycol, diethylene glycol, polyethylene glycol, propylene glycol, polypropylene glycol, and neopentyl glycol; diols such as butanediol, pentanediol, hexanediol, heptanediol, and tetramethylene glycol; bisphenols and compounds having these polyfunctional alcohols modified with polyethyleneoxy chains or polypropyleneoxy chains; glycerin, trimethylol propane, triols such as butanetriol, pentanetriol, hexanetriol, and decanetriol, and compounds having these polyfunctional alcohols modified with polyethyleneoxy chains or polypropyleneoxy chains.

The content of the matrix formation component within the optical recording composition is preferably in the range of 10-95 percent by mass, and more preferably in the range of 35-90 percent by mass. If the content is 10 percent by mass or higher, the optical recording composition will yield stable interference images, and if the content is 95 percent by mass or lower, desirable properties will be obtained in terms of diffraction efficiencies.

<Other components>

The optical recording composition may further contain a polymerization inhibitor or an antioxidant where necessary for the purpose of improving the preservation stability of the optical recording composition.

Examples of the polymerization inhibitor or the antioxidant may include hydroquinone, p-benzoquinone, hydroquinone monomethylether, 2,6-di-tert-butyl-p-cresol, 2,2'-methylenebis(4-methyl-6-tert-butylphenol), triphenylphosphite, trisnonyl phenylphosphite, phenothiazine, and N-isopropyl-N'-phenyl-p-phenylene diamine.

The additive amount of the polymerization inhibitor or the antioxidant is preferably not more than 3 percent by mass for the total mass of the recording monomers. If the additive amount exceeds 3 percent by mass, the polymerization speed delays or in some cases polymerization may not occur.

The optical recording composition may contain sensitizing dyes as required. The sensitizing dyes may be conventional compounds described in "Research Disclosure, vol. 200, December 1980, Item 20036" or "Sensitizer, pp. 160-163, Kodansha Ltd., ed. Katsumi Tokumaru and Shin Ohgawara, 1987."

Specific examples of the sensitizing dyes include 3-ketocoumarin compounds described in Japanese Laid-open Patent Publication No. S58-15603; thiopyrylium salts described in Japanese Laid-open Patent Publication No. S58-40302; naphthothiazole merocyanine compounds described in Japanese Patent Publication Nos. S59-28328 and S60-53300; and merocyanine compounds described in Japanese Patent Publication Nos. S61-9621 and S62-3842, and Japanese Laid-open Patent Publication Nos. S59-89303 and S60-60104.

Further, other sensitizing dyes may be used, which are described in "Functional Dye Chemistry, 1981, CMC Publishing Co., pp. 393-416" or "Color Material, 60 (4), 212-224 (1987)". Specific examples of these sensitizing dyes are cationic methine dyes, cationic carbonium dyes, cationic quinonimine dyes, cationic indoline dyes, and cationic styryl dyes.

Furthermore, the sensitizing dyes may include keto dyes such as coumarin dyes (including ketocoumarin and sulfocoumarin), merostyryl dyes, oxonol dyes, and hemioxonol dyes; non-keto dyes such as non-keto polymethine dyes, triarylmethane dyes, xanthen dyes, anthracene dyes, rhodamine dyes, acridine dyes, aniline dyes, and azo dyes; non-keto polymethine dyes such as azomethine dyes, cyanine dyes, carbocyanine dyes, dicarbocyanine dyes, tricarbocyanine dyes, hemicyanine dyes, and styryl dyes; and quinonimine dyes such as azine dyes, oxazin dyes, thiazin dyes, quinoline dyes, and thiazole dyes. The sensitizing dyes may be used alone or in combination of two or more.

The optical recording composition may contain a photothermal conversion material for the purpose of enhancing the sensitivity of the recording layer formed from the optical recording composition.

The photothermal conversion material may be properly selected without limitation depending on the intended performance or capability. For example, organic dyes are preferable considering the properties that they are conveniently added to the recording layer together with the photopolymers and that no incident light scatters. Infrared light absorbing dyes are also preferable considering the property that they do not absorb and scatter the recording beam from the light source.

The infrared light absorbing dyes may be properly selected without limitation depending on the application, and preferable examples thereof include cationic dyes, complex-salt forming dyes, and quinone neutral dyes. The absorption peak wavelength of the infrared light absorbing dyes is preferably in the range of 600-1,000 nm, and most preferably in the range of 700-900 nm.

The content of the infrared light absorbing dye may be determined depending on the absorbance of light having

the wavelength in the infrared region at which the maximum absorbance is shown. The absorbance is preferably in the range of 0.1-2.5, and more preferably in the range of 0.2-2.0.

The optical recording composition may further contain a component that can diffuse into the direction opposite to that of the condensation of the polymerizable component or a compound having an acid cleavage structure, where necessary, in order to reduce the volume change upon polymerization.

The aforementioned optical recording composition is applicable to various holographic recording compositions capable of recording information by means of irradiation with light that includes the information. In particular, the optical recording composition is suitable as a composition for volume holographic recording.

If the optical recording composition has sufficiently low viscosities, the recording layer may be formed by casting. On the other hand, if the viscosity of the optical recording composition is too high to perform casting, the recording layer material is mounted on the lower substrate using a dispenser, followed by pressing and spreading the recording layer entirely with the upper substrate to form a recording medium.

SIGNIFICANCE OF REFRACTIVE INDEX CORRECTION

Significance of the refractive index correction for the above holographic recording medium 10 will be described below.

<Change in Angle of Interference patterns>

With reference to FIG. 2, description will be given of angles of an interference pattern before and after recording information. It should be noted that FIG. 2 is an explanatory view conceptually showing a change in the angle of the interference pattern; however, actually the recording angle of the interference pattern is not always the same as that shown in FIG. 2 and fringes of the interference pattern are not always recorded in this pattern.

The interference pattern S as shown in FIG. 2 has an angle $\phi$ relative to the thickness direction N of the recording layer 12 (i.e., direction orthogonal to the planar direction P of the recording layer 12). Even if the recording layer 12 in which the interference pattern S has been recorded undergoes shrinkage due to the polymerization reaction upon recording and a temperature decrease after recording, shrinkage does not occur in the planar direction P as the recording layer 12 is constrained between the substrates 11, 13. However, since the recording layer 12 is free of such constraint in the thickness direction, the recording layer 12 substantially shrinks only in the thickness direction N as the result. Therefore, the interference pattern S tilts by $\Delta\phi$ and changes into an interference pattern S'. The interference pattern S' has an angle $\phi^*$ relative to the thickness direction N of the recording layer 12.

According to FRP (Fringe Plane Rotation) model, the angle $\phi^*$ is obtained by the following formula.

$$\phi^* = \phi + \Delta\phi = \arctan(\tan\phi/(1-\alpha)) \qquad (2)$$

where $\alpha$ is a shrinkage ratio of the recording layer 12.

Accordingly, the angle of the interference pattern S changes due to shrinkage of the recording layer 12 before and after recording information in the holographic recording medium 10. Using the above formula (2), the shrinkage ratio $\alpha$ of the recording layer 12 can be estimated for an actual sample.

In order to estimate the shrinkage ratio $\alpha$, a general two-beam interference apparatus to be described later is used. An interference pattern with a weak diffraction efficiency up to 1% is created using two plane waves, and the interference pattern is recorded in a sample of the holographic recording medium 10 at a predetermined angle $\phi$. Thereafter, the recording medium is fixed such that the photoreactive component of the holographic recording medium 10 is completely consumed. The diffraction efficiency relative to the readout angle is then measured, and the angle of the interference pattern S is measured again. The shrinkage ratio $\alpha$ of the recording layer 12 can be estimated from the above formula (2) based on a change in the tilt angle of the interference pattern between the times during the recording and after the fixation.

<Two-beam interference exposure apparatus>

A two-beam interference exposure apparatus as shown in FIG. 3 can measure an influence on the output of the reconstructed signal due to a change in angle of the interference patterns.

As seen in FIG. 3, the two-beam interference exposure apparatus 50 comprises a laser exposure device L, a neutral density (ND) filter 51, a spatial filter 52, a beam expander 53, a half-wave plate 54 (54a, 54b), a shutter 55, a

polarization beam splitter 56, a mirror 57 (57a, 57b), a sample holder 58, and a power meter PM.

The laser exposure device L may be a second harmonic generation (SHG) laser of which a laser oscillating wavelength is 532 nm. In this two-beam interference exposure apparatus 50, a beam emitted from the laser exposure device L is adjusted at the ND filter 51 to optimize the quantity of light, and thereafter passes through a pinhole of the spatial filter 52 at which noise is removed from the beam. The obtained beam passes through the beam expander 53 at which the narrow beam is expanded into a beam having a diameter of 6 mm. The beam then passes through the half-wave plate 54a at which the angle of the linear polarized light is adjusted, and goes into the polarization beam splitter 56 at which the beam is split into two beams. At this stage, the half-wave plate 54a adjusts the beam such that the two split beams will have the same intensity. One of the beams split by the polarization beam splitter 56 passes through the half-wave plate 54b at which the direction of the polarized light is adjusted to have the same direction as that of the other split beam. Each of the split beams is reflected by the mirror 57 (57a, 57b) so that the recording layer of a sample holographic recording medium 59 is irradiated with these split beams on the sample holder 58 for rotatably supporting the sample medium 59.

When the output of a reconstructed signal beam produced at the recorded interference pattern should be measured, the interference pattern is irradiated with a split beam (corresponding to a readout beam) that has been split by the polarization beam splitter 56 to generate the reconstructed signal beam. The intensity of the reconstructed signal beam is measured with the optical power meter PM. The sample holder 58 is rotatable so that changing the angle of the sample 59 causes a change in the intensity of the obtained reconstructed signal beam.

FIG. 4 is a graph showing a change in angle of the interference pattern resulting from a volumetric shrinkage of 0.1 % in the recording layer that is generally regarded as a preferable criterion. The horizontal axis of the graph indicates angle (sample angle $\theta$) of the sample holder as shown in FIG. 3, by which angle the interference pattern has been recorded in the sample. It is assumed that the sample angle $\theta$ measured when the incident angle of the signal beam is equal to the incident angle of the reference beam is 0 degree. The vertical axis of the graph indicates Bragg detuning that is the shift amount of Bragg angle (i.e., shift in the readout angle). Bragg angle indicates an angle which satisfies diffraction conditions. Herein, Bragg detuning indicates that supposing the shrinkage ratio is 0.1%, in what shift angle between the readout beam and the reference beam the reconstructed signal beam has the maximum output. The caption of each line indicates the relation between the crossing angle $\theta_{AIR}$ and the shrinkage ratio $\alpha$. The crossing angle is defined by a half of the angle between the signal beam and the reference beam as shown in FIG. 3. For instance, the caption "5 degrees-0.1%" indicates that the crossing angle $\theta_{AIR}$ is 5 degrees and the shrinkage ratio $\alpha$ is 0.1%.

As seen in FIG. 4, in any of the crossing angle conditions, when the sample angle $\theta$ is 0 degree, Bragg detuning also indicates 0 degree. This means that if the sample angle $\theta$ is 0 degree, the signal beam and the reference beam go into the recording layer 12 at a symmetrical angle to the normal of the recording layer 12 (see the thickness direction N of FIG. 2) so that the interference pattern S is formed in a direction along the thickness direction N of the recording layer 12. Therefore, even if the thickness of the recording layer 12 changes due to shrinkage, the angle and the interval of the interference pattern S remain unchanged.

In any of the crossing angle conditions, the greater the sample angle $\theta$ at the time of recording, the greater angle difference Bragg detuning indicates. In the meantime, a shrinkage ratio of 0.1 % is generally considered as a preferable criterion, and as seen in FIG. 4, Bragg detuning of approximately $\pm$0.04 degrees can be considered acceptable for practical use.

It should be noted that Bragg detuning of FIG. 4 is shown on the premise that a change in the average refractive index does not occur before and after irradiation of the recording layer 12 with a beam. In other words, unless correction that is proposed according to the present invention is made for changing the average refractive index, the shift amount of Bragg angle as plotted in the graph will occur when the shrinkage ratio is 0.1%.

A decrease in the diffraction efficiency due to a shift in the incident angle of the readout beam can be calculated using Kogelnik's coupled wave theory. FIG. 5 is a graph showing a relation between shift amount of the sample angle and diffraction efficiency for each crossing angle. In this graph, the horizontal axis indicates sample angle $\theta$, and the vertical axis indicates normalized diffraction efficiency. The caption of each line indicates the crossing angle $\theta_{AIR}$.

As seen in FIG. 5, when the interference pattern recorded at crossing angles $\theta_{AIR}$ from 5 to 45 degrees is irradiated with the readout beam at a shift angle corresponding to the magnitude of the sample angle $\theta$ plotted in the horizontal axis, the diffraction efficiency will gradually lower. For instance, in the case where the crossing angle $\theta_{AIR}$ is 45 degrees, it is shown that the diffraction efficiency lowers by 50% when the readout beam goes into the interference pattern at a shift angle of 0.04 degrees. Intervals of fringes of an interference pattern formed at the time of recording are different dependent on the crossing angle $\theta_{AIR}$ between the signal beam and the reference beam. Fringes of the interference pattern have wider intervals when the crossing angle $\theta_{AIR}$ is 5 degrees, whereas narrower intervals when the crossing angle $\theta_{AIR}$ is 45 degrees. The greater the crossing angle $\theta_{AIR}$ such as in the case of 45 degrees, the more significantly the shift angle of the readout beam influences on the diffraction efficiency.

It should be noted that the graph of FIG. 5 shows the calculation results supposing that the recording layer 12 is free of shrinkage before and after recording and the average refractive index does not change through irradiation with

a beam.

<Range of Optical compensation rate C>

In consideration of the relation between shrinkage of the recording layer 12 (i.e., shift angle of the readout beam) and the diffraction efficiency, a preferable range of the optical compensation rate C defined by $C=(1-(n2/n1))/\alpha$ is shown in FIG. 6. FIG. 6 is a graph showing relations between shrinkage ratio and optical compensation rate for particular crossing angles $\theta_{AIR}$ when an optimal compensation (for keeping a shift angle within a range equal to or less than $\alpha$=0.1%) is carried out for the recording layer recorded with the recording condition of the sample angle being $\pm$40 degrees. For instance, in the case where the crossing angle $\theta_{AIR}$ is 5 degrees, an optical compensation rate of 0.95 is obtained when the optical compensation rate is calculated such that Bragg detuning becomes 0 at a shrinkage ratio $\alpha$ of 0.5%. With reference to FIG. 6, in the case where the crossing angle $\theta_{AIR}$ is 5 degrees, the optical compensation rate takes a value of approximately 0.95 irrespective of the shrinkage ratio $\alpha$. This means that if a rate of change of the average refractive index is substantially equally to the thickness changing rate before and after shrinkage of the recording layer, an optical compensation can be made.

As best seen in FIG. 6, it is understood that in a practical range of crossing angles from 5 to 45 degrees, when the optical compensation rate C satisfies $0.8 \leq C \leq 1.0$, an excellent optical compensation can be performed substantially irrespective of the crossing angle $\theta_{AIR}$.

HOLOGRAPHIC RECORDING APPARATUS

A holographic recording apparatus according to one preferred embodiment of the invention splits a recording beam emitted from a recording beam source into a signal beam and a reference beam, and focuses these beams in the holographic recording medium. The holographic recording apparatus may have a similar configuration to the two-beam interference exposure apparatus as shown in FIG. 3. To be more specific, as seen in FIG. 7, a holographic recording apparatus 60 comprises a spatial light modulation element 61 and a refractive index control beam source 62 in addition to the components of the two-beam interference exposure apparatus of FIG. 3, and further comprises a data readout device 63 and a basement 64 in place of the power meter PM and the sample holder 58.

The spatial light modulator 61 is used to imprint information into a section of the signal beam (i.e., the beam passing straight through the polarization beam splitter 56). The spatial light modulator 61 displays information to be recorded on a planar array consisting of thousands of pixels each of which functions as an independent microscopic shutter, and transmits the beam through the array of pixels so that the beam is partly blocked by the pixels to thereby imprint information into the section of the beam.

The refractive index control beam source 62 is a beam source configured to emit a beam for developing or losing color of a separate compound that is contained in the holographic recording medium 10 and different from the polymerizable monomer. The wavelength of the refractive index control beam source 62 is different from that of the laser exposure device L. The control beam source 62 emits a beam after recording information in the holographic recording medium 10 under control of a controller (not shown) or by manipulation of the operator.

The data readout device 63 includes optical readout elements such as CCDs arranged in a matrix manner. The date readout device 63 may be a conventionally known device for reading a pixilated data array included in the cross-section of the reconstructed signal beam.

The basement 64 supports the holographic recording medium 10. For changing the recording position of the medium 10, the basement 64 is rotatable or movable along a plane of the holographic recording medium 10. This makes it possible to record information in the entire surface of the medium 10. The basement 64 may be configured as a rotary stage.

According to this holographic recording apparatus 60, after recording information in the recording layer 12, the refractive index control beam source 62 irradiates the recording layer 12 of the holographic recording medium 10 with a beam to lower the average refractive index of the recording layer 12. This can compensate an optical shift resulting from shrinkage of the recording layer 12.

With reference to FIG. 8, a holographic recording apparatus according to a second embodiment of the invention will be described.

As seen in FIG. 8, a holographic recording apparatus 70 mainly comprises a laser beam source 71, a mirror 72, a DMD (Digital Micro-mirror Device) chip 73, object lenses 74a, 74b, a data readout device 75, a basement 76, a refractive index control beam source 77, and a controller 78.

The laser beam source 71 is a beam source for emitting a coherent beam. The laser beam source 71 is arranged to direct the beam to the mirror 72.

The mirror 72 is arranged in such a position to reflect the beam from the laser beam source 71 toward the DMD chip 73.

The DMD chip 73 includes a plurality of tiny mirrors 73a arranged in a matrix manner, and a plurality of adjusting devices 73b each of which adjusts or changes the angle of each mirror 73a. The DMD chip 33 generates a signal beam and a reference beam by means of reflecting the beam from the mirror 72 using the mirrors 73a. To be more specific, part of the mirrors 73a arranged around the outer periphery of the DMD chip 33 are directed to the object lens 74a with a predetermined pattern so that a ring-shaped beam reflected by these mirrors 73a is used as a reference beam. Meanwhile, directions of the mirrors 73a arranged inside these peripherally-arranged mirrors 73a are appropriately adjusted based on data input from the controller 78 such that some of the mirrors 73a are directed to the object lens 74a and the others to other directions. The beam reflected by these mirrors 73 a which are adjusted at random directions inside the peripherally-arranged mirrors 73a is used as a signal beam. In this manner, the DMD chip 33 imprints optical information in a matrix manner into the cross-section of the signal beam.

The object lens 74a collects the reference beam and the signal beam from the DMD chip 73 and causes these beams to interfere with each other in the recording layer 12 of the holographic recording medium 10.

The data readout device 75 is substantially the same as the data readout device 63 of the holographic recording apparatus 60.

The basement 76 supports the holographic recording medium 10. For changing the recording position of the medium 10, the basement 76 is movable relative to the incident beam (the reference beam and the signal beam incident into the holographic recording medium 10) in a direction orthogonal to the optical axis of the incident beam. This makes it possible to record information in the entire surface of the medium 10. The basement 76 may be configured as a rotary stage.

The refractive index control beam source 77 is substantially the same as the refractive index control beam source 62. The refractive index control beam source 77 is arranged in such a position to emit a beam directed to the holographic recording medium 10.

The controller 78 digitally controls the laser beam source 71, the DMD chip 73, and the basement 76.

The controller 78 is connected to an instruction device for instructing the holographic recording apparatus 70 to record information in the holographic recording medium 10 or to read out information from the medium 10, such as a computer terminal and an image recorder. Information is input from the instruction device to the controller 78 when the information is to be recorded in the medium 10, and readout and reconstructed information is output to the instruction device when the information is readout from the medium 10.

Upon recording information, the controller 78 adjusts the angle of each mirror 73a of the DMD chip 73 in accordance with information to be recorded, and controls the laser beam source 71 to generate and emit a signal beam and a reference beam. The controller 78 also drives the basement 76 for recording a recording spot (interference pattern) in an appropriate position of the holographic recording medium 10. When the holographic recording is completed, the controller 78 actuates the refractive index control beam source 77, so that the recording layer 12 is irradiated with a beam from the control beam source 77. As a result, the average refractive index of the recording layer 12 will be lowered.

When the information is read out from the holographic recording medium 10, the controller 78 controls the mirrors 73a of the DMD chip 73 arranged in a region corresponding to the signal beam such that the beam reflected therefrom is not directed to the object lens 74a, and the mirrors 73a arranged in a region corresponding to the reference beam such that they are directed to the object lens 74a in the same pattern as that used at the time of recording. Therefore, the holographic recording medium 10 is irradiated only with a readout beam (reference beam). In order to read a particular recording spot (interference pattern) of the holographic recording medium 10, the basement 76 is moved so that the recording spot is irradiated with the readout beam to thereby obtain a reconstructed signal beam. The data readout device 75 then receives the incident reconstructed signal beam, and outputs the same to the instruction device through the controller 76.

According to this holographic recording apparatus 70, after recording of information in the holographic recording medium 10, the refractive index control beam source 77 irradiates the recording layer 12 of the medium 10 with a beam to lower the average refractive index of the recording layer 12. This can compensate an optical shift resulting from shrinkage of the recording layer 12.

Although the present invention has been described in detail with reference to the above preferred embodiments, it is to be understood that the present invention is not limited to these specific embodiments and various changes and modifications may be made without departing from the scope of the appended claims. For example, in the above holographic recording apparatuses 60, 70, another beam having a wavelength different from that of the hologram-recording beam is used to lower the average refractive index of the recording layer 12. However, the average refractive index may be lowered using the hologram-recording beam. To be more specific, the optical recording composition used for the recording layer 12 may contain a compound of which an average refractive index is lowered by irradiation with the hologram-recording beam.

Examples will be shown below for proving the effects of the present invention. The significance of the present invention will be better understood by referring to the following examples.

EXAMPLES

The following examples show cases where the average refractive index of the recording layer lowers by polymerization of the polymerizable monomer. By using a specific recording material (cf. Examples 1 and 2) to be described later, it is confirmed that a change in Bragg angle becomes smaller at the time of readout even if shrinkage is caused after holographic recording.

<Preparation of Application liquid used for Recording layer>

The composition for the recording layer was prepared from Solution A and Solution B as below. The preparation was made in a glove box into which dry nitrogen was introduced. The dry nitrogen was prepared by removing moisture from nitrogen gas using a small-sized air drier (Product name: EFA5-100-A manufactured by IAC. Co., Ltd.) and adjusting a relative humidity at 25 ˚C to be less than 20%. Tools and receptacles were sufficiently dried before their use.

Example 1

| | |
|---|---|
| (A) Solution A contains: | |
| DM-55 (dye having a polymerizable group) | 1.30 g |
| Bis(cyclopentadienyl)-bis(2,6-difluoro-3-(pyrr-1-yl)phenyl)titanium *1 | 0.25 g |

*1 IRGACURE ™ 784 manufactured by Ciba Specialty Chemicals

| | |
|---|---|
| Hexamethylene diisocyanate *2 | 5.9 g |

*2 Takenate ™ T-700 manufactured by Mitsui Chemicals Polyurethanes, Inc.

| | |
|---|---|
| (B) Solution B contains: | |
| PO-modified triol derived from glycerin *3 | 8.08 g |

*3 MN-300 ™ manufactured by Mitsui Chemicals Polyurethanes, Inc.

| | |
|---|---|
| Polyethylene glycol *4 | 7.16 g |

*4 Manufactured by Tokyo Chemical Industry Co., Ltd.

| | |
|---|---|
| Curing agent *5 | 0.30 g |

*5 U-CAT ™ SA102 manufactured by San-Apro Limited.

Example 2

| | |
|---|---|
| (A) Solution A contains: | |
| DM-55 (dye having a polymerizable group) | 1.73 g |

(continued)

(A) Solution A contains:

| | |
|---|---|
| Bis(cyclopentadienyl)-bis(2,6-difluoro-3-(pyrr-1-yl)phenyl)titanium *1 | 0.25 g |

*1 IRGACURE™ 784 manufactured by Ciba Specialty Chemicals

| | |
|---|---|
| Hexamethylene diisocyanate *2 | 5.9 g |

*2 Takenate ™ T-700 manufactured by Mitsui Chemicals Polyurethanes, Inc.

(B) Solution B contains:

| | |
|---|---|
| PO-modified triol derived from glycerin *3 | 8.08 g |

*3 MN-300 ™ manufactured by Mitsui Chemicals Polyurethanes, Inc.

| | |
|---|---|
| Polyethylene glycol *4 | 7.16 g |

*4 Manufactured by Tokyo Chemical Industry Co., Ltd.

| | |
|---|---|
| Curing agent *5 | 0.30 g |

*5 U-CAT ™ SA102 manufactured by San-Apro Limited.

Comparative prior art example

(A) Solution A contains:

| | |
|---|---|
| EO-modified acrylate derived from 9,9'-biphenyl fluorene *6 | 1.73 g |

*6 Ogsol ™ EA0200 manufactured by Osaka Gas Chemicals Co., Ltd.

| | |
|---|---|
| Bis(cyclopentadienyl)-bis(2,6-difluoro-3-(pyrr-1-yl)phenyl)titanium *1 | 0.25 g |

*1 IRGACURE ™ 784 manufactured by Ciba Specialty Chemicals

| | |
|---|---|
| Hexamethylene diisocyanate *2 | 5.9 g |

*2 Takenate ™ T-700 manufactured by Mitsui Chemicals Polyurethanes, Inc.

(B) Solution B contains:

| | |
|---|---|
| PO-modified triol derived from glycerin *3 | 8.08 g |

*3 MN-300 ™ manufactured by Mitsui Chemicals Polyurethanes, Inc.

| | |
|---|---|
| Polyethylene glycol *4 | 7.16 g |
| *4 Manufactured by Tokyo Chemical Industry Co., Ltd. | |

| | |
|---|---|
| Curing agent *5 | 0.30 g |
| *5 U-CAT ™ SA102 manufactured by San-Apro Limited. | |

<Formation of Recording layer>

Solution A and Solution B as prepared above were mixed together to provide a mixed solution. To be more specific, Solution A of 7.88 g and Solution B of 9.36 g were mixed. A spacer was disposed between two glass substrates, which had been sufficiently dried in advance to remove moisture from the surfaces thereof, so as to form a rectangular cell having an air gap of 300 μm thickness. The mixed solution was then poured into this air gap of the rectangular cell, and heated at 80 °C for 6 hours using an oven. The mixed solution was heat set so that a holographic recording medium was obtained. As with the preparation of Solutions A and B, processes from the mixture of the solutions to the pouring of the mixed solution into the rectangular cell were made in a glove box into which dry nitrogen was introduced.

<Recording of Interference patterns>

Recording of interference patterns was carried out using the two-beam interference exposure apparatus 50 of FIG. 3. Fifteen (15) interference patterns were multiply-recorded at every 4.5 degrees using the two-beam interference exposure apparatus 50 under conditions in which the wavelength of the laser beam source was 532 nm, $\theta_{AIR}$ was 15 degrees, and the sample angle θ was in the range from -31.5 to +31.5 degrees. Thereafter, a fixing process was carried out using a Xenon lamp in order to completely consume the recording material in the recording layer.

<Measurement of Bragg detuning>

For the sample holographic recording medium obtained after completion of the fixing process, a measurement was made for a shift amount between the angle of the reference beam with respect to the sample at the time of recording and the angle of the readout beam with respect to the sample for maximizing the output of the reconstructed signal beam at the time of readout. In order to reduce the influence on the consumption of the recording material upon holographic recording, the exposure intensity was adjusted such that the consumption of the recording material's dynamic range (M/#) for the fifteen (15) multiple recording becomes less than 5%.

In this assessment, since a change in the thickness of the recording layer and a change in the average refractive index have an influence on the result of the shift angle, the thickness of the recording layer was separately measured with Michelson interferometer. In Examples 1 and 2, the shrinkage ratio α and the optical compensation rate C were as follows.

(1) Example 1

Shrinkage ratio α: 0.6%

Optical compensation rate C: 0.95

(2) Example 2

Shrinkage ratio α: 1.0%

Optical compensation rate C: 0.97

FIG. 9 is a graph showing relations between sample angle and Bragg detuning for Examples 1 and 2. In this graph, other than values in Examples 1 and 2, calculated values are plotted for the cases where no change was occurred in the average refractive index at the shrinkage ratio α of 0.6% and 1.0%, respectively.

In the cases where the shrinkage ratio α is 0.6% and 1.0%, Bragg detuning ranges from -0.35 to +0.24 degrees, and from -0.6 to +0.38 degrees, respectively. However, Examples 1 and 2 show that the optical compensation effects

caused by decreased average refractive index after recording can restrict the range of Bragg detuning from -0.02 to +0.03 degrees.

<Shrinkage compensation in the process of recording>

The shrinkage compensation by the change of the average refractive index in the recording layer was confirmed for Examples 1 and 2 with the progress of recording.

Recording of interference patterns was carried out using the two-beam interference exposure apparatus 50 of FIG. 3. Sixty-one (61) holograms were recorded at every 1.092 degrees (step angle) using the two-beam interference exposure apparatus 50 under conditions in which the wavelength was 532 nm, $\theta_{AIR}$ was 15 degrees, and the sample angle $\theta$ at the time of recording was in the range from -32.76 to +32.76 degrees. The integrated exposure energy required for recording the sixty one holograms was 15,000 mJ/cm$^2$ for Examples 1 and 2, respectively, and the material in the recording layer were mostly consumed. FIG. 10 is a graph showing relations between sample angle and Bragg detuning for Examples 1 and 2.

According to the prior art example, shift amounts of Bragg angle are almost consistent with the curved line showing the shrinkage ratio $\alpha$ being 0.72% (i.e., curved line showing calculated values) at an initial stage in the range from -32.76 to -15.00 degrees. However, at the middle stage to the end of the recording process, shift amounts of Bragg angle become smaller than the theoretical values. This is because the material is gradually consumed as the polymerization reaction for recording proceeds, so that the shrinkage rate changes in accordance with the progress of recording.

Meanwhile, Examples 1 and 2 show that the shift amounts of Bragg angle are uniformly corrected entirely from the initial stage of the recording (-32.76 degrees) to the end of the recording process (+32.76 degrees). Therefore, even if the shrinkage of the recorded interference patterns varies for each of the interference patterns, the correction can be better performed. In other words, parameters, such as wavelength, angle, and temperature, required for correction of the shift angle at the time of readout can be set uniformly for all the interference patterns.

## Claims

1. A holographic recording medium comprising at least two substrates, and a recording layer provided between the substrates,
wherein the recording layer has a property such that an average refractive index lowers as irradiation with a beam proceeds, and
wherein in the recording layer an optical compensation rate C that is defined by $C=(1-(n2/n1))/\alpha$ satisfies $0.8 \leq C \leq 1.0$ where $\alpha$ is a rate of thickness change of the recording layer before and after recording, n1 is an average refractive index before recording, and n2 is an average refractive index after recording.

2. A holographic recording medium according to claim 1, wherein the recording layer contains at least one kind of dye having a polymerizable group.

3. A holographic recording medium according to claim 2, wherein the dye having a polymerizable group is such that an absorption peak wavelength $\lambda_{max}$ thereof is shorter by 10-200 nm than a wavelength of a hologram-reconstructing beam, that a molar absorptivity $\varepsilon$ at the absorption peak wavelength $\lambda_{max}$ is not smaller than 10,000, and that a molar absorptivity $\varepsilon$ at the wavelength of the hologram-reconstructing beam is not more than 100.

4. A holographic recording medium according to claim 1, wherein the recording layer comprises a compound of which an absorption spectrum changes through irradiation with a beam.

5. A holographic recording medium according to any one of claims 1 to 4, wherein the beam for lowering the average refractive index is different from a hologram-recording beam.

6. A holographic recording medium according to any one of claims 1 to 4, wherein the beam for lowering the average refractive index is a hologram-recording beam.

7. A holographic recording apparatus which records information in a holographic recording medium of any one of claims 1 to 5, the apparatus comprising:

   a recording beam source configured to generate a laser beam;
   a device configured to create a signal beam and a reference beam from the laser beam, the signal beam being

created from part of the laser beam by imprinting information into a section of the part of the laser beam, and the reference beam being created from the rest of the laser beam;
an optical system configured to focus the signal beam and the reference beam in the recording layer of the holographic recording medium; and
a refractive index control beam source configured to emit a light for lowering the average refractive index of the recording layer, a wavelength of the light being different from that of the laser beam generated at the recording beam source.

**8.** A holographic recording apparatus which records information in a holographic recording medium of any one of claims 1 to 5, the apparatus comprising:

a recording beam source configured to generate a laser beam;
an optical system configured to divide the laser beam into a signal beam and a reference beam and to focus the signal beam and the reference beam in the recording layer of the holographic recording medium;
a device configured to imprint information into the signal beam; and
a refractive index control beam source configured to emit a light for lowering the average refractive index of the recording layer, a wavelength of the light being different from that of the laser beam generated at the recording beam source.

FIG. 1

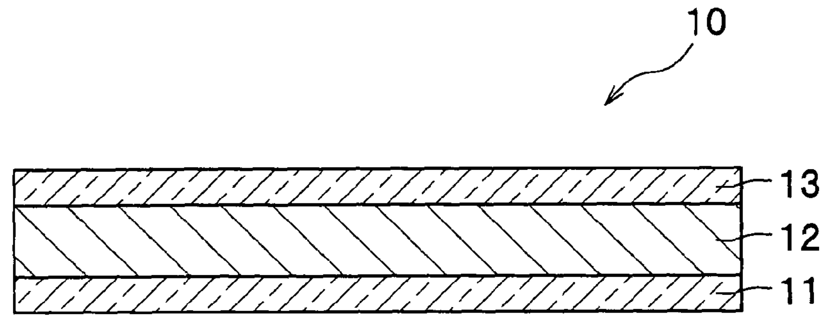


FIG. 2

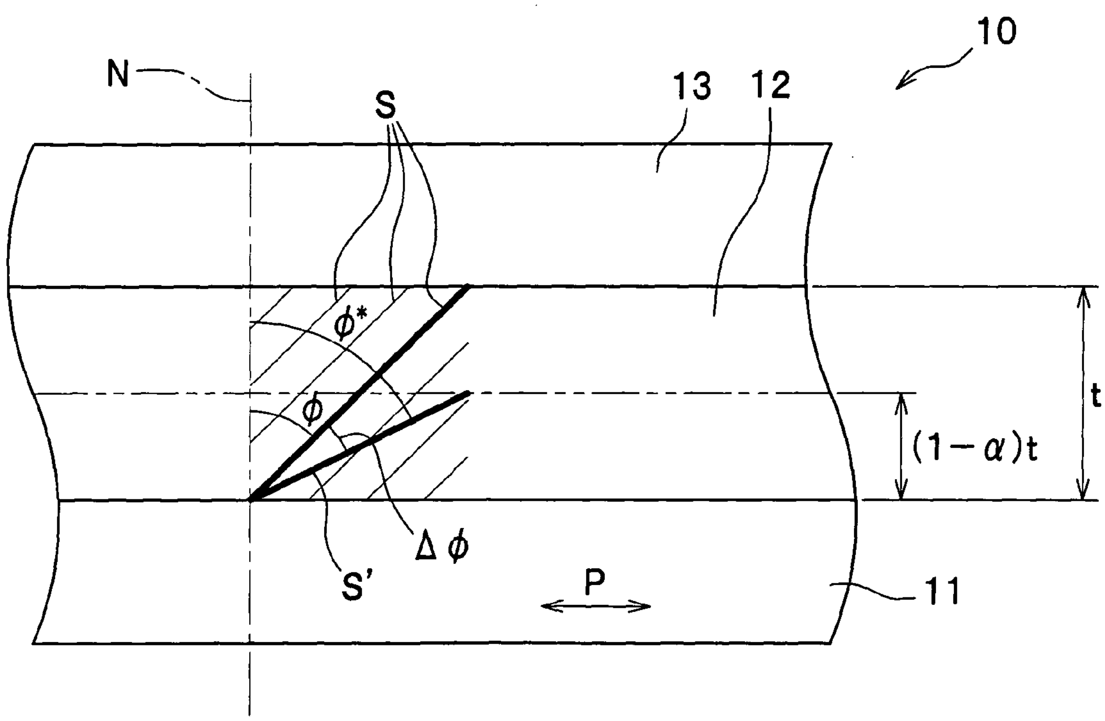

FIG. 3

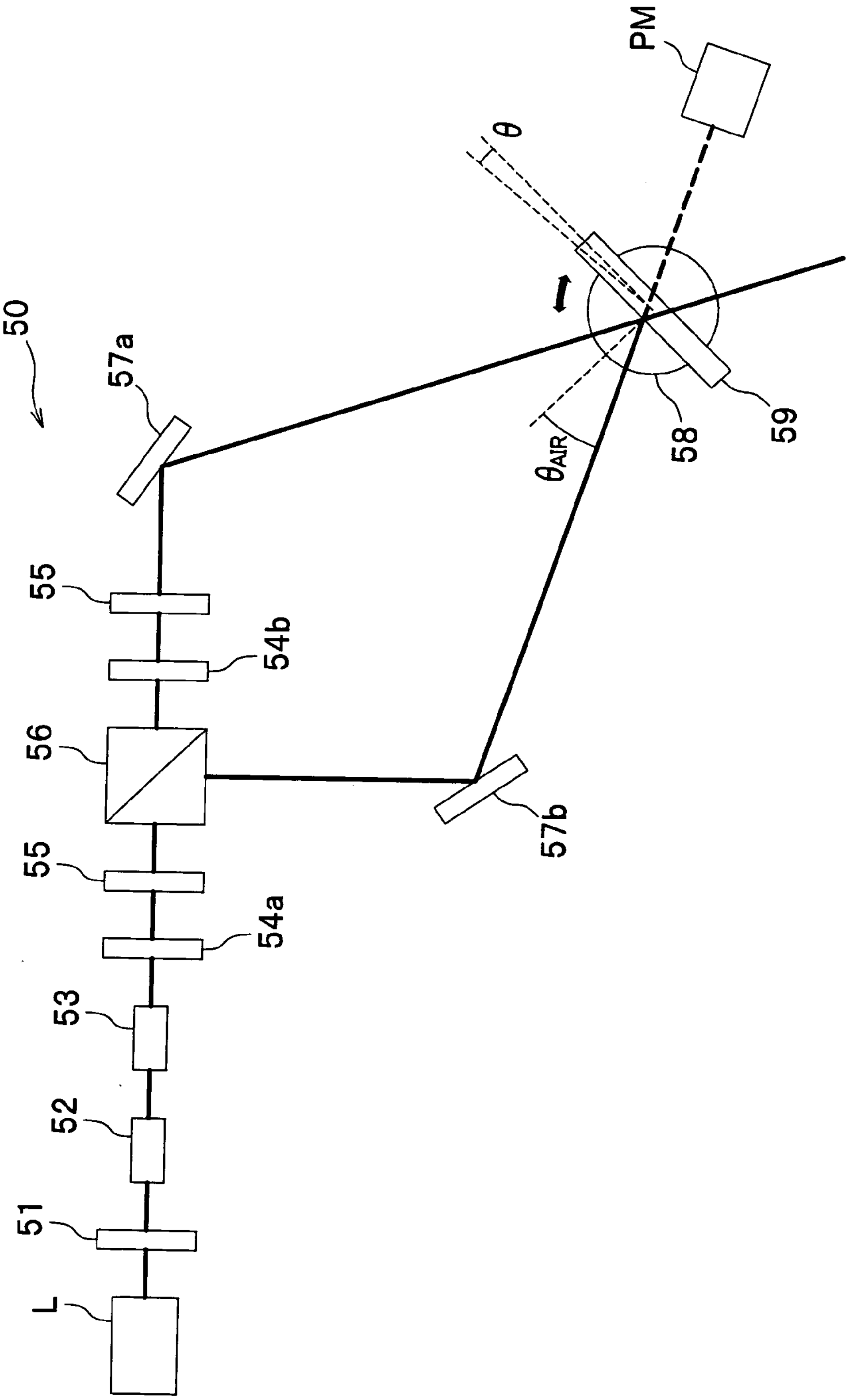

FIG. 4

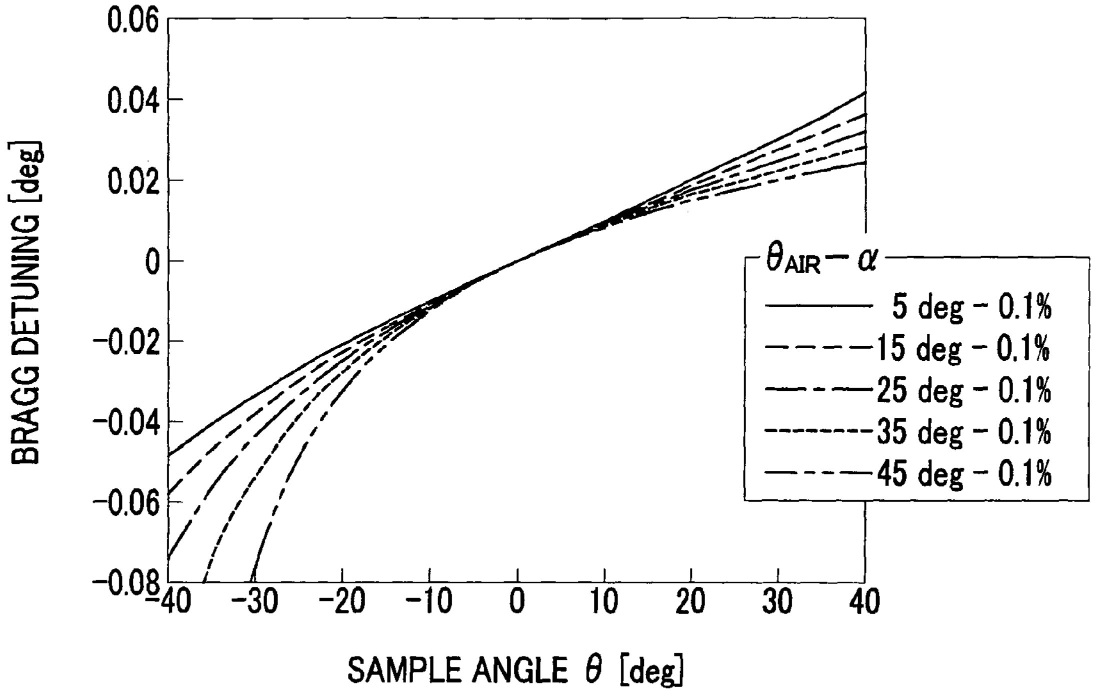
BRAGG DETUNING [deg]
0.06
0.04
0.02
0
−0.02
−0.04
−0.06
−0.08
−40 −30 −20 −10 0 10 20 30 40
SAMPLE ANGLE θ [deg]
θAIR − α
5 deg - 0.1%
15 deg - 0.1%
25 deg - 0.1%
35 deg - 0.1%
45 deg - 0.1%

FIG. 5

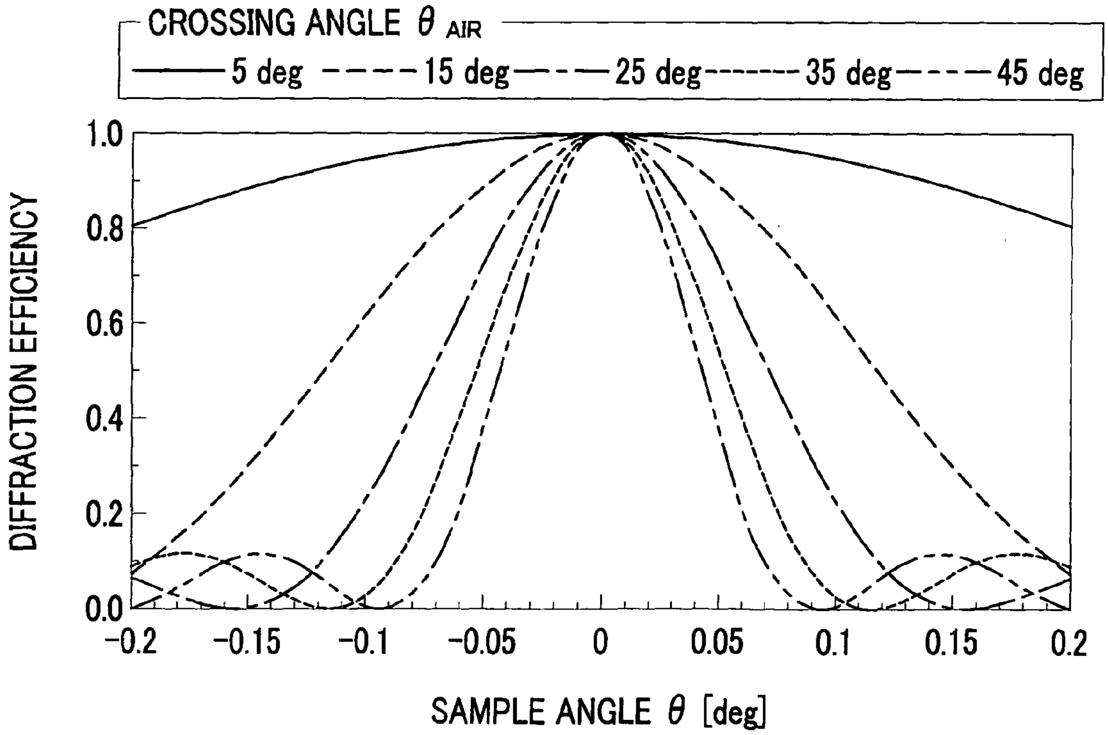
CROSSING ANGLE θ AIR
5 deg
15 deg
25 deg
35 deg
45 deg
DIFFRACTION EFFICIENCY
1.0
0.8
0.6
0.4
0.2
0.0
−0.2 −0.15 −0.1 −0.05 0 0.05 0.1 0.15 0.2
SAMPLE ANGLE θ [deg]

FIG. 6

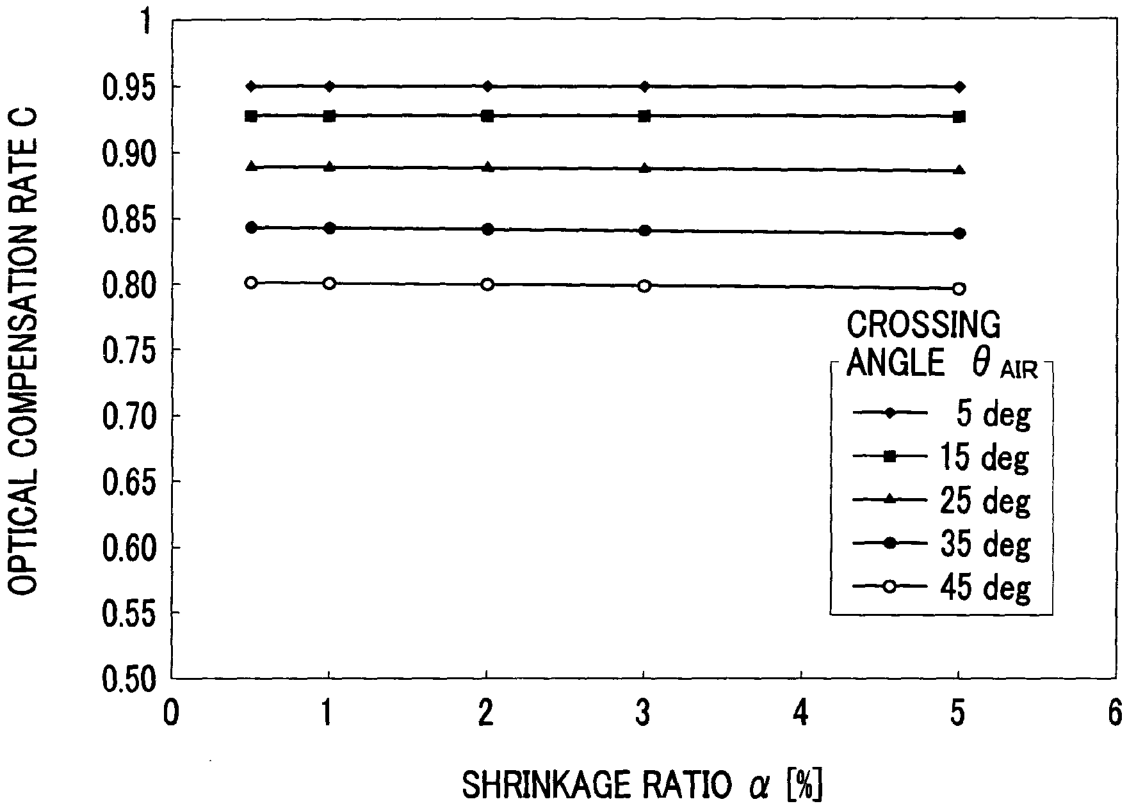
1
0.95
0.90
0.85
0.80
0.75
0.70
0.65
0.60
0.55
0.50
OPTICAL COMPENSATION RATE C
0
1
2
3
4
5
6
SHRINKAGE RATIO α [%]
CROSSING ANGLE θ AIR
5 deg
15 deg
25 deg
35 deg
45 deg

FIG. 7

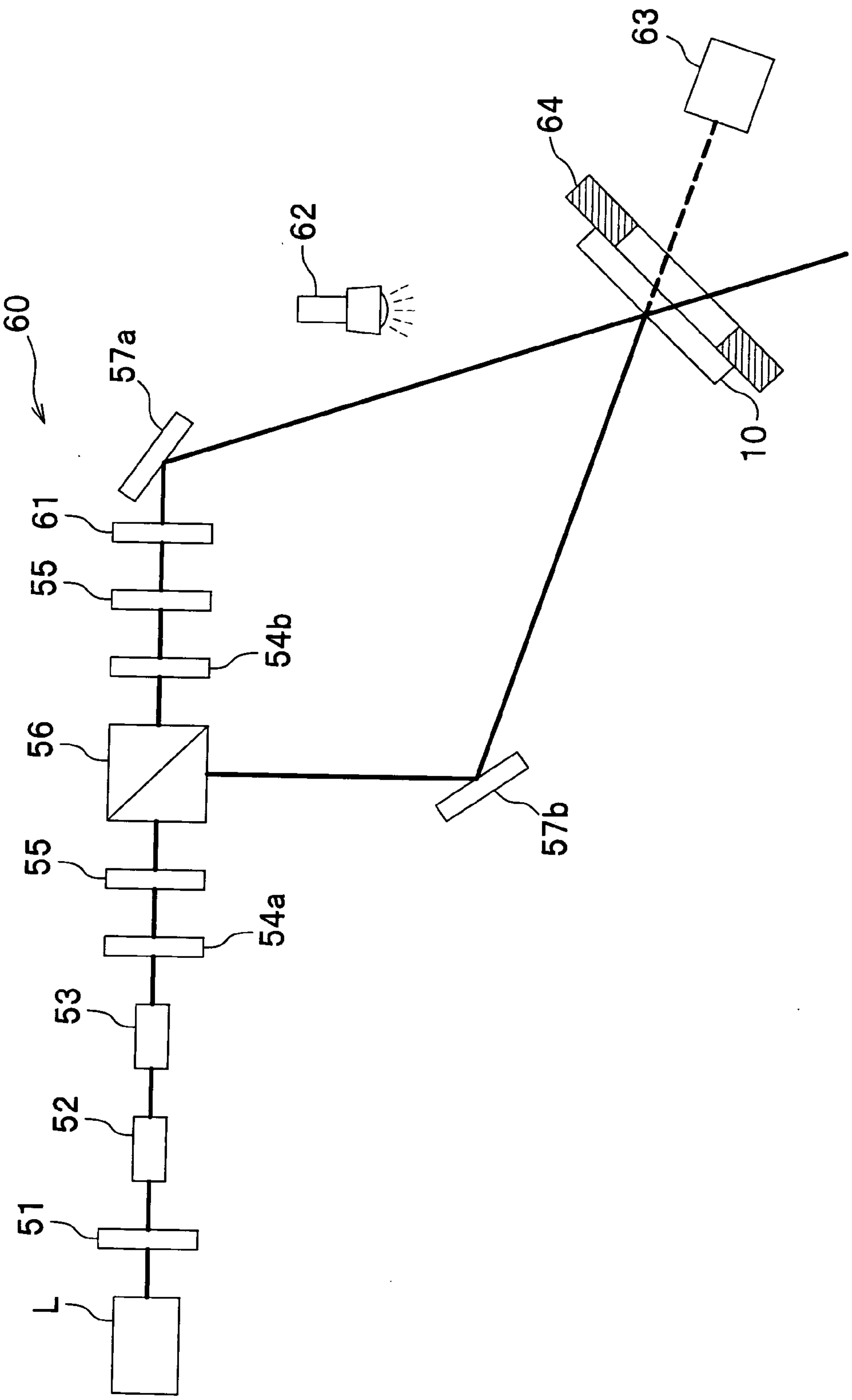

FIG. 8

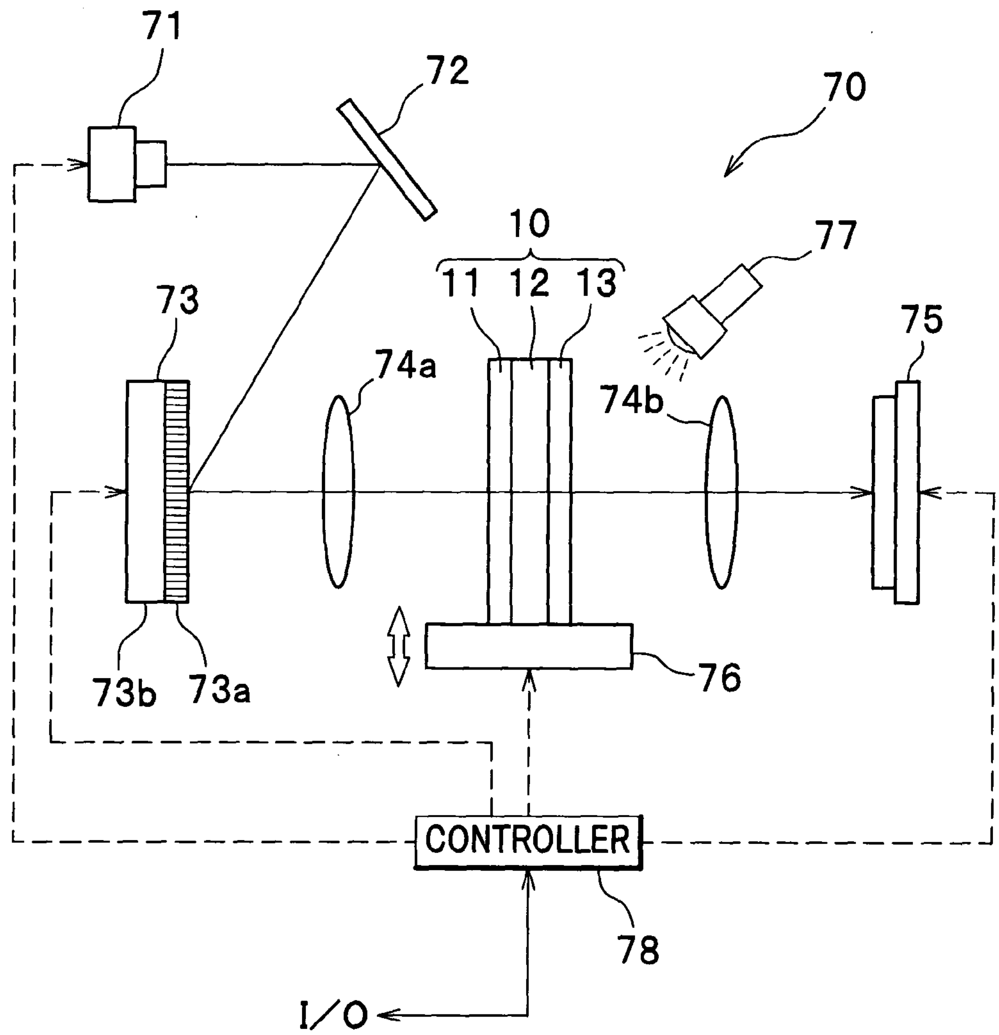

FIG. 9

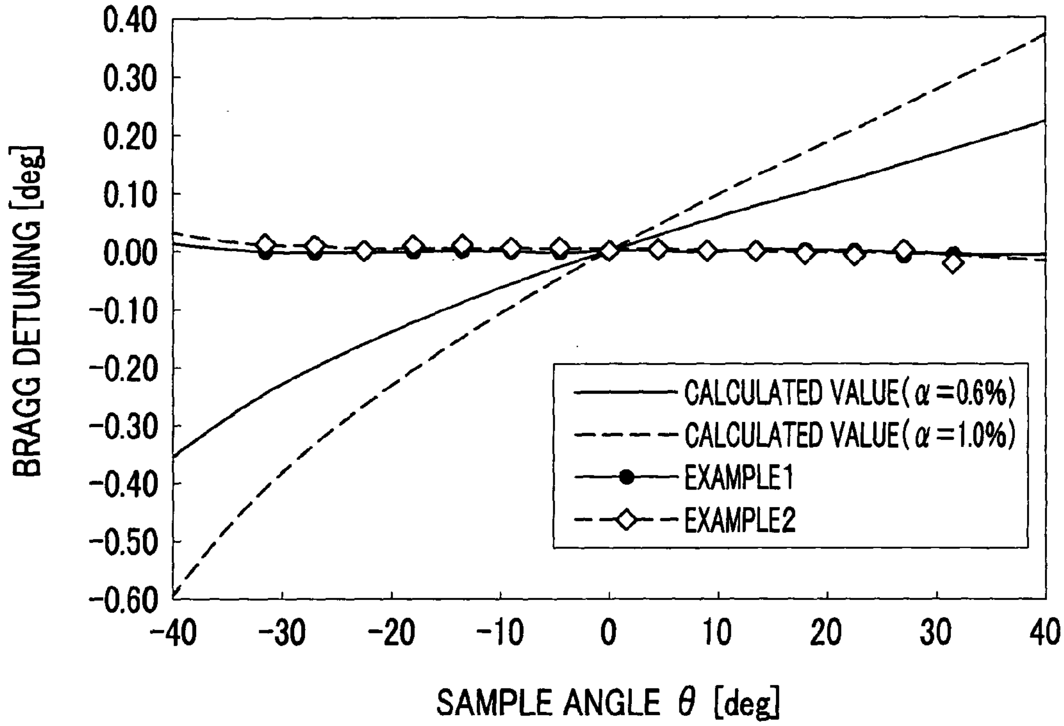
BRAGG DETUNING [deg]
0.40
0.30
0.20
0.10
0.00
-0.10
-0.20
-0.30
-0.40
-0.50
-0.60
-40
-30
-20
-10
0
10
20
30
40
SAMPLE ANGLE θ [deg]
CALCULATED VALUE(α=0.6%)
CALCULATED VALUE(α=1.0%)
EXAMPLE1
EXAMPLE2

FIG. 10

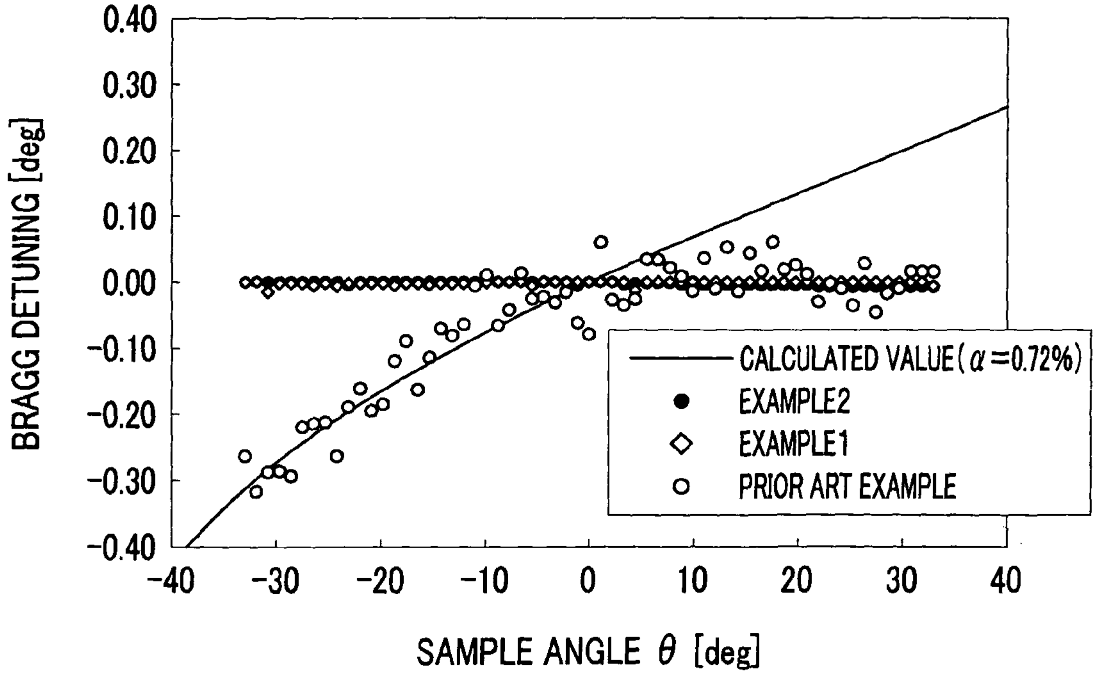
BRAGG DETUNING [deg]
0.40
0.30
0.20
0.10
0.00
-0.10
-0.20
-0.30
-0.40
-40
-30
-20
-10
0
10
20
30
40
SAMPLE ANGLE θ [deg]
CALCULATED VALUE(α=0.72%)
EXAMPLE2
EXAMPLE1
PRIOR ART EXAMPLE

Europäisches Patentamt
European Patent Office
Office européen des brevets

# EUROPEAN SEARCH REPORT

Application Number
EP 08 01 3191

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/188790 A1 (TAKIZAWA HIROO [JP]) 24 August 2006 (2006-08-24)<br>* paragraphs [0144] - [0450] * | 1-8 | INV.<br>G11B7/0065<br>G11B7/242<br>G03F7/00 |
| X | D.A.WALDMAN AND H.-Y.S.LI: "Determination of low transvers shrinkage in slant fringe gratings of a cationic ring-opening volume holgram recording material" PROCEEDINGS OF SPIE, vol. 3010, May 1997 (1997-05), pages 354-372, XP002499827 | 7,8 | |
| A | * page 365 - page 368 * | 1-6 | |
| A | WO 99/26112 A (POLAROID CORP [US]) 27 May 1999 (1999-05-27)<br>* the whole document * | 1-8 | |
| A | US 6 103 454 A (DHAR LISA [US] ET AL) 15 August 2000 (2000-08-15)<br>* the whole document * | 1-8 | |
| A | EP 1 553 447 A (KONICA MEDICAL AND GRAPHIC COR [JP]) 13 July 2005 (2005-07-13)<br>* the whole document * | 1-8 | TECHNICAL FIELDS SEARCHED (IPC)<br>G11B<br>G03F |
| X | US 4 799 746 A (WREEDE JOHN E [US]) 24 January 1989 (1989-01-24)<br>* columns 1-6 * | 7,8 | |

The present search report has been drawn up for all claims

3

| Place of search | Date of completion of the search | Examiner |
|---|---|---|
| Munich | 16 October 2008 | Baur, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 08 01 3191

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2008

| Patent document cited in search report | Publication date | Patent family member(s) | Publication date |
|---|---|---|---|
| US 2006188790 A1 | 24-08-2006 | JP 2006235087 A | 07-09-2006 |
| WO 9926112 A | 27-05-1999 | DE 69823860 D1 | 17-06-2004 |
| | | DE 69823860 T2 | 12-05-2005 |
| | | EP 1029258 A1 | 23-08-2000 |
| | | JP 3473950 B2 | 08-12-2003 |
| | | JP 2001523842 T | 27-11-2001 |
| | | US 2003157414 A1 | 21-08-2003 |
| US 6103454 A | 15-08-2000 | US 2002142227 A1 | 03-10-2002 |
| | | US 6482551 B1 | 19-11-2002 |
| EP 1553447 A | 13-07-2005 | AU 2003285749 A1 | 03-03-2004 |
| | | WO 2004017141 A1 | 26-02-2004 |
| | | JP 2005274587 A | 06-10-2005 |
| | | US 2005231773 A1 | 20-10-2005 |
| US 4799746 A | 24-01-1989 | DE 3689841 D1 | 23-06-1994 |
| | | DE 3689841 T2 | 01-09-1994 |
| | | EP 0215839 A1 | 01-04-1987 |
| | | IL 77722 A | 17-09-1990 |
| | | JP 6044181 B | 08-06-1994 |
| | | NO 863631 A | 11-09-1986 |
| | | WO 8605286 A1 | 12-09-1986 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005321597 A
- US 20070206448 A1
- JP 2007119731 A
- JP 2005099751 A
- JP 2005099753 A
- JP 2005017730 A
- JP 2005017354 A
- JP 2005115361 A
- JP 2005309359 A
- JP S5815603 B
- JP S5840302 B
- JP S5928328 B
- JP S6053300 B
- JP S619621 B
- JP S623842 B
- JP S5989303 B
- JP S6060104 B


### Non-patent literature cited in the description


- Holographic Data storage. *IBM Journal of Research and Development,* vol. 44 (3), 341-368
- Holographic recording properties in thick films of ULSH-500 photopolymer. *Proceedings of SPIE - The International Society for Optical Engineering,* vol. 3291, 89-103
- Recording media that exhibit high dynamic range for digital holographic data storage. *Optics letters,* vol. 24 (7), 487-489
- Evaluation of polycarbonate substrate hologram recording medium regarding implication of birefringence and thermal expansion. *Optics Communications,* 2007, vol. 270, 17-24
- Tenperature Compensation strategy for holographic storage. *Proceedings of Optical data storage topical meeting,* 2006
- **SINYA OGAWARA.** Shikiso Handobukku. Kodansha, 1986
- **SHINYA OGAWARA.** Kinosei Shikiso no Kagaku. CMC, 1981
- **TADASABURO IKEMORI.** Tokushu Kino Zairyo. CMC, 1986
- *Research Disclosure,* December 1980, vol. 200
- Sensitizer. Kodansha Ltd, 1987, 160-163
- Functional Dye Chemistry. CMC Publishing Co, 1981, 393-416
- *Color Material,* 1987, vol. 60 (4), 212-224